(19)

Europäisches
Patentamt
European
Patent Office
Office européen
des brevets

(11)     **EP 1 924 863 B1**

(12)     **EUROPEAN PATENT SPECIFICATION**

(45) Date of publication and mention
of the grant of the patent:
**15.01.2014   Bulletin 2014/03**

(51) Int Cl.:
***G01R 31/08*** *(2006.01)*

(21) Application number: **06784043.9**

(22) Date of filing: **05.09.2006**

(86) International application number:
**PCT/PL2006/000061**

(87) International publication number:
**WO 2007/032697 (22.03.2007 Gazette 2007/12)**

(54) **A METHOD FOR FAULT LOCATION IN ELECTRIC POWER LINES**

VERFAHREN ZUR FEHLERORTUNG IN ELEKTRISCHEN STROMLEITUNGEN

PROCEDE DE LOCALISATION DES DEFAUTS SUR LES LIGNES ELECTRIQUES

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **14.09.2005   PL 37706405
23.06.2006   PL 38001206**

(43) Date of publication of application:
**28.05.2008   Bulletin 2008/22**

(73) Proprietor: **ABB Technology AG
8050 Zürich (CH)**

(72) Inventors:
• **BALCEREK, Przemyslaw
PL-53-301 Wroclaw (PL)**
• **FULCZYK, Marek
PL-47-220 Kedzierzyn-Kozle (PL)**
• **ROSOLOWSKI, Eugeniusz
PL-54-150 Wroclaw (PL)**
• **IZYKOWSKI, Jan
PL-50-306 Wroclaw (PL)**
• **SAHA, Murari
S-722 44 Vasteras (SE)**

(74) Representative: **Chochorowska-Winiarska,
Krystyna
ABB Sp. z o. o.,
Corporate Research,
ul. Starowislna 13A
31-038 Krakow (PL)**

(56) References cited:
**EP-A1- 0 464 662**

• **KAI-PING LIEN ET AL: "A novel fault location
algorithm for multi-terminal lines using phasor
measurement units" POWER SYMPOSIUM, 2005.
PROCEEDINGS OF THE 37TH ANNUAL NORTH
AMERICAN AMES, IA, USA OCT. 23-25, 2005,
PISCATAWAY, NJ, USA,IEEE, 23 October 2005
(2005-10-23), pages 576-581, XP010865525 ISBN:
0-7803-9255-8 cited in the application**
• **CHI-SHAN YU ET AL: "A fault location algorithm
for transmission lines with tapped leg-PMU based
approach" 2001 IEEE POWER ENGINEERING
SOCIETY. SUMMER MEETING. CONFERENCE
PROCEEDINGS. VANCOUVER, CANADA, JULY
15 - 19, 2001, IEEE POWER ENGINEERING
SOCIETY, NEW YORK, NY : IEEE, US, vol. VOL. 2
OF 3, 15 July 2001 (2001-07-15), pages 915-920,
XP010567853 ISBN: 0-7803-7173-9**
• **YING-HONG LIN ET AL: "A New Fault Locator for
Three-Terminal Transmission Lines-Using Two-
Terminal Synchronized Voltage and Current
Phasors" IEEE TRANSACTIONS ON POWER
DELIVERY, IEEE SERVICE CENTER, NEW YORK,
NY, US, vol. 17, no. 2, 2002, pages 452-459,
XP011078798 ISSN: 0885-8977**

EP 1 924 863 B1

**Description**

The present invention is concerned with a method for fault location in electric power lines applicable both to three-terminal power lines and multiple-terminal power lines, fit to be used in the power industry for overhead and overhead-cable transmission or distribution lines.

The accurate location of the fault in electric power lines is of great importance both for power companies dealing with electric energy distribution and for end users of electric energy. Quick and exact location of the fault point effects the quality of transmitted electric energy and its reliable and uninterrupted supply. In most cases, faults result in mechanical damage which must be removed before voltage is restored in the line. Quick rectification of a fault is possible if the place of the fault is known exactly. The simplest method for determining the location of a fault is searching along the line. This method is slow and expensive, even dangerous in adverse weather conditions. Fault locators facilitating quick determination of the fault point are used for locating fault points. A fault locator is usually a part of a digital protective relay located in power stations or substations. Depending on the type of electric power lines: parallel lines, three-terminal power lines, multiple-terminal power lines, and depending on the location of final terminals and the diversity of measuring signals, different ways of fault location are distinguished.

A system and a method for fault location in a three-terminal power line is known from US patent description 6466030. The method according to that invention consists in dividing the transmission line in the tap point into two sections, the supply side section and the receiving side section, and on both sides of both sections at their ends instruments for measuring the values of current and voltage signals are installed. Then, on the basis of synchronously or asynchronously measured values and the model of fault loops, the load impedance in the branch is calculated, after which the first hypothetical fault location is calculated assuming that the fault occurred on the supply section side. Depending on whether the measurements are synchronised or not, either the phase angle is calculated, which is the measure of displacement with time of the measured samples from signals from both ends of the line on the basis of measured pre-fault signals, or a phase angle equal to zero for synchronous measurements is assumed. Then calculations of the second hypothetical fault location in the second line section between the tap point and the received point are made. From the two calculated hypothetical locations one value which is contained in a specific interval of expected values, i.e. numerical values from 0 to 1 in relative units is chosen. The described solution applies to the case of a single circuit line with a passive branch, which means that in the adopted equivalent circuit diagram of such system, in the tapped line, the presence of electric-power motive force is not considered, and the load impedance of this line can be calculated from pre-fault measurements.

A system and a method for fault location in a multiple-terminal parallel transmission line is known from US patent description 5 485 394. In the method according to that invention, a multi-terminal transmission system is equalled to a three-terminal transmission system. For such system differential current amplitudes are calculated in each station, and then the distance to the fault point is calculated from their relations.

A method for fault location using voltage and current phasor measurement in all stations at the ends of a multi-terminal line is known, from the publication YING-HONG LIN et all: "Novel Fault Location Algorithm for Multi-Terminal Lines Using Phasor Measurement Units" published in the materials of the Thirty-Seventh Annual North American Power Symposium in Ames, Iowa, USA, October 23-25, 2005. That method consists in reducing a multi-section transmission line to systems of two-terminal lines assuming that the fault is located in one of these sections and then hypothetical fault locations are calculated for this assumption. Next, calculations of successive hypothetical fault locations are made assuming that the fault is located in further successive sections of the line. One value, which is contained in a specific interval of expected values and which indicates the actual place of the fault, is selected from the hypothetical locations calculated in this way.

A new solution for accurately locating faults on three terminal lines is known from the publication "A new fault Locator for three-Terminal Transmission Line-Using Two-Terminal Synchronized Voltage and Current Phasors", IEEE Transaction on Power Delivery, IEEE Service Center, New York, NY, US,vol.17, no.2, 2002, pages 452-459, XP011078798 ISSN:0885-8977. In this solution the fault locator for three-terminal transmission lines using incomplete, i.e. two-terminal synchronized voltages and current phasors has been proposed. In the first step of the fault location procedure the faulted section of the transmission lines is selected based on the assumption that the voltage drop expressed in terms of measurements from both line side at fault point are identical. Next for each of the selected faulted line section special fault location procedure is applied. If the fault occurs in one of the section of the original line the remote source impedance and current flowing in the tapped line is calculated and next distance to fault is estimated. If the fault occurs in tapped leg first the internal voltage source is calculated and then this voltage is utilized to distance to fault calculation.

THE ESSENCE OF THE INVENTION

The essence of the inventive method for locating faults in electric power lines by dividing the lines of the transmission or distribution system into sections consists in the following:

- current for fault condition and pre-fault condition is measured in all terminal stations of the system,

- the line phase voltage for fault and pre-fault conditions is measured in one terminal station of the system,

- symmetrical components of the measured current and voltage signals and the total fault current in the fault point are calculated,

- a hypothetical location of the fault is assumed in one of the line sections.

- the first hypothetical fault point located in line section between the beginning of the line and the first tap point, the second hypothetical fault point located in line section between the end of the line and the last tap point, and a consecutive hypothetical fault point which is located in each of line branches which are connected to the line is assumed, while for multi-terminallines, having more then three terminals, the consecutive hypothetical fault point located in each line sections between two consecutive tap points is additionally assumed,

- the distance from the beginning of the line to the fault point in the section between the beginning of the line and the first tap point, the distance from the end of the line to the fault point in the section between the end of the line and the last tap point, the distance from the end of the tapped line to the fault point located in each of branches are calculated, while for a multi-terminal lines the distance from the tap point to the fault point located in each of the line section between two tap points is additionally calculated and then for all hypothetical fault points in each section fault resistance is calculated,

- the actual fault point location is selected first by comparing the numerical values concerning the previously determined distances and rejecting those results whose numerical values are negative or bigger than 1 per unit and then by analysing the values of the calculated fault resistances for fault points and rejecting those results of the calculation for which the value of fault resistance is negative, and if it is found that only one numerical value concerning the distance is contained in the numerical interval between zero and one per unit and the value of calculated fault resistance for this distance to the fault point is positive or equal to zero, then these results are final and they indicate the actual distance to the fault point and the value of fault resistance in the fault point,

- if, after the selection of the actual fault point it turns out that at least two numerical values concerning the previously calculated distances are contained within the numerical interval from zero to one in relative units and the values of the calculated fault resistances for these fault points are positive or equal to zero, then impedance modules or impedances of equivalent source systems for the negative sequence component for phase-to-ground faults, phase-to-phase faults, and double phase-to-to-ground faults or for the incremental positive sequence component for three-phase faults are determined, assuming that the fault occurred in a definite section, for multi-terminal lines, during the impedance determination is additionally verify whether the calculated values of the impedance of equivalent source systems are contained in the first quadrant of the Cartesian co-ordinate system for the complex plain and these distances to fault points are rejected for which impedance values are not contained in this quadrant of the system, and if it turns out that only one value of the impedance of the equivalent source system concerning distance is contained in the first quadrant of the system, then the result of the calculation of the distance to the fault point, for this impedance, is considered to be final, whereas if it turns out that at least two values of the impedance of equivalent source systems concerning distance are contained in the first quadrant of the system, then the modules of these impedances are utilised in the next step,

- the values of the modules of the equivalent source impedance are compared with realistic values, which really define the system load or supply, and the distance for which the value of the module of the equivalent source impedance is nearest to the realistic values really determining the system load or supply is considered to be the final result.

Preferably, calculation of the total fault current is done taking into account the share coefficients determining the relation between the symmetrical components of the total fault current when voltage drop across the fault resistance is estimated, a specially determined set of these coefficients being used for that operation.

Preferably, for phase-to-phase-to-earth faults the positive sequence component is eliminated in the estimation of the total fault current, and for the negative and zero sequence components the following values of the share coefficients determining the relation between the symmetrical components of the total fault current when voltage drop across the fault resistance is estimated are assumed, in particular for a-b-g fault:

$$\underline{a}_{\mathrm{F1}} = 0 \,,$$

$$\underline{a}_{\mathrm{F2}} = \underline{a}_{\mathrm{F2}}^{\mathrm{init.}} - \frac{\underline{a}_{\mathrm{F1}}^{\mathrm{init.}} \underline{b}_{\mathrm{F2}}}{\underline{b}_{\mathrm{F1}}} \,,$$

$$\underline{a}_{\mathrm{F0}} = \frac{\underline{a}_{\mathrm{F1}}^{\mathrm{init.}}}{\underline{b}_{\mathrm{F1}}}$$

whereas :

$$\underline{a}_{\mathrm{F1}}^{\mathrm{init.}} = 1 - \underline{a}^2 \,,$$

$$\underline{a}_{\mathrm{F2}}^{\mathrm{init.}} = 1 - \underline{a} \,,$$

$$\underline{b}_{\mathrm{F1}} = -\underline{a} \,,$$

$$\underline{b}_{\mathrm{F2}} = -\underline{a}^2 \,,$$

$$\underline{a} = \exp^{j\,2\pi/3} = -0{,}5 + j\,\frac{\sqrt{3}}{2} \,,$$

Preferably, for three-terminal power lines, the distances from the beginning of the line to the fault point $d_A$, from the end of the line to the fault point $d_B$, from the end of the tapped line to the fault point $d_C$ are determined from the following equations:

$$d_{\mathrm{A}} = \frac{\mathrm{real}(\underline{V}_{\mathrm{Ap}})\mathrm{imag}(\underline{I}_{\mathrm{F}}) - \mathrm{imag}(\underline{V}_{\mathrm{Ap}})\mathrm{real}(\underline{I}_{\mathrm{F}})}{\mathrm{real}(\underline{Z}_{\mathrm{1LA}}\underline{I}_{\mathrm{Ap}})\mathrm{imag}(\underline{I}_{\mathrm{F}}) - \mathrm{imag}(\underline{Z}_{\mathrm{1LA}}\underline{I}_{\mathrm{Ap}})\mathrm{real}(\underline{I}_{\mathrm{F}})} \,,$$

$$d_{\mathrm{B}} = \frac{-\mathrm{real}(\underline{V}_{\mathrm{Tp}} - \underline{Z}_{\mathrm{1LB}}\underline{I}_{\mathrm{TBp}})\mathrm{imag}(\underline{I}_{\mathrm{F}}) + \mathrm{imag}(\underline{V}_{\mathrm{Tp}} - \underline{Z}_{\mathrm{1LB}}\underline{I}_{\mathrm{TBp}})\mathrm{real}(\underline{I}_{\mathrm{F}})}{\mathrm{real}(\underline{Z}_{\mathrm{1LB}}\underline{I}_{\mathrm{TBp}})\mathrm{imag}(\underline{I}_{\mathrm{F}}) - \mathrm{imag}(\underline{Z}_{\mathrm{1LB}}\underline{I}_{\mathrm{TBp}})\mathrm{real}(\underline{I}_{\mathrm{F}})} \,,$$

$$d_{\mathrm{C}} = \frac{-\operatorname{real}(\underline{V}_{\mathrm{Tp}} - \underline{Z}_{1\mathrm{LC}}\underline{I}_{\mathrm{TCp}})\operatorname{imag}(\underline{I}_{\mathrm{F}}) + \operatorname{imag}(\underline{V}_{\mathrm{Tp}} - \underline{Z}_{1\mathrm{LC}}\underline{I}_{\mathrm{TCp}})\operatorname{real}(\underline{I}_{\mathrm{F}})}{\operatorname{real}(\underline{Z}_{1\mathrm{LC}}\underline{I}_{\mathrm{TCp}})\operatorname{imag}(\underline{I}_{\mathrm{F}}) - \operatorname{imag}(\underline{Z}_{1\mathrm{LC}}\underline{I}_{\mathrm{TCp}})\operatorname{real}(\underline{I}_{\mathrm{F}})} ,$$

where:

"real" denotes the real part of the given quantity,

"imag" denotes the imaginary part of the given quantity,

$\underline{V}_{\mathrm{Ap}}$ - denotes the fault loop voltage determined assuming that the fault occurred in section LA,

$\underline{V}_{\mathrm{Tp}}$ - denotes the fault loop voltage determined assuming that the fault occurred in section LB or LC,

$\underline{I}_{\mathrm{Ap}}$ - denotes the fault loop current determined assuming that the fault occurred in section LA,

$\underline{I}_{\mathrm{TBp}}$ - denotes the fault loop current determined assuming that the fault occurred in section LB,

$\underline{I}_{\mathrm{TCp}}$ - denotes the fault loop current determined assuming that the fault occurred in line section LC,

$\underline{I}_{\mathrm{F}}$ - denotes total fault current,

$\underline{Z}_{\mathrm{ILA}} = R_{1\mathrm{LA}} + j\omega_1 L_{1\mathrm{LA}}$ - denotes impedance of the line section LA for the positive sequence,

$\underline{Z}_{1\mathrm{LB}} = R_{1\mathrm{LB}} + j\omega_1 L_{1\mathrm{LB}}$ - denotes impedance of the line section LB for the positive sequence,

$\underline{Z}_{1\mathrm{LC}} = R_{1\mathrm{LC}} + j\omega_1 L_{1\mathrm{LC}}$ - denotes impedance of the line section LC for the positive sequence,

$R_{1\mathrm{LA}}, R_{1\mathrm{LB}}, R_{1\mathrm{LC}}$ - resistance for the positive sequence for line sections LA, LB, LC, respectively,

$L_{1\mathrm{LA}}, L_{1\mathrm{LB}}, L_{1\mathrm{LC}}$ - inductance for the positive sequence for line sections LA, LB, LC, respectively,

$\omega_1$ - pulsation for the fundamental frequency.

Preferably, for three-terminal power lines, the fault resistance $R_{\mathrm{FA}}$, $R_{\mathrm{FB}}$, $R_{\mathrm{FC}}$ is determined from the following equations:

$$R_{\mathrm{FA}} = \frac{1}{2}\left[\frac{\operatorname{real}(\underline{V}_{\mathrm{Ap}}) - d_{\mathrm{A}}\operatorname{real}(\underline{Z}_{1\mathrm{LA}}\underline{I}_{\mathrm{Ap}})}{\operatorname{real}(\underline{I}_{\mathrm{F}})} + \frac{\operatorname{imag}(\underline{V}_{\mathrm{Ap}}) - d_{\mathrm{A}}\operatorname{imag}(\underline{Z}_{1\mathrm{LA}}\underline{I}_{\mathrm{Ap}})}{\operatorname{imag}(\underline{I}_{\mathrm{F}})}\right] ,$$

$$R_{\mathrm{FB}} = \frac{1}{2}\left[\frac{\operatorname{real}(\underline{V}_{\mathrm{Tp}}) - (1 - d_{\mathrm{B}})\cdot\operatorname{real}(\underline{Z}_{1\mathrm{LB}}\underline{I}_{\mathrm{TBp}})}{\operatorname{real}(\underline{I}_{\mathrm{F}})}\right] + \frac{1}{2}\left[\frac{\operatorname{imag}(\underline{V}_{\mathrm{Tp}}) - (1 - d_{\mathrm{B}})\cdot\operatorname{imag}(\underline{Z}_{1\mathrm{LB}}\underline{I}_{\mathrm{TBp}})}{\operatorname{imag}(\underline{I}_{\mathrm{F}})}\right]$$

$$R_{FC} = \frac{1}{2}\left[\frac{\text{real}(\underline{V}_{Tp}) - (1-d_C)\cdot\text{real}(\underline{Z}_{1LC}\underline{I}_{TCp})}{\text{real}(\underline{I}_F)}\right] + \frac{1}{2}\left[\frac{\text{imag}(\underline{V}_{Tp}) - (1-d_C)\cdot\text{imag}(\underline{Z}_{1LC}\underline{I}_{TCp})}{\text{imag}(\underline{I}_F)}\right]$$

where:

"real" denotes the real part of the given quantity,

"imag" denotes the imaginary part of the given quantity,

$\underline{V}_{Ap}$ - denotes the fault loop voltage calculated assuming that the fault occurred in section LA,

$\underline{V}_{Tp}$ - denotes the fault loop voltage calculated assuming that the fault occurred in section LB or LC,

$\underline{I}_{Ap}$ - denotes the fault loop current calculated assuming that the fault occurred in section LA,

$\underline{I}_{TBp}$ - denotes the fault loop current calculated assuming that the fault occurred in section LB,

$\underline{I}_{TCp}$ - denotes the fault loop current calculated assuming that the fault occurred in line section LC,

$\underline{I}_F$ - denotes the total fault current,

$\underline{Z}_{ILA} = R_{ILA} + j\,\omega_1 L_{1LA}$ - denotes impedance of the line section LA for the positive sequence,

$\underline{Z}_{ILB} = R_{1LB} + j\omega_1 L_{1LB}$ - denotes impedance of the line section LB for the positive sequence,

$\underline{Z}_{1LC} = R_{1LC} + j\omega_1 L_{1LC}$ - denotes impedance of the line section LC for the positive sequence,

$R_{1LA}$, $R_{1LB}$, $R_{1LC}$ - resistance for the positive sequence for line sections LA, LB, LC, respectively,

$L_{1LA}$, $L_{1LB}$, $L_{1LC}$ - inductance for the positive sequence for line sections LA, LB, LC, respectively,

$\omega_1$ - pulsation for the fundamental frequency.

$d_A$ - denotes the distance from the beginning of the line to the fault point,

$d_B$ - denotes the distance from the end of the line to the fault point,

$d_C$ - denotes the distance from the end of the tapped line to the fault point.

Preferably, for three-terminal power lines, the equivalent source impedance for the negative sequence component ( $(\underline{Z}_{2SB})_{SUB\_A}$ ) and for the incremental positive sequence component ( $(\underline{Z}_{\Delta1SB})_{SUB\_A}$ ) are calculated assuming that the fault occurred in LA line section, as per this equation:

$$(\underline{Z}_{iSB})_{SUB\_A} = \frac{\underline{G}_{iA}\underline{I}_{A2} - \underline{H}_{iA}\underline{I}_{FAi}}{\underline{Q}_{BCi}(\underline{I}_{FAi} - \underline{I}_{Ai})}.$$

where :

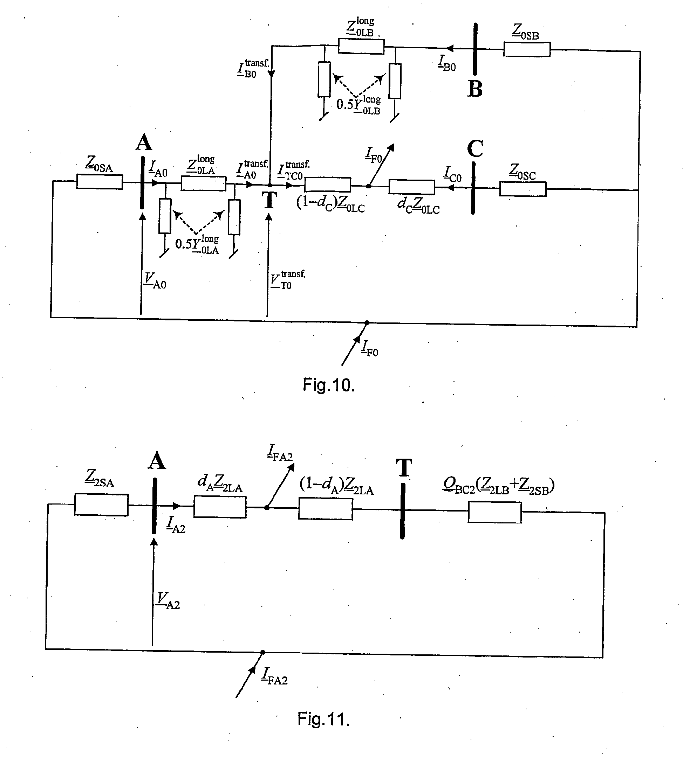

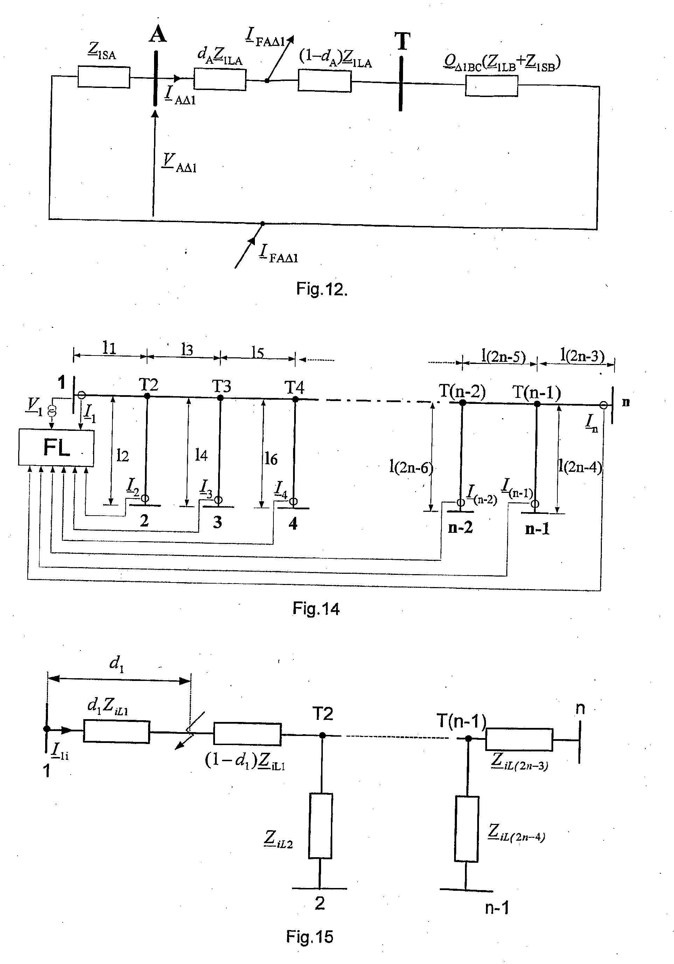

the lower index $i$ takes on values $i = 2$ for the negative sequence, $i = \Delta1$ for the incremental positive sequence component,
$\underline{G}_{iA}$ - denotes the first analytical coefficient for the negative sequence component, determined from the analysis of an equivalent circuit diagram of the system as shown in fig. 11 and/or for the incremental positive sequence component analytically determined from the equivalent circuit diagram of the system as shown in fig. 12,

$\underline{I}_{Ai}$ - denotes the negative and/or incremental positive sequence component of current measured at the beginning of the line,

$\underline{H}_{iA}$ - denotes the second analytical coefficient for the negative sequence component, determined from the analysis of an equivalent circuit diagram of the system as shown in fig. 11 and/or the incremental positive sequence component analytically determined from the equivalent circuit diagram of the system as shown in fig. 12,

$\underline{I}_{FAi}$ - denotes the negative sequence component of the total fault current, determined from the analysis of an equivalent circuit diagram of the system as shown in fig. 11 and/or the incremental positive sequence component of the total fault current, determined from the analysis of an equivalent circuit diagram of the system as shown in fig. 12,

$\underline{Q}_{BCi}$ - denotes the quotient of the negative sequence component of current measured at the end of the line and the sum of the negative sequence components of current signals measured at the end of the line and at the end of the tapped line and/or the quotient of the incremental positive sequence component of current measured at the end of the line and the sum of the incremental positive sequence components of current signals measured at the end of the line and at the end of the tapped line.

Preferably, for three-terminal power lines, the equivalent source impedance $((\underline{Z}_{2SC})_{SUB\_A})$ for the negative sequence component and $((\underline{Z}_{\Delta1SC})_{SUB\_A})$ for the incremental positive sequence component are calculated assuming that the fault occurred in line section LA, from the following equation:

$$ (\underline{Z}_{iSC})_{SUB\_A} = \left( \underline{Z}_{iLB} + (\underline{Z}_{iSB})_{SUB\_A} \right) \frac{\underline{I}_{Bi}}{\underline{I}_{Ci}} - \underline{Z}_{iLC} . $$

where:

the lower index $i$ takes on values $i = 2$ for the negative sequence component, $i = \Delta1$ for the incremental positive sequence component,

$(Z_{iSB})_{SUB\_A}$ - denotes equivalent source impedance for the negative sequence component and/or the incremental positive sequence component, calculated assuming that the fault occurred in line section LA,

$\underline{Z}_{iLB}$ - denotes the impedance of line section LB for the negative sequence component and/or the positive sequence component, where: $\underline{Z}_{\Delta1LB} = \underline{Z}_{1LB}$,

$\underline{Z}_{1LB}$ - denotes the impedance of line section LB for the positive sequence component,

$\underline{Z}_{iLC}$ - denotes the impedance of line section LC for the negative sequence component and/or impedance of line section LC for the incremental positive sequence component, where $\underline{Z}_{2LC} = \underline{Z}_{1LC}$ and $\underline{Z}_{\Delta1LC} = \underline{Z}_{1LC}$,

$\underline{Z}_{1LC}$ - denotes the impedance of line section LC for the positive sequence component,

$\underline{I}_{Bi}$ - denotes the negative sequence component and/or the incremental positive sequence component of current measured at the end of the line,

$\underline{I}_{Ci}$ - denotes the negative sequence component and/or the incremental positive sequence component of current measured at the end of the branch.

Preferably, for three-terminal power lines, equivalent source impedance for the negative sequence component $(\underline{Z}_{2SB})_{SUB\_B}$ and for the incremental positive sequence component $(\underline{Z}_{\Delta1SB})_{SUB\_B}$ is determined assuming that the fault occurred in line section LB, from the following equation:

$$ (\underline{Z}_{iSB})_{SUB\_B} = \frac{(1-d_B)\underline{Z}_{iLB}\underline{I}_{TBi}^{transf.} - d_B\underline{Z}_{iLB}\underline{I}_{Bi} - \underline{V}_{Ti}^{transf.}}{\underline{I}_{Bi}} $$

where:

the lower index $i$ takes on values $i = 2$ for the negative sequence component, $i = \Delta1$ for the incremental positive sequence component,

$d_B$ - denotes the distance from the end of the line to the fault point,

$\underline{Z}_{iLB}$ - denotes the impedance of line section LB for the negative sequence component and/or for the positive sequence component, where $\underline{Z}_{2LB} = \underline{Z}_{1LB}$ and $\underline{Z}_{\Delta1LB} = \underline{Z}_{1LB}$,

$\underline{Z}_{1LB}$ - denotes the impedance of line section LB for the positive sequence component,

$\underline{I}_{\mathrm{TBi}}^{\mathrm{transf.}}$ - denotes current flowing from a tap point T to line section LB for the negative sequence component and/or for the incremental positive sequence component,

$\underline{I}_{\mathrm{Bi}}$ - denotes the negative sequence component and/or the incremental positive sequence component of current measured at the end of the line,

$\underline{V}_{\mathrm{Ti}}^{\mathrm{transf.}}$ - denotes voltage in the tap point T for the negative sequence component and/or for the incremental positive sequence component.

Preferably, for three-terminal power lines, equivalent source impedance for the negative sequence component $(\underline{Z}_{2SC})_{SUB\_B}$ and for the incremental positive sequence component $(\underline{Z}_{\Delta1SC})_{SUB\_B}$ is calculated assuming that the fault occurred in line section LB, from the following equation:

$$(\underline{Z}_{i\mathrm{SC}})_{\mathrm{SUB\_B}} = -\frac{\underline{V}_{\mathrm{Ci}}}{\underline{I}_{\mathrm{Ci}}}$$

where:

the lower index *i* takes on values *i* = 2 for the negative sequence component, *i* = Δ1 for the incremental positive sequence component,
$\underline{V}_{\mathrm{Ci}}$ - denotes the calculated negative sequence component and/or the incremental positive sequence component of voltage at the end of the tapped line, $\underline{I}_{\mathrm{Ci}}$ - denotes the negative sequence component and/or the incremental positive sequence component of current measured at the end of the branch.

Preferably, for three-terminal power lines, equivalent source impedance for the negative sequence component $(\underline{Z}_{2SC})_{SUB\_C}$ and for the incremental positive sequence component $(\underline{Z}_{\Delta1SC})_{SUB\_C}$ is calculated assuming that the fault occurred in line section LC, from the following equation:

$$(\underline{Z}_{i\mathrm{SC}})_{\mathrm{SUB\_C}} = \frac{(1-d_{\mathrm{C}})\underline{Z}_{i\mathrm{LC}}\underline{I}_{\mathrm{TCi}}^{\mathrm{transf.}} - d_{\mathrm{C}}\underline{Z}_{i\mathrm{LC}}\underline{I}_{\mathrm{Ci}} - \underline{V}_{\mathrm{Ti}}^{\mathrm{transf.}}}{\underline{I}_{\mathrm{Ci}}}$$

where:

the lower index *i* takes on values *i* = 2 for the negative sequence component, *i* = Δ1 for the incremental positive sequence component,
$d_C$ - denotes the distance from the end of the tapped line to the fault point,
$\underline{Z}_{iLC}$ - denotes impedance of the line section LC for the negative sequence component and/or for the incremental positive sequence component, where $\underline{Z}_{2LC} = \underline{Z}_{1LC}$ and $\underline{Z}_{\Delta1LC} = \underline{Z}_{1LC}$,
$\underline{Z}_{1LC}$ - denotes impedance of the line section LC for the positive sequence component,

$\underline{I}_{\mathrm{TCi}}^{\mathrm{transf.}}$ - denotes current flowing from the tap point T to line section LC for the negative sequence component and/or for the incremental positive sequence component,

$\underline{I}_{\mathrm{Ci}}$ - denotes the negative sequence component and/or the incremental positive sequence component of current measured at the end of the branch,

$\underline{V}_{\mathrm{Ti}}^{\mathrm{transf.}}$ - denotes voltage at the tap point T for the negative sequence component and/or for the incremental positive sequence component.

Preferably, for three-terminal power lines, equivalent source impedance for the negative sequence component $(\underline{Z}_{2SB})_{SUB\_C}$ and for the incremental positive sequence component $(\underline{Z}_{\Delta1SB})_{SUB\_C}$ is calculated from the following equation assuming that the fault occurred in line section LC:

$$(\underline{Z}_{\mathrm{iSB}})_{\mathrm{SUB\_C}} = -\frac{\underline{V}_{\mathrm{Bi}}}{\underline{I}_{\mathrm{Bi}}}$$

where:

the lower index $i$ takes on values $i = 2$ for the negative sequence component, $i = \Delta 1$ for the incremental positive sequence component,

$\underline{V}_{\mathrm{Bi}}$ - denotes the calculated negative sequence and/or the incremental positive sequence component of voltage at the end of the line,

$I_{\mathrm{Bi}}$ - denotes the negative sequence and/or the incremental positive sequence component of current measured at the end B of the line.

**Preferably, for multi-terminal power lines,** distances from the beginning of the line to the fault point ($d_1$), from the end of the line to the fault point ($d_{(2n-3)}$), from the end of the line to the fault point ($d_{(2k-2)}$), from the tap point to the fault point in the line section between two tap points ($d_{(2k-1)}$) are determined from the following equations:

$$d_1 = \frac{\mathrm{real}(\underline{V}_{1\mathrm{p}})\,\mathrm{imag}(\underline{I}_{\mathrm{F}}) - \mathrm{imag}(\underline{V}_{1\mathrm{p}})\,\mathrm{real}(\underline{I}_{\mathrm{F}})}{\mathrm{real}(\underline{Z}_{1\mathrm{L}1}\underline{I}_{1\mathrm{p}})\,\mathrm{imag}(\underline{I}_{\mathrm{F}}) - \mathrm{imag}(\underline{Z}_{1\mathrm{L}1}\underline{I}_{1\mathrm{p}})\,\mathrm{real}(\underline{I}_{\mathrm{F}})},$$

$$d_{(2n-3)} = \frac{-\,\mathrm{real}(\underline{V}_{\mathrm{T(n-1)np}} - \underline{Z}_{1\mathrm{L}(2n-3)}\underline{I}_{\mathrm{T(n-1)np}})\,\mathrm{imag}(\underline{I}_{\mathrm{F}}) + \mathrm{imag}(\underline{V}_{\mathrm{T(n-1)np}} - \underline{Z}_{1\mathrm{L}(2n-3)}\underline{I}_{\mathrm{T(n-1)np}})\,\mathrm{real}(\underline{I}_{\mathrm{F}})}{\mathrm{real}(\underline{Z}_{1\mathrm{L}(2n-3)}\underline{I}_{\mathrm{T(n-1)np}})\,\mathrm{imag}(\underline{I}_{\mathrm{F}}) - \mathrm{imag}(\underline{Z}_{1\mathrm{L}(2n-3)}\underline{I}_{\mathrm{T(n-1)np}})\,\mathrm{real}(\underline{I}_{\mathrm{F}})}$$

$$d_{(2k-2)} = \frac{-\,\mathrm{real}(\underline{V}_{\mathrm{Tkkp}} - \underline{Z}_{1\mathrm{L}(2k-2)}\underline{I}_{\mathrm{Tkkp}})\,\mathrm{imag}(\underline{I}_{\mathrm{F}}) + \mathrm{imag}(\underline{V}_{\mathrm{Tkkp}} - \underline{Z}_{1\mathrm{L}(2k-2)}\underline{I}_{\mathrm{Tkkp}})\,\mathrm{real}(\underline{I}_{\mathrm{F}})}{\mathrm{real}(\underline{Z}_{1\mathrm{L}(2k-2)}\underline{I}_{\mathrm{Tkkp}})\,\mathrm{imag}(\underline{I}_{\mathrm{F}}) - \mathrm{imag}(\underline{Z}_{1\mathrm{L}(2k-2)}\underline{I}_{\mathrm{Tkkp}})\,\mathrm{real}(\underline{I}_{\mathrm{F}})},$$

$$d_{(2k-1)} = \frac{-\,\mathrm{real}(\underline{V}_{\mathrm{TkT(k+1)p}} - \underline{Z}_{1\mathrm{L}(2k-1)}\underline{I}_{\mathrm{TkT(k+1)p}})\,\mathrm{imag}(\underline{I}_{\mathrm{F}}) + \mathrm{imag}(\underline{V}_{\mathrm{TkT(k+1)p}} - \underline{Z}_{1\mathrm{L}(2k-1)}\underline{I}_{\mathrm{TkT(k+1)p}})\,\mathrm{real}(\underline{I}_{\mathrm{F}})}{\mathrm{real}(\underline{Z}_{1\mathrm{L}(2k-1)}\underline{I}_{\mathrm{TkT(k+1)p}})\,\mathrm{imag}(\underline{I}_{\mathrm{F}}) - \mathrm{imag}(\underline{Z}_{1\mathrm{L}(2k-1)}\underline{I}_{\mathrm{TkT(k+1)p}})\,\mathrm{real}(\underline{I}_{\mathrm{F}})}$$

where:

"real" denotes the real part of the given quantity,

"imag" denotes the imaginary part of the given quantity,

$\underline{V}_{1\mathrm{p}}$ - fault loop voltage calculated under assumption that fault occurred in the first section of the line section L1,

$\underline{I}_{1\mathrm{p}}$ - fault loop current calculated under assumption that fault occurred in the first section of the line section L1,

$\underline{V}_{\mathrm{T(n-1)np}}$ - fault loop voltage calculated under assumption that fault occurred in the line section L(2n-3),

$\underline{I}_{\mathrm{T(n-1)np}}$ - fault loop current calculated under assumption that fault occurred in the line section L(2n-3),

$\underline{V}_{\mathrm{Tkkp}}$ - fault loop voltage calculated under assumption that fault occurred in the $k^{\mathrm{th}}$ tapped line,

$\underline{I}_{\mathrm{Tkkp}}$ - fault loop current calculated under assumption that fault occurred in $k^{\mathrm{th}}$ tapped line,

$\underline{V}_{TkT(k+1)p}$ - fault loop voltage calculated under assumption that fault occurred in the line section between two tap points,

$\underline{I}_{TkT(k+1)p}$ - fault loop current calculated under assumption that fault occurred in the line section between two tap points,

$\underline{I}_F$- total fault current,

$\underline{Z}_{1L1}$ - impedance of line section L1 for the positive sequence component,

$\underline{Z}_{0L1}$ - impedance of line section L1 for the zero sequence component,

$\underline{Z}_{1L(2n-3)}$- impedance of line section L(2n-3) for the positive sequence component,

$\underline{Z}_{0L(2n-3)}$- impedance of line section L(2n-3) for the zero sequence component,

$\underline{Z}_{1L(2k-2)}$- impedance of line section L(2k-2) for the positive sequence component,

$\underline{Z}_{0L(2k-2)}$- impedance of line section L(2k-2) for the zero sequence component,

$\underline{Z}_{1L(2k-1)}$- impedance of line section L(2k-1) for the positive sequence component,

$\underline{Z}_{0L(2k-1)}$ - impedance of line section L(2k-1) for the zero sequence component.

k- number of the tap point

n- number of the line terminal

**Preferably, for multi-terminal power lines,** the fault resistance $(R_{1F})$, $(R_{(2n-3)F})$, $(R_{(2k-2)F})$, $(R_{(2k-1)F})$ is calculated from the following equations:

$$R_{1F} = \frac{1}{2}\left[\frac{\text{real}(\underline{V}_{1p}) - d_1\text{real}(\underline{Z}_{1L1}\underline{I}_{1p})}{\text{real}(\underline{I}_F)} + \frac{\text{imag}(\underline{V}_{1p}) - d_1\text{imag}(\underline{Z}_{1L1}\underline{I}_{1p})}{\text{imag}(\underline{I}_F)}\right],$$

$$R_{(2n-3)F} = \frac{1}{2}\left[\frac{\text{real}(\underline{V}_{T(n-1)np}) - (1-d_{(2n-3)}) \cdot \text{real}(\underline{Z}_{1L(2n-3)}\underline{I}_{T(n-1)np})}{\text{real}(\underline{I}_F)}\right] + \frac{1}{2}\left[\frac{\text{imag}(\underline{V}_{T(n-1)np}) - (1-d_{(2n-3)}) \cdot \text{imag}(\underline{Z}_{1L(2n-3)}\underline{I}_{T(n-1)np})}{\text{imag}(\underline{I}_F)}\right],$$

$$R_{(2k-2)F} = \frac{1}{2}\left[\frac{\text{real}(\underline{V}_{Tkkp}) - (1-d_{(2k-2)}) \cdot \text{real}(\underline{Z}_{1L(2k-2)}\underline{I}_{Tkkp})}{\text{real}(\underline{I}_F)}\right] + \frac{1}{2}\left[\frac{\text{imag}(\underline{V}_{Tkkp}) - (1-d_{(2k-2)}) \cdot \text{imag}(\underline{Z}_{1L(2k-2)}\underline{I}_{Tkkp})}{\text{imag}(\underline{I}_F)}\right]$$

$$R_{(2k-1)F} = \frac{1}{2}\left[\frac{real(\underline{V}_{TkT(k+1)p}) - (1-d_{(2k-1)}) \cdot real(\underline{Z}_{1L(2k-1)}\underline{I}_{TkT(k+1)p})}{real(\underline{I}_F)}\right] +$$

$$+ \frac{1}{2}\left[\frac{imag(\underline{V}_{TkT(k+1)p}) - (1-d_{(2k-1)}) \cdot imag(\underline{Z}_{1L(2k-1)}\underline{I}_{TkT(k+1)p})}{imag(\underline{I}_F)}\right]$$

where:

"real" denotes the real part of the given quantity,

"imag" denotes the imaginary part of the given quantity,

$d_1$ - distance to fault from the beginning of the line to the fault point,

$d_{(2n-3)}$ - distance to fault from the end of the line to the fault point,

$d_{(2k-2)}$ - distance to fault from the end of the tapped line to the fault point

$d_{(2k-1)}$ -distance to fault on the line section between two tap points,

$\underline{V}_{1p}$ - fault loop voltage calculated under assumption that fault occurred in the first section of the line section L1,

$\underline{I}_{1p}$- fault loop current calculated under assumption that fault occurred in the first section of the line section L1,

$\underline{V}_{T(n-1)np}$ - fault loop voltage calculated under assumption that fault occurred in the line section L(2n-3),

$\underline{I}_{T(n-1)np}$- fault loop current calculated under assumption that fault occurred in the line section L(2n-3),

$\underline{V}_{Tkkp}$ - fault loop voltage calculated under assumption that fault occurred in the $k^{th}$ tapped line,

$\underline{I}_{Tkkp}$ - fault loop current calculated under assumption that fault occurred in $k^{th}$ tapped line,

$\underline{V}_{ThTkT(k+1)p}$- fault loop voltage calculated under assumption that fault occurred in the line section between two tap points,

$\underline{I}_{TkT(k+1)p}$ - fault loop current calculated under assumption that fault occurred in the line section between two tap points,

$\underline{I}_F$- total fault current,

$\underline{Z}_{1L1}$ - impedance of line section L1 for the positive sequence component,

$\underline{Z}_{0L1}$ - impedance of line section L1 for the zero sequence component,

$\underline{Z}_{1L(2n-3)}$ - impedance of line section L(2n-3) for the positive sequence component,

$\underline{Z}_{0L(2n-3)}$- impedance of line section L(2n-3) for the zero sequence component,

$\underline{Z}_{1L(2k-2)}$- impedance of line section L(2k-2) for the positive sequence component,

$\underline{Z}_{0L(2k-2)}$ impedance of line section L(2k-2) for the zero sequence component,

$\underline{Z}_{1L(2k-1)}$ - impedance of line section L(2k-1) for the positive sequence component,

$\underline{Z}_{0L(2k-1)}$ - impedance of line section L(2k-1) for the zero sequence component.

k- number of the tap point

n- number of the line terminal

**Preferably, for multi-terminal power lines,** equivalent source impedance for the negative sequence component ($\underline{Z}_{2S1}$) or for the incremental positive sequence component ($\underline{Z}_{\Delta1S1}$) is calculated assuming that the fault is located in the line section between the beginning of the line and the first tap point, according to the following equation:

$$(\underline{Z}_{iS1}) = \frac{-\underline{V}_{1i}}{\underline{I}_{1i}}$$

where

i=2 for negative sequence, i=Δ1 for incremental positive sequence component,

$\underline{V}_{1i}$ - voltage measured in station 1 (the first lower index) for individual symmetrical components, (the second lower index) i.e. negative component - index 2 and incremental positive sequence component - index Δ1,

$I_{1i}$ - current measured in station 1 (the first lower index) for individual symmetrical components, (the second lower index) i.e. negative component - index 2 and incremental positive sequence component - index Δ1.

Preferably, **for multi-terminal power lines,** equivalent source impedance (($Z_{2S(n)}$)) for the negative sequence component and (($Z_{\Delta1S(n)}$)) for the incremental positive sequence component is determined assuming that the fault is located in the line section between the end of the line and the last tap point, from the following equation:

$$(\underline{Z}_{iSn}) = -\frac{\underline{V}_{T(n-1)i}^{transf.} - (1-d_{(2n-3)}) \cdot \underline{Z}_{iL(2n-3)} \cdot \underline{I}_{T(n-1)ni}^{transf.} - d_{(2n-3)} \cdot \underline{Z}_{iL(2n-3)} \cdot (\underline{I}_{T(n-1)ni}^{transf.} - \underline{I}_{Fi})}{\underline{I}_{ni}}.$$

where:

i=2 for negative sequence component, i=Δ1 for incremental positive sequence component,

$\underline{V}_{T(n-1)i}^{transf.}$ - voltages in the final tap point T(n-1) for the negative sequence component i=2, or for incremental positive sequence component i=Δ1,

$d_{(2n-3)}$ - distance to fault from the end of the line to the fault point,

$\underline{Z}_{iL(2n-3)}$ - impedance of line section L(2n-3) for the negative sequence component i=2, or for incremental positive sequence component i=Δ1,

$\underline{I}_{T(n-1)ni}^{transf.}$ - values of current flowing from tap point T(n-1) to station n in line section L(2n-3) for negative sequence component i=2, or for incremental positive sequence component i=Δ1

$\underline{I}_{Fi}$ - total fault current for negative sequence component i=2, or for incremental positive sequence component i=Δ1,

$\underline{I}_{ni}$ - current measured in last station n (the first lower index) for individual symmetrical components, (the second lower index) i.e. negative component - index 2 and incremental positive sequence component - index Δ1.

Preferably, for **multi-terminal power lines,** equivalent source impedance for the negative sequence component (($\underline{Z}_{2Sk}$)) and for the incremental positive sequence component (($\underline{Z}_{\Delta 1Sk}$)) is determined assuming that the fault is located in the tapped line, from the following equation:

$$(\underline{Z}_{iSk}) = -\frac{\underline{V}_{Tki}^{transf.} - (1-d_{(2k-2)}) \cdot \underline{Z}_{iL(2k-2)} \cdot \underline{I}_{Tkki}^{transf.} - d_{(2k-2)} \cdot \underline{Z}_{iL(2k-2)} \cdot (\underline{I}_{Tkki}^{transf.} - \underline{I}_{F2})}{\underline{I}_{ki}}$$

where:

$\underline{V}_{Tki}^{transf.}$ - voltages in the $k^{th}$ tap point for the negative sequence component i=2, or for incremental positive sequence component i=Δ1,

$d_{(2k-2)}$ - distance to fault from the end of the tapped line to the fault point Tk,

$\underline{Z}_{iL(2k-2)}$ - impedance of line section L(2k-2) for the negative sequence component i=2, or for incremental positive sequence component i=Δ1,

$\underline{I}_{Tkki}^{transf.}$ - values of current flowing from tap point Tk to $k^{th}$ station in tapped line section L(2k-2) for negative sequence component i=2, or for incremental positive sequence component i=Δ1

$\underline{I}_{Fi}$ - total fault current for negative sequence component i=2, or for incremental positive sequence component i=Δ1,

$\underline{I}_{ki}$ current measured in station k (the first lower index) for individual symmetrical components, (the second lower index) i.e. negative component - index 2 and incremental positive sequence component - index Δ1.

Preferably, **for multi-terminal power lines,** equivalent source impedance for the negative sequence component (($\underline{Z}_{2Sk}$) and ($\underline{Z}_{2S(k+1)}$)) and for the incremental positive sequence component (($\underline{Z}_{\Delta 1Sk}$) and ($\underline{Z}_{\Delta 1S(k+1)}$)) is calculated assuming that the fault is located in the line section between two consecutive tap points, from the following equations:

$$(\underline{Z}_{iSk}) = -\frac{\underline{V}_{Tki}^{transf.} - d_{(2k-1)} \cdot \underline{Z}_{iL(2k-1)} \cdot \underline{I}_{TkT(k+1)i}^{transf.} - (1-d_{(2k-1)}) \cdot \underline{Z}_{iL(2k-1)} \cdot (\underline{I}_{TkT(k+1)i}^{transf.} - \underline{I}_{Fi}) + \underline{Z}_{iLk}\underline{I}_{ki}}{\underline{I}_{ki}}$$

,

$$(\underline{Z}_{iS(k+1)}) = -\frac{\underline{V}_{Tki}^{transf.} - d_{(2k-1)} \cdot \underline{Z}_{iL(2k-1)} \cdot \underline{I}_{TkT(k+1)i}^{transf.} - (1 - d_{(2k-1)}) \cdot \underline{Z}_{iL(2k-1)} \cdot (\underline{I}_{TkT(k+1)i}^{transf.} - \underline{I}_{Fi}) + \underline{Z}_{iL(2k)} \underline{I}_{(k+1)i}}{\underline{I}_{(k+1)i}}$$

where:

$\underline{V}_{Tki}^{transf.}$ - voltages in the $k^{th}$ tap point for the negative sequence component i=2, or for incremental positive sequence component i=Δ1,

$d_{(2k-1)}$ - distance to fault on the line section between two tap points

$\underline{Z}_{iL(2k-1)}$- impedance of line section L(2k-1) for the negative sequence component i=2, or for incremental positive sequence component i=Δ1,

$\underline{I}_{TkT(k+1)i}^{transf.}$ - current flowing from tap point Tk to tap point T(k+1) in the line section for negative sequence component i=2, or for incremental positive sequence component i=Δ1

$I_{Fi}$ - total fault current for negative sequence component i=2, or for incremental poisitive sequence component i=Δ1,

$\underline{I}_{ki}$ current measured in station k (the first lower index) for individual symmetrical components, (the second lower index) i.e. negative component - index 2 and incremental positive sequence component - index Δ1,

$\underline{I}_{(k+1)i}$ - current measured in station k+1 (the first lower index) for individual symmetrical components, (the second lower index) i.e. negative component - index 2 and incremental positive sequence component - index Δ1

ADVANTAGES OF THE INVENTION

The advantage of the method for fault location in electric power lines which is the subject of this invention is that it makes it possible to determine the fault point for a transmission or distribution system both with passive and active tap (taps). Due to the required input signals, the inventive location method can be applied in differential-current protection, which will increase the functionality of the protective relay. In this way, the protective relay, besides its main feature, i.e. indication whether the fault occurred in the given protection zone or outside it, will be able to exactly define the location of the fault.
In addition, the inventive method is resistant to pre-fault conditions defined by the direction and volume of flow of the pre-fault power.

AN EXAMPLE OF THE INVENTION EMBODIMENT

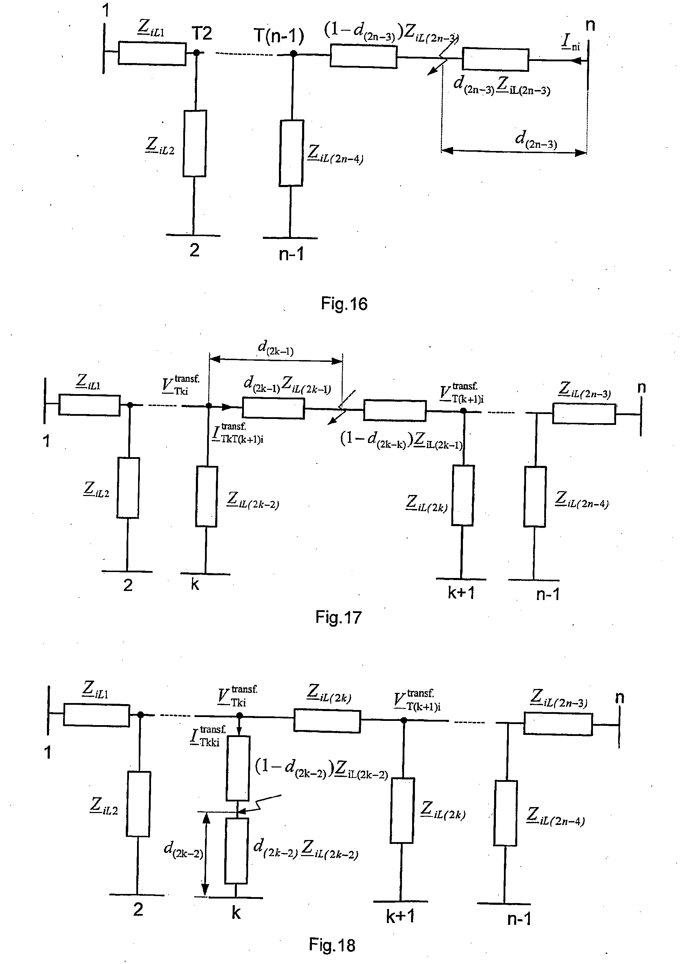

The method according to the present invention is explained in an embodiment shown in the drawing, where fig.1 shows a general diagram of the electric network for the implementation of the inventive method for a three-terminal electric power line, with indicated sections LA, LB and LC, fig. 2 - an equivalent circuit diagram for the positive sequence component for the assumption that the fault occurred in line section LA, fig. 3 - an equivalent circuit diagram of a transmission system for the negative sequence component for the assumption that the fault occurred in line section LA, fig. 4 - an equivalent circuit diagram of a transmission system for the zero sequence component for the assumption that the fault occurred in line section LA, fig. 5 - an equivalent circuit diagram for the positive sequence component for the assumption that the fault occurred in line section LB, fig. 6 - an equivalent circuit diagram of a transmission system for the negative sequence component for the assumption that the fault occurred in line section LB, fig. 7 - an equivalent circuit diagram of a transmission system for the zero sequence component for the assumption that the fault occurred in line section LB, fig. 8 - an equivalent circuit diagram for the positive sequence component for the assumption that the fault occurred in line section LC, fig. 9 - an equivalent circuit diagram of a transmission system for the negative sequence component for the assumption that the fault occurred in line section LC, fig. 10 - an equivalent circuit diagram of a transmission system for the zero sequence component for the assumption that the fault occurred in line section LC, and fig. 11 - an equivalent circuit diagram of a transmission system for the negative sequence component for the assumption that the fault occurred in line section LA for calculating the impedance of equivalent systems, fig.12 - an equivalent circuit diagram for the  incremental positive sequence component for the assumption that the fault occurred in line section LA for calculating the impedance of equivalent systems, fig. 13 - shows the network of actions performed when locating faults on the basis of the inventive method for a three-terminal electric power line, fig. 14 - a general diagram of the transmission system for the implementation of the inventive method for a multi-terminal power line, fig. 15 - an equivalent circuit diagram of a transmission system for symmetrical components assuming that the fault is located in the first section of a multi-terminal power line, fig. 16 - an equivalent circuit diagram of a transmission system for symmetrical components for an assumption that the fault is located in the final section of a multi-terminal power line, fig. 17 - a fragment of the equivalent circuit diagram of a transmission system for symmetrical components assuming that the fault is located in a section of a tapped line of a multi-terminal power line, fig. 18 - a fragment of the equivalent circuit diagram of a transmission system for symmetrical components for the assumption that the fault is located in a section of a multi-terminal power line between two tap points, fig. 19 shows the network of actions performed when locating faults on the basis of the inventive method for a multi-terminal electric power line.

**An example of the invention embodiment for a three-terminal power line.**

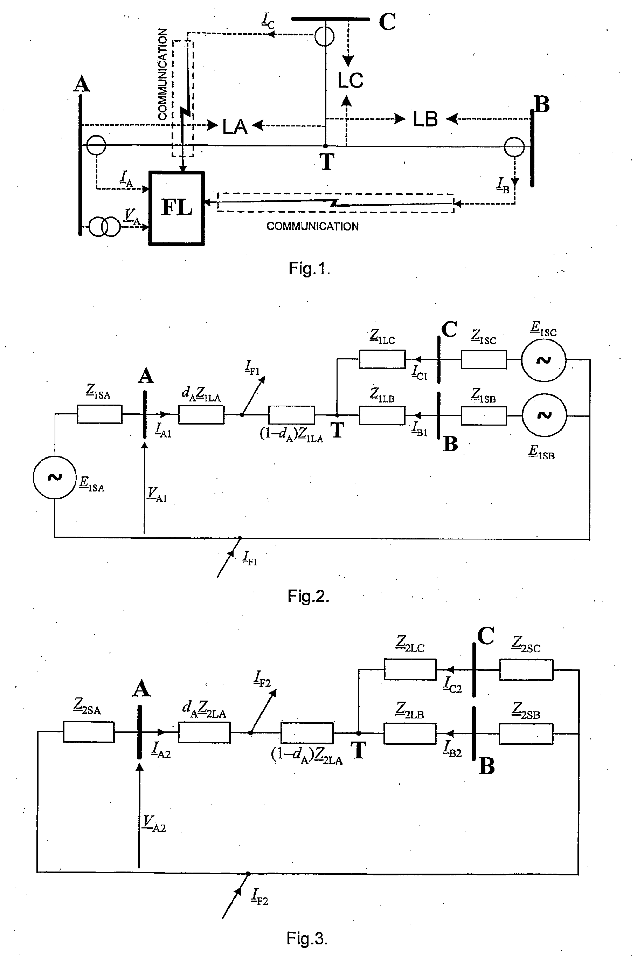

The transmission system shown in fig. 1 consists of three electric power stations A, B and C. Station A is located at the beginning of the line, station B at the end of this line and station C after the line which in tap point T is branched out from the line between stations AB. Tap point T divides the transmission system into three sections LA, LB and LC. In station A there is a fault locator FL. Fault location is done using models of faults and fault loops for symmetrical components and different types of faults, by applying suitable share coefficients determining the relation between the symmetrical components of the total fault current when voltage drop across the fault resistance is estimated, defined as $\underline{a}_{F1}$, $\underline{a}_{F2}$, $\underline{a}_{F0}$ and weight coefficients $\underline{a}_1$, $\underline{a}_2$, $\underline{a}_0$, defining the share of individual components in the total model of the fault loop. Analysis of boundary conditions for different types of faults shows that there is a certain degree of freedom when determining the share coefficients determining the relation between the symmetrical components of the total fault current when voltage drop across the fault resistance is estimated. Their selection depends on the adopted preference of the use of individual sequence components depending on the type of the fault. In the presented example of the invention embodiment, in order to ensure high precision of the fault location, voltage drop across the fault resistance is estimated using:

-    the negative sequence component of the total fault current for phase-to-earth faults (a-g), (b-g), (c-g) and phase-to-phase faults (a -b), (b-c) i (c-a),

-    the negative sequence component and the zero sequence component for double phase-to-earth faults (a-b-g), (b-c-g), (c-a-g),

-    incremental positive sequence component for three-phase faults (a-b-c, a-b-c-g), for which the fault value is decreased by the pre-fault value of the positive-sequence component of current.

Examples of share coefficients determining the relation between the symmetrical components of the total fault current when voltage drop across the fault resistance is estimated are shown in table 1. The type of the fault is denoted by symbols: a-g, b-g, c-g , a-b, b-c, c-a, where letters a, b, c denote individual phases, and letter g denotes earthing, index 1 denotes the positive-sequence component, index 2 - the negative component, and index 0 - the zero sequence component.

TABLE 1.

| Fault (F) | $\underline{a}_{F1}$ | $\underline{a}_{F2}$ | $\underline{a}_{F0}$ |
|---|---|---|---|
| a-g | 0 | 3 | 0 |
| b-g | 0 | $3\underline{a}$ | 0 |
| c-g | 0 | $3\underline{a}^2$ | 0 |
| a-b | 0 | $1-\underline{a}$ | 0 |
| b-c | 0 | $\underline{a}\,\underline{a}^2$ | 0 |
| c-a | 0 | $\underline{a}^2-1$ | 0 |
| $\underline{a}$=exp(j2π/3); $\mathbf{j}=\sqrt{-1}$ | | | |

Synchronised measurements of phase currents from stations A, B, C and of phase voltages from station A are supplied to the fault locator FL. Additionally, it is assumed that the fault locator is supplied with information about the type of the fault and the time of its occurrence. The process of fault location, assuming that it is a fault of the type (a-b-g) - double phase-to-earth fault, is as follows:

**I. Stage one**

1. In stations A, B, C, current input signals from individual lines for fault and pre-fault conditions are measured. In station A, phase voltages of the line in fault and pre-fault conditions are measured. Next, the symmetrical components of the phase currents measured in stations A, B, C and of phase voltages measured in station A are calculated.
2. Total fault current ($\underline{I}_F$) is calculated from this equation:

$$\underline{I}_F = \underline{a}_{F1}\underline{I}_{F1} + \underline{a}_{F2}\underline{I}_{F2} + \underline{a}_{F0}\underline{I}_{F0} \tag{1}$$

where :

the first lower index "F" denotes a fault condition, the second lower index "1" denotes the positive sequence component, "2" - the negative component, "0" - zero sequence component,
and the share coefficients determining the relation between the symmetrical components of the total fault current when voltage drop across the fault resistance is estimated are as follows:

$$\underline{a}_{F1} = 0 \,,$$

$$\underline{a}_{F2} = \underline{a}_{F2}^{\text{init.}} - \frac{\underline{a}_{F1}^{\text{init.}}\underline{b}_{F2}}{\underline{b}_{F1}} \,,$$

$$\underline{a}_{F0} = \frac{\underline{a}_{F1}^{\text{init.}}}{\underline{b}_{F1}} \,,$$

whereas, in particular for a-b-g fault:

$$\underline{a}_{F1}^{\text{init.}} = 1 - \underline{a}^2 \,,$$

$$\underline{a}_{F2}^{\text{init.}} = 1 - \underline{a} \,,$$

$$\underline{b}_{F1} = -\underline{a} \,,$$

$$\underline{b}_{F2} = -\underline{a}^2 \,,$$

$$\underline{a} = \exp^{j\,2\pi/3} = -0,5 + j\,\frac{\sqrt{3}}{2},$$

$$\underline{I}_{F1} = \underline{I}_{A1} + \underline{I}_{B1} + \underline{I}_{C1} \tag{2},$$

$$\underline{I}_{F2} = \underline{I}_{A2} + \underline{I}_{B2} + \underline{I}_{C2} \tag{3},$$

$$\underline{I}_{F0} = \underline{I}_{A0} + \underline{I}_{B0} + \underline{I}_{C0} \tag{4}.$$

where: the first lower index denotes the station, the second lower index denotes: 1 - the positive sequence component, 2 - the negative component, 0 - the zero sequence component.

For faults of other types, the share coefficients determining the relation between the symmetrical components of the total fault current when voltage drop across the fault resistance is estimated and "relation coefficients" are compiled in tables 1, 2 and 3.

Table 2.

| Fault (F) | Initial share coefficient determining the relation between the symmetrical components of the total fault current when voltage drop across the fault resistance is estimated | | | Relation coefficient | |
|---|---|---|---|---|---|
| | $\underline{a}_{F1}^{\text{init.}}$ | $\underline{a}_{F2}^{\text{init.}}$ | $\underline{a}_{F0}^{\text{init.}}$ | $\underline{b}_{F1}$ | $\underline{b}_{F2}$ |
| a-b-g | $1 - \underline{a}^2$ | $1 - \underline{a}$ | 0 | $-\underline{a}$ | $-\underline{a}^2$ |
| b-c-g | $\underline{a}^2 - \underline{a}$ | $\underline{a} - \underline{a}^2$ | 0 | -1 | -1 |
| c-a-g | $\underline{a} - 1$ | $\underline{a}^2 - 1$ | 0 | $-\underline{a}^2$ | $-\underline{a}$ |

Table 3.

| Fault (F) | share coefficient determining the relation between the symmetrical components of the total fault current when voltage drop across the fault resistance is estimated | | |
|---|---|---|---|
| | $\underline{a}_{F1}$ | $\underline{a}_{F2}$ )[*] | $\underline{a}_{F0}$ |
| a-b-c, a-b-c-g | $1 - \underline{a}^2$ | $1 - \underline{a}$ | 0 |
| )[*] - due to the lack of the negative component this coefficient may be adopted as = 0 | | | |

**II. Stage two**

In stage two, a hypothetical fault point is assumed and the distance between the end of the given line section and the hypothetical fault point is calculated on the following assumptions:

- calculation of the distance from the beginning of the line to the fault point assuming that the fault occurred in line section LA - actions 3.1.a - 3.2.a,
- calculation of the distance from the end of the line to the fault point assuming that the fault occurred in line section LB - actions 3.1.b - 3.4.b,
- calculation of the distance from the end of the tapped line to the fault point assuming that the fault occurred in line section LC - actions 3.1.c - 3.3.c.

**3.1.a.** The fault loop voltage and current is determined from the following relations between symmetrical components (fig.2-4):

$$\underline{V}_{Ap} = \underline{a}_1\underline{V}_{A1} + \underline{a}_2\underline{V}_{A2} + \underline{a}_0\underline{V}_{A0} \qquad (5),$$

$$\underline{I}_{Ap} = \underline{a}_1\underline{I}_{A1} + \underline{a}_2\underline{I}_{A2} + \underline{a}_0\frac{\underline{Z}_{0LA}}{\underline{Z}_{1LA}}\underline{I}_{A0} \qquad (6)$$

where:

$\underline{V}_{A1}, \underline{V}_{A2}, \underline{V}_{A0}$ - voltage measured in station A for individual symmetrical components, the positive sequence component - index 1, the negative component - index 2 and the zero sequence component - index 0.
$\underline{I}_{A1}, \underline{I}_{A2}, \underline{I}_{A0}$ - currents measured in station A for the positive sequence component - index 1, the negative component - index 2 and the zero sequence component - index 0,
$\underline{Z}_{1LA}$ - the impedance of line section LA for the positive sequence component,
$\underline{Z}_{0LA}$ - the impedance of line section LA for the zero sequence component,

In particular for a-b-g fault, the weight coefficients are :

$$\underline{a}_1 = 1 - \underline{a}^2,$$

$$\underline{a}_2 = 1 - \underline{a},$$

$$\underline{a}_0 = 0.$$

Weight coefficients for other types of faults are compiled in table 4.

Table 4.

| Fault | $\underline{a}_1$ | $\underline{a}_2$ | $\underline{a}_0$ |
|---|---|---|---|
| a-g | 1 | 1 | 1 |
| b-g | $\underline{a}^2$ | $\underline{a}$ | 1 |
| c-g | $\underline{a}$ | $\underline{a}^2$ | 1 |
| a-b, a-b-g a-b-c, a-b-c-g | $1 - \underline{a}^2$ | $1 - \underline{a}$ | 0 |
| b-c, b-c-g | $\underline{a}^2 - \underline{a}$ | $\underline{a} - \underline{a}^2$ | 0 |
| c-a, c-a-g | $\underline{a} - 1$ | $\underline{a}^2 - 1$ | 0 |

Fault loop equation has the following form:

$$\underline{V}_{Ap} - d_A \underline{Z}_{1LA} \underline{I}_{Ap} - R_{FA} \underline{I}_F = 0 \qquad (7).$$

When the equation (7) has been written out separately for the real part and the imaginary part and further mathematical transformations have been performed, the solutions shown under 3.2a are obtained.

**3.2a.** The distance to the fault point $d_A$ and the fault resistance $R_{FA}$ are determined from the following equations:

$$d_A = \frac{\text{real}(\underline{V}_{Ap})\text{imag}(\underline{I}_F) - \text{imag}(\underline{V}_{Ap})\text{real}(\underline{I}_F)}{\text{real}(\underline{Z}_{1LA}\underline{I}_{Ap})\text{imag}(\underline{I}_F) - \text{imag}(\underline{Z}_{1LA}\underline{I}_{Ap})\text{real}(\underline{I}_F)} \qquad (8),$$

$$R_{FA} = \frac{1}{2}\left[\frac{\text{real}(\underline{V}_{Ap}) - d_A\text{real}(\underline{Z}_{1LA}\underline{I}_{Ap})}{\text{real}(\underline{I}_F)} + \frac{\text{imag}(\underline{V}_{Ap}) - d_A\text{imag}(\underline{Z}_{1LA}\underline{I}_{Ap})}{\text{imag}(\underline{I}_F)}\right] \qquad (9),$$

where:

"real" denotes the real part of the given quantity,

"imag" denotes the imaginary part of the given quantity,

$\underline{V}_{Ap}$ - denotes the voltage of the fault loop as per the formula (5)

$\underline{I}_F$ - denotes the total fault current as per the formula (1),

$\underline{Z}_{1LA}$ - denotes the impedance of the line section LA for the positive sequence component,

$\underline{I}_{Ap}$ - denotes the fault loop current determined as per the formula (6).

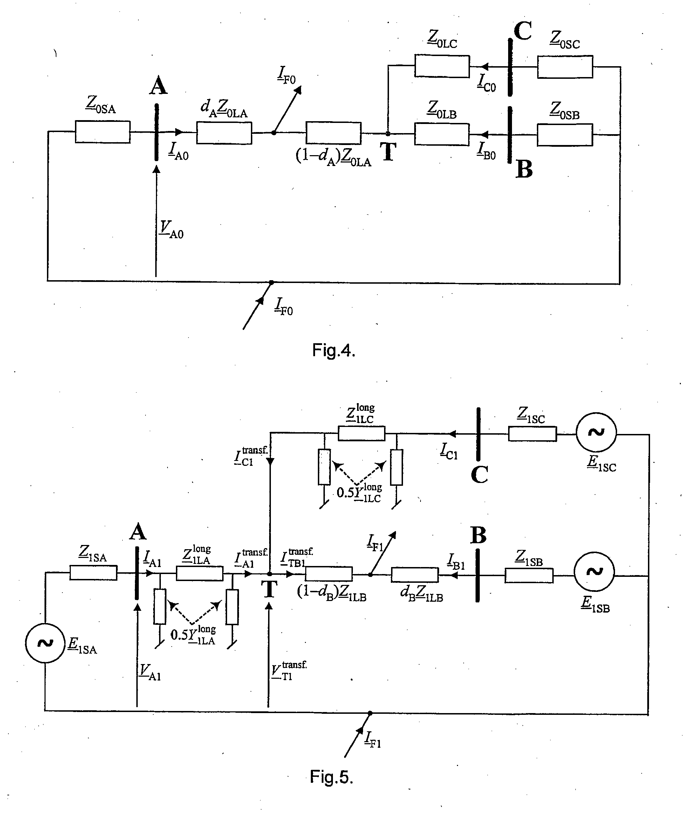

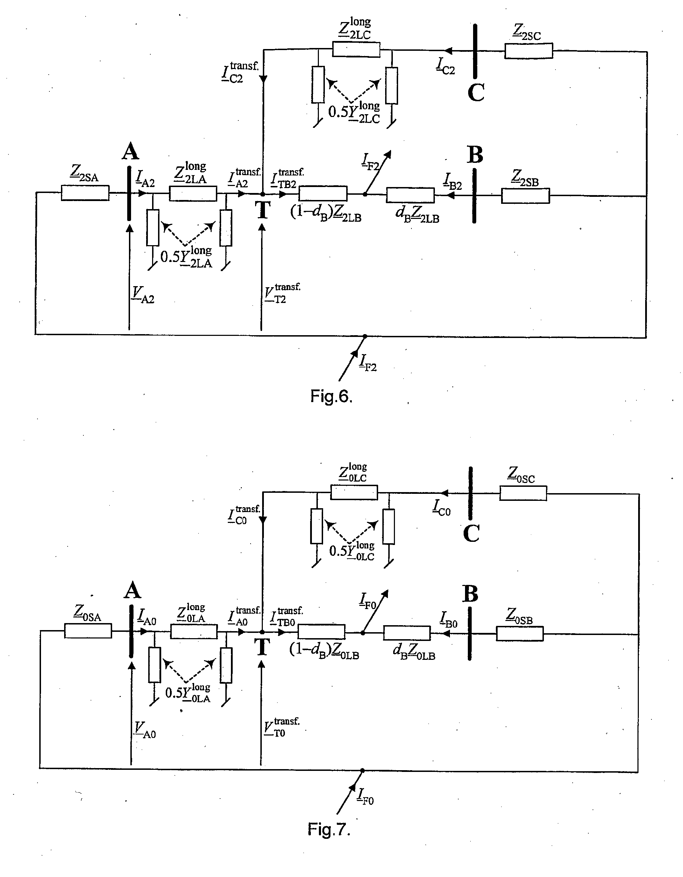

**3.1.b.** Voltages for symmetrical components are calculated $\underline{V}_{T1}^{\text{transf.}}$, $\underline{V}_{T2}^{\text{transf.}}$, $\underline{V}_{T0}^{\text{transf.}}$ (fig. 5-7) in tap point T:

$$\underline{V}_{T1}^{\text{transf.}} = \cosh(\underline{\gamma}_{1LA}\ell_{LA})\cdot\underline{V}_{A1} - \underline{Z}_{c1LA}\sinh(\underline{\gamma}_{1LA}\ell_{LA})\cdot\underline{I}_{A1},$$

$$\underline{V}_{T2}^{\text{transf.}} = \cosh(\underline{\gamma}_{1LA}\ell_{LA})\cdot\underline{V}_{A2} - \underline{Z}_{c1LA}\sinh(\underline{\gamma}_{1LA}\ell_{LA})\cdot\underline{I}_{A2},$$

$$\underline{V}_{T0}^{\text{transf.}} = \cosh(\underline{\gamma}_{0LA}\ell_{LA})\cdot\underline{V}_{A0} - \underline{Z}_{c0LA}\sinh(\underline{\gamma}_{0LA}\ell_{LA})\cdot\underline{I}_{A0},$$

where:

$\underline{\gamma}_{1LA}$ - propagation constant of line section LA for the positive and negative sequence components,

$\underline{\gamma}_{0LA}$ - propagation constant of line section LA for the zero sequence component,

$\ell_{LA}$ length of line section LA,

$\underline{Z}_{c1LA}$ - surge impedance of section LA for the positive and negative sequence components,

$\underline{Z}_{c0LA}$ - surge impedance of section LA for the zero sequence component.

**3.2.b.** The values of currents incoming to tap point T from line section

$$LA: \underline{I}_{A1}^{\text{transf.}}, \underline{I}_{A2}^{\text{transf.}}, \underline{I}_{A0}^{\text{transf.}} \text{ and section } LC: \underline{I}_{C1}^{\text{transf.}}, \underline{I}_{C2}^{\text{transf.}}, \underline{I}_{C0}^{\text{transf.}} \text{ (fig.5-7)}$$

$$\underline{I}_{A1}^{\text{transf.}} = (-1/\underline{Z}_{c1LA}) \cdot \sinh(\underline{\gamma}_{1LA}\ell_{LA}) \cdot \underline{V}_{A1} + \cosh(\underline{\gamma}_{1LA}\ell_{LA}) \cdot \underline{I}_{A1},$$

$$\underline{I}_{A2}^{\text{transf.}} = (-1/\underline{Z}_{c1LA}) \cdot \sinh(\underline{\gamma}_{1LA}\ell_{LA}) \cdot \underline{V}_{A2} + \cosh(\underline{\gamma}_{1LA}\ell_{LA}) \cdot \underline{I}_{A2},$$

$$\underline{I}_{A0}^{\text{transf.}} = (-1/\underline{Z}_{c0LA}) \cdot \sinh(\underline{\gamma}_{0LA}\ell_{LA}) \cdot \underline{V}_{A0} + \cosh(\underline{\gamma}_{0LA}\ell_{LA}) \cdot \underline{I}_{A0},$$

$$\underline{I}_{C1}^{\text{transf.}} = (-1/\underline{Z}_{c1LC}) \cdot \tanh(\underline{\gamma}_{1LC}\ell_{LC}) \cdot \underline{V}_{T1}^{\text{transf.}} + (1/\cosh(\underline{\gamma}_{1LC}\ell_{LC})) \cdot \underline{I}_{C1},$$

$$\underline{I}_{C2}^{\text{transf.}} = (-1/\underline{Z}_{c1LC}) \cdot \tanh(\underline{\gamma}_{1LC}\ell_{LC}) \cdot \underline{V}_{T2}^{\text{transf.}} + (1/\cosh(\underline{\gamma}_{1LC}\ell_{LC})) \cdot \underline{I}_{C2},$$

$$\underline{I}_{C0}^{\text{transf.}} = (-1/\underline{Z}_{c0LC}) \cdot \tanh(\underline{\gamma}_{0LC}\ell_{LC}) \cdot \underline{V}_{T0}^{\text{transf.}} + (1/\cosh(\underline{\gamma}_{0LC}\ell_{LC})) \cdot \underline{I}_{C0},$$

where:

$\gamma_{1LC}$ - propagation constant of line, section LC for the positive and negative sequence components,
$\gamma_{0LC}$ - propagation constant of line section LC for the zero sequence component,
$\underline{Z}_{c1LC}$ - surge impedance of section LC for the positive and negative sequence components,
$\underline{Z}_{c0LC}$ - surge impedance of section LC for the zero sequence component,
$\ell_{LC}$ - length of line section LC.

**3.3.b.** The values of current $\underline{I}_{TB1}^{\text{transf.}}$, $\underline{I}_{TB2}^{\text{transf.}}$, $\underline{I}_{TB0}^{\text{transf.}}$ flowing from tap point T to station B in line section LB is calculated:

$$\underline{I}_{TB1}^{\text{transf.}} = \underline{I}_{A1}^{\text{transf.}} + \underline{I}_{C1}^{\text{transf.}},$$

$$\underline{I}_{TB2}^{\text{transf.}} = \underline{I}_{A2}^{\text{transf.}} + \underline{I}_{C2}^{\text{transf.}},$$

$$\underline{I}_{\text{TB0}}^{\text{transf.}} = \underline{I}_{\text{A0}}^{\text{transf.}} + \underline{I}_{\text{C0}}^{\text{transf.}} .$$

Fault loop equation has the following form:

$$\underline{V}_{\text{Tp}} - (1 - d_{\text{B}})\underline{Z}_{\text{1LB}}\underline{I}_{\text{TBp}} - R_{\text{FB}}\underline{I}_{\text{F}} = 0 \tag{10},$$

where:

$$\underline{V}_{\text{Tp}} = \underline{a}_1 \underline{V}_{\text{T1}}^{\text{transf.}} + \underline{a}_2 \underline{V}_{\text{T2}}^{\text{transf.}} + \underline{a}_0 \underline{V}_{\text{T0}}^{\text{transf.}}$$

$$\underline{I}_{\text{TBp}} = \underline{a}_1 \underline{I}_{\text{TB1}}^{\text{transf.}} + \underline{a}_2 \underline{I}_{\text{TB2}}^{\text{transf.}} + \underline{a}_0 \frac{\underline{Z}_{\text{0LB}}}{\underline{Z}_{\text{1LB}}} \underline{I}_{\text{TB0}}^{\text{transf.}} \tag{11}.$$

When the equation (10) has been written out separately for the real part and the imaginary part and further mathematical transformations have been performed, the solutions shown under 3.4b are obtained.

**3.4.b.** The distance to fault point $d_B$ and fault resistance $R_{\text{FB}}$ are calculated from the following equations:

$$d_{\text{B}} = \frac{-\operatorname{real}(\underline{V}_{\text{Tp}} - \underline{Z}_{\text{1LB}}\underline{I}_{\text{TBp}})\operatorname{imag}(\underline{I}_{\text{F}}) + \operatorname{imag}(\underline{V}_{\text{Tp}} - \underline{Z}_{\text{1LB}}\underline{I}_{\text{TBp}})\operatorname{real}(\underline{I}_{\text{F}})}{\operatorname{real}(\underline{Z}_{\text{1LB}}\underline{I}_{\text{TBp}})\operatorname{imag}(\underline{I}_{\text{F}}) - \operatorname{imag}(\underline{Z}_{\text{1LB}}\underline{I}_{\text{TBp}})\operatorname{real}(\underline{I}_{\text{F}})} \tag{12},$$

$$R_{\text{FB}} = \frac{1}{2}\left[\frac{\operatorname{real}(\underline{V}_{\text{Tp}}) - (1 - d_{\text{B}}) \cdot \operatorname{real}(\underline{Z}_{\text{1LB}}\underline{I}_{\text{TBp}})}{\operatorname{real}(\underline{I}_{\text{F}})}\right] + \frac{1}{2}\left[\frac{\operatorname{imag}(\underline{V}_{\text{Tp}}) - (1 - d_{\text{B}}) \cdot \operatorname{imag}(\underline{Z}_{\text{1LB}}\underline{I}_{\text{TBp}})}{\operatorname{imag}(\underline{I}_{\text{F}})}\right]$$

$$\tag{13},$$

where:

$\underline{Z}_{\text{1LB}}$ - impedance of line section LB for the positive sequence component,
$\underline{Z}_{\text{0LB}}$ - impedance of line section LB for the zero sequence component.

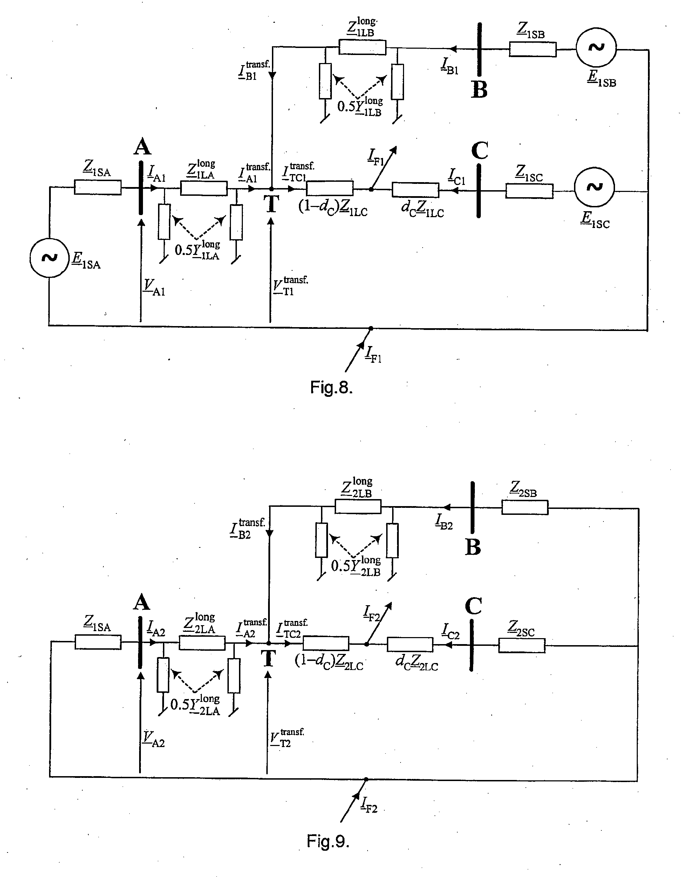

**3.1.c.** The values of currents incoming to tap point T (fig. 8-10) from line sections LA $\underline{I}_{\text{A1}}^{\text{transf.}}$, $\underline{I}_{\text{A2}}^{\text{transf.}}$, $\underline{I}_{\text{A0}}^{\text{transf.}}$ and section LB $\underline{I}_{\text{B1}}^{\text{transf.}}$, $\underline{I}_{\text{B2}}^{\text{transf.}}$, $\underline{I}_{\text{B0}}^{\text{transf.}}$ are calculated according to these formulas:

$$\underline{I}_{\text{B1}}^{\text{transf.}} = (-1/\underline{Z}_{\text{c1LB}}) \cdot \tanh(\underline{\gamma}_{\text{1LB}}\ell_{\text{LB}}) \cdot \underline{V}_{\text{T1}}^{\text{transf.}} + (1/\cosh(\underline{\gamma}_{\text{1LB}}\ell_{\text{LB}})) \cdot \underline{I}_{\text{B1}},$$

$$\underline{I}_{B2}^{\text{transf.}} = (-1/\underline{Z}_{c1LB}) \cdot \tanh(\underline{\gamma}_{1LB}\ell_{LB}) \cdot \underline{V}_{T2}^{\text{transf.}} + (1/\cosh(\underline{\gamma}_{1LB}\ell_{LB})) \cdot \underline{I}_{B2} ,$$

$$\underline{I}_{B0}^{\text{transf.}} = (-1/\underline{Z}_{c0LB}) \cdot \tanh(\underline{\gamma}_{0LB}\ell_{LB}) \cdot \underline{V}_{T0}^{\text{transf.}} + (1/\cosh(\underline{\gamma}_{0LB}\ell_{LB})) \cdot \underline{I}_{B0} ,$$

$$\underline{I}_{A1}^{\text{transf.}} = (-1/\underline{Z}_{c1LA}) \cdot \sinh(\underline{\gamma}_{1LA}\ell_{LA}) \cdot \underline{V}_{A1} + \cosh(\underline{\gamma}_{1LA}\ell_{LA}) \cdot \underline{I}_{A1} ,$$

$$\underline{I}_{A2}^{\text{transf.}} = (-1/\underline{Z}_{c1LA}) \cdot \sinh(\underline{\gamma}_{1LA}\ell_{LA}) \cdot \underline{V}_{A2} + \cosh(\underline{\gamma}_{1LA}\ell_{LA}) \cdot \underline{I}_{A2} ,$$

$$\underline{I}_{A0}^{\text{transf.}} = (-1/\underline{Z}_{c0LA}) \cdot \sinh(\underline{\gamma}_{0LA}\ell_{LA}) \cdot \underline{V}_{A0} + \cosh(\underline{\gamma}_{0LA}\ell_{LA}) \cdot \underline{I}_{A0} ,$$

where:

$\gamma_{1LB}$ - propagation constant of line section LB for the positive and negative sequence components,
$\gamma_{0LB}$ - propagation constant of line section LB for the zero sequence component,
$\ell_{LB}$ - the length of line section LB.
$\underline{Z}_{c1LB}$ - surge impedance of section LB for the positive sequence and negative components,
$\underline{Z}_{c0LB}$ - surge impedance of section LB for the zero sequence component.

**3.2.c.** The value of current $\underline{I}_{TC1}^{\text{transf.}}$, $\underline{I}_{TC2}^{\text{transf.}}$, $\underline{I}_{TC0}^{\text{transf.}}$ flowing from tap point T to station C in line section LC (fig.8-10) is calculated:

$$\underline{I}_{TC1}^{\text{transf.}} = \underline{I}_{A1}^{\text{transf.}} + \underline{I}_{B1}^{\text{transf.}} ,$$

$$\underline{I}_{TC2}^{\text{transf.}} = \underline{I}_{A2}^{\text{transf.}} + \underline{I}_{B2}^{\text{transf.}} ,$$

$$\underline{I}_{TC0}^{\text{transf.}} = \underline{I}_{A0}^{\text{transf.}} + \underline{I}_{B0}^{\text{transf.}} .$$

Fault loop equation has the following form:

$$\underline{V}_{Tp} - (1 - d_C)\underline{Z}_{1LC}\underline{I}_{TCp} - R_{FC}\underline{I}_F = 0 \qquad\qquad (14)$$

where:

$$\underline{V}_{\text{Tp}} = \underline{a}_1 \underline{V}_{\text{T1}}^{\text{transf.}} + \underline{a}_2 \underline{V}_{\text{T2}}^{\text{transf.}} + \underline{a}_0 \underline{V}_{\text{T0}}^{\text{transf.}}$$

$$\underline{I}_{\text{TCp}} = \underline{a}_1 \underline{I}_{\text{TC1}}^{\text{transf.}} + \underline{a}_2 \underline{I}_{\text{TC2}}^{\text{transf.}} + \underline{a}_0 \frac{\underline{Z}_{\text{0LC}}}{\underline{Z}_{\text{1LC}}} \underline{I}_{\text{TC0}}^{\text{transf.}} \qquad (15)$$

When the equation (13) has been written out separately for the real part and the imaginary part and further mathematical transformations have been performed, the solutions shown under 3.3,c are obtained.

**3.3.c.** The distance to fault point $d_C$ and fault resistance $R_{FC}$ are calculated from the following equations:

$$d_C = \frac{-\text{real}(\underline{V}_{\text{Tp}} - \underline{Z}_{\text{1LC}} \underline{I}_{\text{TCp}})\text{imag}(\underline{I}_F) + \text{imag}(\underline{V}_{\text{Tp}} - \underline{Z}_{\text{1LC}} \underline{I}_{\text{TCp}})\text{real}(\underline{I}_F)}{\text{real}(\underline{Z}_{\text{1LC}} \underline{I}_{\text{TCp}})\text{imag}(\underline{I}_F) - \text{imag}(\underline{Z}_{\text{1LC}} \underline{I}_{\text{TCp}})\text{real}(\underline{I}_F)} \qquad (16),$$

$$R_{FC} = \frac{1}{2}\left[\frac{\text{real}(\underline{V}_{\text{Tp}}) - (1 - d_C) \cdot \text{real}(\underline{Z}_{\text{1LC}} \underline{I}_{\text{TCp}})}{\text{real}(\underline{I}_F)}\right] + \frac{1}{2}\left[\frac{\text{imag}(\underline{V}_{\text{Tp}}) - (1 - d_C) \cdot \text{imag}(\underline{Z}_{\text{1LC}} \underline{I}_{\text{TCp}})}{\text{imag}(\underline{I}_F)}\right]$$

$$(17).$$

### III. Stage three

At this stage the selection of final results is done.

4. It is checked whether the results of the calculation of the distances $d_A$, $d_B$, $d_C$ to the fault point are contained within the interval (0÷1) in relative units:

$0 \leq d_A \leq 1,$
$0 \leq d_B \leq 1,$
$0 \leq d_C \leq 1.$

Results which are not contained in the given interval show that they have been calculated on a false pre-assumption concerning the point of occurrence of the fault on the given line section. These results are rejected.

5. The second calculated value, i.e. fault resistance $R_{FA}$, $R_{FB}$, $R_{FC}$, is analysed and those results of the calculations for which the fault resistance is negative are rejected.

6. If the analysis of the criteria as in actions 4 and 5 does not indicate clearly which values define the place of the fault, then in subsequent actions the impedance of equivalent source systems for the negative component in the case of phase-to-earth, phase-to-phase, double phase-to earth faults, or alternatively for the incremental positive sequence component is calculated. For three-phase faults, the impedance of equivalent source systems for the incremental positive sequence component is calculated.

7. Current $\underline{I}_{FA2}$ (fig. 11) is calculated assuming that the fault occurred in line section LA:

$$\underline{I}_{FA2} = \frac{\underline{Z}_{\text{2SA}} + \underline{Z}_{\text{2LA}} + \underline{Q}_{\text{BC2}}(\underline{Z}_{\text{2LB}} + \underline{Z}_{\text{2SB}})}{(1 - d_A)\underline{Z}_{\text{2LA}} + \underline{Q}_{\text{BC2}}(\underline{Z}_{\text{2LB}} + \underline{Z}_{\text{2SB}})} \underline{I}_{\text{A2}},$$

where:

$$\underline{Q}_{BC2} = \frac{\underline{I}_{B2}}{\underline{I}_{B2} + \underline{I}_{C2}},$$

8. The equivalent source impedance $(\underline{Z}_{2SB})_{SUB\_A}$ is calculated assuming that the fault occurred in line section LA:

$$(\underline{Z}_{2SB})_{SUB\_A} = \frac{\underline{G}_{2A}\underline{I}_{A2} - \underline{H}_{2A}\underline{I}_{FA2}}{\underline{Q}_{BC2}(\underline{I}_{FA2} - \underline{I}_{A2})}, \qquad (18),$$

where:

$$\underline{G}_{2A} = \underline{Z}_{2SA} + \underline{Z}_{2LA} + \underline{Q}_{BC2}\underline{Z}_{2LB},$$

$$\underline{H}_{2A} = (1 - d_A)\underline{Z}_{2LA} + \underline{Q}_{BC2}\underline{Z}_{2LB},$$

$$\underline{Z}_{2SA} = \frac{-\underline{V}_{A2}}{\underline{I}_{A2}}.$$

9. The equivalent source impedance $(\underline{Z}_{2SC})_{SUB\_A}$ is calculated assuming that the fault occurred in line section LA:

$$(\underline{Z}_{2SC})_{SUB\_A} = \left(\underline{Z}_{2LB} + (\underline{Z}_{2SB})_{SUB\_A}\right)\frac{\underline{I}_{B2}}{\underline{I}_{C2}} - \underline{Z}_{2LC} \qquad (19).$$

10. The equivalent source impedance $(\underline{Z}_{2SB})_{SUB\_B}$ is calculated assuming that the fault occurred in line section LB:

$$(\underline{Z}_{2SB})_{SUB\_B} = \frac{(1 - d_B)\underline{Z}_{2LB}\underline{I}_{TB2}^{transf.} - d_B\underline{Z}_{2LB}\underline{I}_{B2} - \underline{V}_{T2}^{transf.}}{\underline{I}_{B2}} \qquad (20).$$

11. The equivalent source impedance $(\underline{Z}_{2SC})_{SUB\_B}$ is calculated assuming that the fault occurred in line section LB:

$$(\underline{Z}_{2SC})_{SUB\_B} = -\frac{\underline{V}_{C2}}{\underline{I}_{C2}} \qquad (21).$$

where:

$$\underline{V}_{C2} = \cosh(\underline{\gamma}_{2LC}\ell_{LC}) \cdot \underline{V}_{T2}^{transf.} + \underline{Z}_{c2LC}\sinh(\underline{\gamma}_{2LC}\ell_{LC}) \cdot \underline{I}_{C2}^{transf.},$$

$$\underline{\gamma}_{2LC} = \underline{\gamma}_{1LC}\,,$$

$$\underline{Z}_{c2LC} = \underline{Z}_{c1LC}$$

12. The equivalent source impedance $(\underline{Z}_{2SB})_{SUB\_c}$ is calculated assuming that the fault occurred in line section LC:

$$(\underline{Z}_{2SC})_{SUB\_C} = \frac{(1-d_C)\underline{Z}_{2LC}\underline{I}_{TC2}^{transf.} - d_C\underline{Z}_{2LC}\underline{I}_{C2} - \underline{V}_{T2}^{transf.}}{\underline{I}_{C2}} \quad (22).$$

13. The equivalent source impedance $(\underline{Z}_{2SB})_{SUB\_C}$ is calculated assuming that the fault occurred in line section LC:

$$(\underline{Z}_{2SB})_{SUB\_C} = -\frac{\underline{V}_{B2}}{\underline{I}_{B2}} \quad (23),$$

where:

$$\underline{V}_{B2} = \cosh(\underline{\gamma}_{2LB}\ell_{LB}) \cdot \underline{V}_{T2}^{transf.} + \underline{Z}_{c2LB}\sinh(\underline{\gamma}_{2LB}\ell_{LB}) \cdot \underline{I}_{B2}^{transf.}$$

14. The calculated equivalent source impedances are transformed into a modular form, whereupon the proper result is selected on the basis of the module of the equivalent source system impedances.

If the calculated value of the module of the equivalent source system impedances, assuming the occurrence of the fault on the given line section, does not correspond to the real value of the source system impedance module, it means that the preliminary data concerning the place of occurrence of the fault on the given section have been assumed wrongly, and the result of the calculation of the distance to the fault point made on this assumption is rejected.

If the value of the module of impedance of the equivalent source systems calculated on the assumption that the fault occurred in the given line section corresponds to the real value of the module of impedance of the equivalent source system, then the result of the calculation of the distance to the fault point indicates a correct pre-assumption and this result is considered to be final.

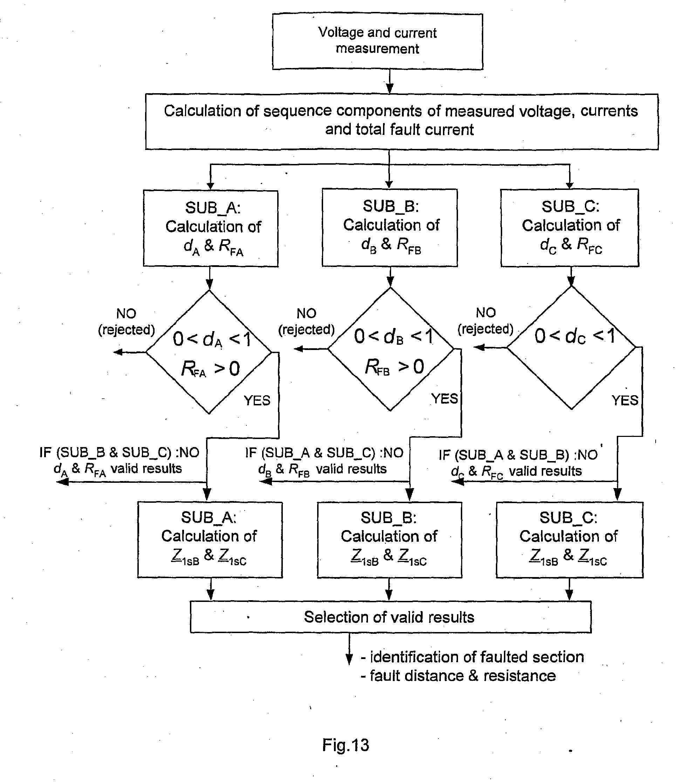

The network of actions shown in fig. 13 includes the following actions for the implementation of the invention:

- current and voltage measurement as per point 1 of the example embodiment of the invention,

- determination of the symmetrical components of the measured currents and voltages and calculation of the total fault current as per point 2 of the invention embodiment example,

- calculation of three hypothetical distances to the fault points and three fault resistances assuming that the fault occurred in section LA, section LB and section LC , as per points: 3.1.a - 3.2.a, 3.1.b - 3.4.b, 3.1.c -3.3.c of the invention embodiment example,

- checking whether the particular hypothetical distances are contained in the interval from 0 to 1 in relative units and rejection of those hypothetical distances whose values are negative or bigger than 1, according to point 4 of the invention embodiment example.

- checking whether the fault resistance values are bigger than or equal to zero and rejection of values less than zero, according to point 5 of the invention embodiment example,

- calculation of the impedance of equivalent sources of individual sections assuming that the fault occurred in the given section, as per points 8-13 of the invention embodiment example,

- selection of the correct result, as per point 14 of the invention embodiment example.

The described example applies to a double phase-to-earth fault of the type (a-b-g). Yet this method is analogous for other types of faults. If other types of faults are analysed, the relevant coefficients $a_{F1}$, $a_{F2}, a_{F0}, a_1, a_2, a_0$ change. The values of these coefficients are compiled in tables 1-4. The method for fault location in three-terminal electric power transmission lines according to the present invention covers also other types of faults, i.e. (a-g, b-g, c-g, a-b, b-c, c-a, b-c-g, c-a-g, a-b-c, a-b-c-g).

The inventive method is not restricted to one line model presented in the example of the analysis, but it can apply to another model, not shown in the figure, in which model the presence of series compensating capacitors in the line section with a fault is assumed. In such case the equations (6), (11), (15) applicable to fault loop current will be modified due to the existence of these capacitors.

The inventive method uses synchronous measurements of currents in three stations of the transmission or distribution system, additionally it employs voltage measurement in the station where the fault locator is installed. Such availability of input signals is not considered in other solutions that are currently in use.

The selection of the valid result is based on the aggregation of three criterion quantities: distance to the fault point, fault resistance in the fault point and the module of impedance of equivalent source systems for those stations where voltage is not measured. This third criterion is innovative and has not been known till now.

**An example of the invention embodiment for a multi-terminal power line.**

The transmission or distribution system shown in fig. 14 consists of 1, 2, ..., n electric power stations. Station 1 is at the beginning of the line, the $n^{th}$ station is at the end of the line. Tap points T1, T2, ..T(n-1) divide the transmission system into line sections L1, L2, ..., L(2n-3). In station 1 there is a fault locator FL. Fault location is done using models of faults and fault loops for symmetrical components and taking into consideration different types of faults at the same time, by applying suitable share coefficients determining the relation between the symmetrical components of the total fault current when voltage drop across the fault resistance is estimated, defined as $a_{F1}, a_{F2}$, $a_{F0}$ and weight coefficients $a_1, a_2, a_0$ defining the share of individual components in the total model of a fault loop. The analysis of boundary conditions for different types of faults indicates the existence of a certain degree of freedom at determining share coefficients determining the relation between the symmetrical components of the total fault current when voltage drop across the fault resistance is estimated. Their selection depends on the adopted preference in the use of individual components depending on the type of the fault. In the presented example of the invention embodiment, in order to ensure high precision of fault location, voltage drop across the fault resistance is estimated using:

- the negative component of the total fault current for phase-to-earth faults (a-g), (b-g), (c-g) and phase-to-phase faults (a -b), (b-c) and (c-a),

- the negative component and the zero sequence component for double phase-to-earth faults (a-b-g), (b-c-g), (c-a-g),

- incremental positive-sequence component for three-phase faults (a-b-c, a-b-c-g) for which the fault value is decreased by the pre-fault value of the positive sequence component of current.

The recommended share coefficients determining the relation between the symmetrical components of the total fault current when voltage drop across the fault resistance is estimated are presented in table 5. The type of the fault is denoted by symbols: a-g, b-g, c-g , a-b, b-c, c-a, a-b-g , b-c-g, c-a-g, a-b-c, a-b-c-g where letters a, b, c denote individual phases of the current, and letter g denotes earthing (ground), index 1 denotes the positive-sequence component, index 2 - the negative sequence component, and index 0 - the zero sequence component.

TABLE 5.

| Fault | $\underline{a}_{F1}$ | $\underline{a}_{F2}$ | $\underline{a}_{F0}$ |
|---|---|---|---|
| a-g | 0 | 3 | 0 |
| b-g | 0 | $1.5 + j1.5\sqrt{3}$ | 0 |

(continued)

| Fault | $\underline{a}_{F1}$ | $\underline{a}_{F2}$ | $\underline{a}_{F0}$ |
|---|---|---|---|
| c-g | 0 | $-1.5 - j1.5\sqrt{3}$ | 0 |
| a-b | 0 | $1.5 - j1.5\sqrt{3}$ | 0 |
| b-c | 0 | $j\sqrt{3}$ | 0 |
| c-a | 0 | $-1.5 - j0.5\sqrt{3}$ | 0 |
| a-b-g | 0 | $3 - j\sqrt{3}$ | $j\sqrt{3}$ |
| b-c-g | 0 | $j2\sqrt{3}$ | $j\sqrt{3}$ |
| c-a-g | 0 | $-3 - j\sqrt{3}$ | $j\sqrt{3}$ |
| a-b-c  a-b-c-a | $1.5 + j0.5\sqrt{3}$ | $1.5 - j0.5\sqrt{3}$ *) | 0 |

$)^*$ - due to the lack of the negative component this coefficient may be adopted as = 0

In table 6 there are compiled share coefficients of individual current components $\underline{a}_1, \underline{a}_2, \underline{a}_0$, defining the share of individual components in the total model of the fault loop.

TABLE 6.

| FAULT | $\underline{a}_1$ | $\underline{a}_2$ | $\underline{a}_0$ |
|---|---|---|---|
| a-g | 1 | 1 | 1 |
| b-g | $-0.5 - j0.5\sqrt{3}$ | $0.5 + j0.5\sqrt{3}$ | 1 |
| c-g | $0.5 + j0.5\sqrt{3}$ | $-0.5 - j0.5\sqrt{3}$ | 1 |
| a-b, a-b-g  a-b-c, a-b-c-p | $1.5 + j0.5\sqrt{3}$ | $1.5 - j0.5\sqrt{3}$ | 0 |
| b-c, b-c-g | $-j\sqrt{3}$ | $j\sqrt{3}$ | 0 |
| c-a, c-a-g | $-1.5 + j0.5\sqrt{3}$ | $-1.5 - j0.5\sqrt{3}$ | 0 |

Synchronised measurements of phase currents from all terminal stations of lines 1,2, ..., n and phase voltages only from station 1 are supplied to the fault locator FL. Additionally, it is assumed that information about the type of the fault and the time of its occurrence is supplied to the fault locator. The fault location process assuming that it is a fault of the type (a-b-g) - phase-to-phase-to earth fault is as follows:

**I'. Stage one'**

**1'.** Operation 610. Input current signals from individual lines for fault and pre-fault conditions are measured in stations 1, 2, ..., n. Phase voltages of the line for fault and pre-fault conditions are measured in station 1. Next, symmetrical components of phase currents measured in stations 1, 2, ..., n, and of phase voltages measured in station 1 are calculated.

**2'.** Operation 620. Total fault current ($\underline{I}_F$) is calculated from this equation:

$$\underline{I}_F = \underline{a}_{F1}\underline{I}_{F1} + \underline{a}_{F2}\underline{I}_{F2} + \underline{a}_{F0}\underline{I}_{F0} \tag{24}$$

where :

the first lower index "F" denotes the fault condition, the second lower index "1" denotes the positive sequence component, "2" - the negative sequence component, "0" -the zero sequence component,
$a_{F1}, a_{F2}, a_{F0}$ - the coefficients presented in table 2,

The symmetrical components of total fault current are determined as the sum of individual symmetrical components of currents determined in all terminal stations 1 ,2, ..., n:

$$\underline{I}_{F1} = \underline{I}_{11} + \underline{I}_{21} + \underline{I}_{31} + ... + \underline{I}_{(n-1)1} + \underline{I}_{n1} \tag{25}$$

$$\underline{I}_{F2} = \underline{I}_{12} + \underline{I}_{22} + \underline{I}_{32} + ... + \underline{I}_{(n-1)2} + \underline{I}_{n2} \tag{26}$$

$$\underline{I}_{F0} = \underline{I}_{10} + \underline{I}_{20} + \underline{I}_{30} + ... + \underline{I}_{(n-1)0} + \underline{I}_{n0} \tag{27}$$

where: the first lower index denotes the station, the second lower index denotes:

1 - the positive sequence component, 2 - the negative component, 0 - the zero sequence component.

**II'. Stage two'**

In stage two' a hypothetical fault point is assumed and the distance between the end of the given line and the hypothetical fault point is calculated (actions performed in operations 630a, 630b, 630c, 630d), on the following assumptions:

- calculation of the distance from the beginning of the line to the fault point assuming that the fault occurred in the first line section L1- actions 3.1.a'
- calculation of the distance from the end of the line to the fault point assuming that the fault occurred in the terminal line section L(2n-3) - actions 3.1.b' - 3.3.b'.
- calculation of the distance from the end of the tapped line to the fault point assuming that the fault is located in the $k^{th}$ tapped line - actions 3.1.c' - 3.2.c',
- calculation of the distance from tap point T(k) to the fault point assuming that the fault is located in the line section between two tap points - actions 3.1.d' - 3.3d'.

**3.1.a'.** The voltage and current of the fault loop is determined from the relation between the symmetrical components (fig.2-4), (actions performed in operations 630a):

$$\underline{V}_{1p} = \underline{a}_1\underline{V}_{11} + \underline{a}_2\underline{V}_{12} + \underline{a}_0\underline{V}_{10} \tag{28}$$

$$\underline{I}_{1p} = \underline{a}_1 \underline{I}_{11} + \underline{a}_2 \underline{I}_{12} + \underline{a}_0 \frac{\underline{Z}_{0L1}}{\underline{Z}_{1L1}} \underline{I}_{10} \qquad (29)$$

where:

$\underline{V}_{11}, \underline{V}_{12}, \underline{V}_{10}$ - voltage measured in station 1 (the first lower index) for individual symmetrical components, (the second lower index) i.e. the positive sequence component - index 1, negative component - index 2 and zero sequence component - index 0.

$\underline{I}_{11}, \underline{I}_{12}, \underline{I}_{10}$ - currents measured in station 1 (the first lower index) for individual symmetrical components, (the second lower index) i.e. the positive sequence component - index 1, negative component - index 2 and zero sequence component - index 0.

$\underline{Z}_{1L1}$ - impedance of line section L1 for the positive sequence component,

$\underline{Z}_{0L1}$ - impedance of line section L1 for the zero sequence component,

$a_1, a_2, a_0$ - weight coefficients compiled in table 2.

Fault loop equation has the following form:

$$\underline{V}_{1p} - d_1 \underline{Z}_{1L1} \underline{I}_{1p} - R_{1F} \underline{I}_F = 0 \qquad (30)$$

When the equation (30) has been written out separately for the real part and the imaginary part and further mathematical transformations have been performed, these equations for the searched distance to the fault point (31) and fault resistance (32) are obtained.

$$d_1 = \frac{\text{real}(\underline{V}_{1p})\,\text{imag}(\underline{I}_F) - \text{imag}(\underline{V}_{1p})\,\text{real}(\underline{I}_F)}{\text{real}(\underline{Z}_{1L1}\underline{I}_{1p})\,\text{imag}(\underline{I}_F) - \text{imag}(\underline{Z}_{1L1}\underline{I}_{1p})\,\text{real}(\underline{I}_F)} \qquad (31),$$

$$R_{1F} = \frac{1}{2}\left[\frac{\text{real}(\underline{V}_{1p}) - d_1\,\text{real}(\underline{Z}_{1L1}\underline{I}_{1p})}{\text{real}(\underline{I}_F)} + \frac{\text{imag}(\underline{V}_{1p}) - d_1\,\text{imag}(\underline{Z}_{1L1}\underline{I}_{1p})}{\text{imag}(\underline{I}_F)}\right] \qquad (32),$$

where:

"real" denotes the real part of the given complex quantity,

"imag" denotes the imaginary part of the given complex quantity,

$\underline{V}_{1p}$ - denotes the voltage of the fault loop as per the formula (28)

$\underline{I}_F$ - denotes the total fault current as per the formula (25),

$\underline{Z}_{1L1}$ - denotes the impedance of the line section L1 for the positive sequence component,

$\underline{I}_{1p}$ - denotes the fault loop current determined as per the formula (29).

**3.1.b'.** Voltages for symmetrical components $\underline{V}_{T11}^{\text{transf.}}$, $\underline{V}_{T12}^{\text{transf.}}$, $\underline{V}_{T10}^{\text{transf.}}$ in the first tap point T2 are calculated, (actions performed in operations 630b ):

$$\underline{V}_{T2i}^{\text{transf.}} = \underline{V}_{1i} - \underline{Z}_{iL1} \cdot \underline{I}_{1i}, \qquad (33)$$

where:

$\underline{Z}_{iL1}$ - impedance of section L1 respectively for the positive and negative components and for the zero sequence component.

**3.2.b'** Voltages for symmetrical components $\underline{V}_{T(n-1)1}^{\text{transf.}}$ , $\underline{V}_{T(n-1)2}^{\text{transf.}}$ , $\underline{V}_{T(n-1)0}^{\text{transf.}}$ in the final tap point T(n-1) are calculated (actions performed in operations 630b):

$$\underline{V}_{T(n-1)i}^{\text{transf.}} = \underline{V}_{T(n-2)i}^{\text{transf.}} - \underline{Z}_{iL(2n-5)} \cdot \sum_{\substack{j=1 \\ i=1,2,3}}^{n-2} \underline{I}_{ji} \ , \tag{34}$$

where:

$\underline{Z}_{iL(2n-3)}$ - impedance of line section L(2n-3) respectively for the positive and negative components and for the zero sequence component.

At the same time voltages in the k$^{\text{th}}$ tap point $\underline{V}_{Tk1}^{\text{transf.}}$ , $\underline{V}_{Tk2}^{\text{transf.}}$ , $\underline{V}_{Tk0}^{\text{transf.}}$ are determined from the following formula:

$$\underline{V}_{Tki}^{\text{transf.}} = \underline{V}_{T(k-1)i}^{\text{transf.}} - \underline{Z}_{iL(2k-3)} \cdot \sum_{\substack{j=1 \\ i=1,2,3}}^{k-1} \underline{I}_{ji} \tag{35}$$

where:

$\underline{V}_{T(k-1)i}^{\text{transf.}}$ calculated voltage in point (k-1),

$\underline{Z}_{iL(2k-3)}$ - impedance of line section L(2k-3) for the symmetrical components.

**3.3.b'.** The values of current $\underline{I}_{T(n-1)n1}^{\text{transf.}}$ , $\underline{I}_{T(n-1)n2}^{\text{transf.}}$ , $\underline{I}_{T(n-1)n0}^{\text{transf.}}$ flowing from tap point T(n-1) to station n in line section L(2n-3) are calculated, (actions performed in operations 630b):

$$\underline{I}_{T(n-1)ni}^{\text{transf.}} = \sum_{\substack{i=1,2,0 \\ j=1}}^{n-1} \underline{I}_{ji} \ , \tag{36}$$

Fault loop equation has the following form:

$$\underline{V}_{T(n-1)np} - (1 - d_{(2n-3)})\underline{Z}_{1L(2n-3)}\underline{I}_{T(n-1)np} - R_{(2n-3)F}\underline{I}_F = 0 \tag{37}$$

where:

$$\underline{V}_{T(n-1)np} = \underline{a}_1 \underline{V}_{T(n-1)1}^{\text{transf.}} + \underline{a}_2 \underline{V}_{T(n-1)2}^{\text{transf.}} + \underline{a}_0 \underline{V}_{T(n-1)0}^{\text{transf.}} \tag{37a}$$

$$\underline{I}_{T(n-1)np} = \underline{a}_1 I^{\text{transf.}}_{T(2n-1)n1} + \underline{a}_2 I^{\text{transf.}}_{T(n-1)n2} + \underline{a}_0 \frac{\underline{Z}_{0L(2n-3)}}{\underline{Z}_{1L(2n-3)}} I^{\text{transf.}}_{T(n-1)n0} \qquad (37b)$$

When the equation (37) has been written out separately for the real part and the imaginary part and further mathematical transformations have been performed, solutions for the searched distance to the fault point $d_{(2n-3)}$ (38) and fault resistance $R_{(2n-3)B}$ (39) are obtained:

$$d_{(2n-3)} = \frac{-\text{real}(\underline{V}_{T(n-1)np} - \underline{Z}_{1L(2n-3)}\underline{I}_{T(n-1)np})\,\text{imag}(\underline{I}_F) + \text{imag}(\underline{V}_{T(n-1)np} - \underline{Z}_{1L(2n-3)}\underline{I}_{T(n-1)np})\,\text{real}(\underline{I}_F)}{\text{real}(\underline{Z}_{1L(2n-3)}\underline{I}_{T(n-1)np})\,\text{imag}(\underline{I}_F) - \text{imag}(\underline{Z}_{1L(2n-3)}\underline{I}_{T(n-1)np})\,\text{real}(\underline{I}_F)} \qquad (38),$$

$$R_{(2n-3)F} = \frac{1}{2}\left[\frac{\text{real}(\underline{V}_{T(n-1)np}) - (1-d_{(2n-3)})\cdot real(\underline{Z}_{1L(2n-3)}\underline{I}_{T(n-1)np})}{\text{real}(\underline{I}_F)}\right] + \\ + \frac{1}{2}\left[\frac{\text{imag}(\underline{V}_{T(n-1)np}) - (1-d_{(3n-3)})\cdot imag(\underline{Z}_{1(2n-3)}\underline{I}_{T(n-1)np})}{\text{imag}(\underline{I}_F)}\right] \qquad (39),$$

where:

$\underline{Z}_{1L(2n-3)}$ - impedance of line section L(2n-3) for the positive sequence component,
$\underline{Z}_{0L(2n-3)}$ - impedance of line section L(2n-3) for the zero sequence component.

**3.1.c'.** Voltages for symmetrical components $\underline{V}^{\text{transf.}}_{Tk1}$, $\underline{V}^{\text{transf.}}_{Tk2}$, $\underline{V}^{\text{transf.}}_{Tk0}$ in the $k^{\text{th}}$ tap point Tk are calculated from the formula (35) assuming as k the number of the considered station equal to the number of the tap point Tk from which the line in which we consider the fault goes to station k (actions performed in operations 630c).

**3.2.c'.** The values of current $\underline{I}^{\text{transf.}}_{Tkk1}$, $\underline{I}^{\text{transf.}}_{Tkk2}$, $\underline{I}^{\text{transf.}}_{Tkk0}$ flowing from tap point Tk to $k^{\text{th}}$ station in tapped line section L(2k-2) are calculated (actions performed in operations 630c):

$$\underline{I}^{\text{transf}}_{Tkki} = \sum_{\substack{i=1,2,3 \\ j=1, j\neq k}}^{n} \underline{I}_{ji} \ , \qquad (40)$$

Fault loop equation has the following form:

$$\underline{V}_{Tkkp} - (1-d_{(2k-2)})\underline{Z}_{1L(2k-2)}\underline{I}_{Tkkp} - R_{(2k-2)k}\underline{I}_F = 0 \qquad (41)$$

where:

$$\underline{V}_{Tkkp} = \underline{a}_1 \underline{V}^{\text{transf.}}_{Tkk1} + \underline{a}_2 \underline{V}^{\text{transf.}}_{Tkk2} + \underline{a}_0 \underline{V}^{\text{transf.}}_{Tkk0} \qquad (41a)$$

$$\underline{I}_{\text{Tkkp}} = \underline{a}_1 \underline{I}_{\text{Tkk1}}^{\text{transf.}} + \underline{a}_2 \underline{I}_{\text{Tkk2}}^{\text{transf.}} + \underline{a}_0 \frac{\underline{Z}_{0L(2k-2)}}{\underline{Z}_{1L(2k-2)}} \underline{I}_{\text{Tkk0}}^{\text{transf.}} \qquad (41b)$$

When the equation (40) has been written out separately for the real part and the imaginary part and further mathematical transformations have been performed, solutions for the searched distance to the fault point $d_{(2k-2)}$ (42) and fault resistance $R_{(2k-2)F}$ (43) are obtained:

$$d_{(2k-2)} = \frac{-\text{real}(\underline{V}_{\text{Tkkp}} - \underline{Z}_{1L(2k-2)}\underline{I}_{\text{Tkkp}})\,\text{imag}(\underline{I}_F) + \text{imag}(\underline{V}_{\text{Tkkp}} - \underline{Z}_{1L(2k-2)}\underline{I}_{\text{Tkkp}})\,\text{real}(\underline{I}_F)}{\text{real}(\underline{Z}_{1L(2k-2)}\underline{I}_{\text{Tkkp}})\,\text{imag}(\underline{I}_F) - \text{imag}(\underline{Z}_{1L(2k-2)}\underline{I}_{\text{Tkkp}})\,\text{real}(\underline{I}_F)} \qquad (42),$$

$$R_{(2k-2)F} = \frac{1}{2}\left[\frac{\text{real}(\underline{V}_{\text{Tkkp}}) - (1 - d_{(2k-2)}) \cdot real(\underline{Z}_{1L(2k-2)}\underline{I}_{\text{Tkkp}})}{\text{real}(\underline{I}_F)}\right] +$$
$$+ \frac{1}{2}\left[\frac{\text{imag}(\underline{V}_{\text{Tkkp}}) - (1 - d_{(2k-2)}) \cdot imag(\underline{Z}_{1L(2k-2)}\underline{I}_{\text{Tkkp}})}{\text{imag}(\underline{I}_F)}\right] \qquad (43)$$

where:

$\underline{Z}_{1L(2k-2)}$ - impedance of line section L(2k-2) for the positive sequence component,
$\underline{Z}_{0L(2k-2)}$ - impedance of line section L(2k-2) for the zero sequence component.

**3.1.d'.** Voltages for symmetrical components $\underline{V}_{\text{Tk1}}^{\text{transf.}}$ , $\underline{V}_{\text{Tk2}}^{\text{transf.}}$ , $\underline{V}_{\text{Tk0}}^{\text{transf.}}$ in the $k^{\text{th}}$ tap point Tk are calculated from the formula (35), (actions performed in operations 630d ).

**3.2.d'.** The values of current $\underline{I}_{\text{TkT(k+1)1}}^{\text{transf.}}$ , $\underline{I}_{\text{TkT(k+1)2}}^{\text{transf.}}$ , $\underline{I}_{\text{TkT(k+1)0}}^{\text{transf.}}$ flowing from tap point Tk to tap point T(k+1) in the line section are calculated (actions performed in operations 630d ):

$$\underline{I}_{\text{TkT(k+1)i}}^{\text{transf.}} = \sum_{\substack{i=1,2,0 \\ j=1}}^{k-1} \underline{I}_{ji} \, , \qquad (44)$$

Fault loop equation has the following form:

$$\underline{V}_{\text{TkT(k+1)p}} - (1 - d_{(k+1)})\underline{Z}_{1L(2k-1)}\underline{I}_{\text{TkT(k+1)p}} - R_{(2k-1)E}\underline{I}_F = 0 \qquad (45)$$

where:

$$\underline{V}_{\text{TkT(k+1)p}} = \underline{a}_1 \underline{V}_{\text{Tk1}}^{\text{transf.}} + \underline{a}_2 \underline{V}_{\text{Tk2}}^{\text{transf.}} + \underline{a}_0 \underline{V}_{\text{Tk0}}^{\text{transf.}} \qquad (45a)$$

$$\underline{I}_{\text{TkT}(k+1)p} = \underline{a}_1 \underline{I}_{\text{TkT}(k+1)1}^{\text{transf.}} + \underline{a}_2 \underline{I}_{\text{TkT}(k+1)2}^{\text{transf.}} + \underline{a}_0 \frac{\underline{Z}_{0L(k+1)}}{\underline{Z}_{1L(k+1)}} \underline{I}_{\text{TkT}(k+1)0}^{\text{transf.}} \tag{45b}$$

When the equation (45) has been written out separately for the real part and the imaginary part and further mathematical transformations have been performed, equations for the searched distance to the fault point $d_{(2k-1)}$ (46) and fault resistance $R_{(2k-1)F}$ (47) are obtained:

$$d_{(2k-1)} = \frac{-\operatorname{real}(\underline{V}_{\text{TkT}(k+1)p} - \underline{Z}_{1L(2k-1)}\underline{I}_{\text{TkT}(k+1)p})\operatorname{imag}(\underline{I}_F) + \operatorname{imag}(\underline{V}_{\text{TkT}(k+1)p} - \underline{Z}_{1L(2k-1)}\underline{I}_{\text{TkT}(k+1)p})\operatorname{real}(\underline{I}_F)}{\operatorname{real}(\underline{Z}_{1L(2k-1)}\underline{I}_{\text{TkT}(k+1)p})\operatorname{imag}(\underline{I}_F) - \operatorname{imag}(\underline{Z}_{1L(2k-1)}\underline{I}_{\text{TkT}(k+1)p})\operatorname{real}(\underline{I}_F)}$$

$$\tag{46},$$

$$R_{(2k-1)F} = \frac{1}{2}\left[\frac{\operatorname{real}(\underline{V}_{\text{TkT}(k+1)p}) - (1-d_{(2k-1)})\cdot\operatorname{real}(\underline{Z}_{1L(2k-1)}\underline{I}_{\text{TkT}(k+1)p})}{\operatorname{real}(\underline{I}_F)}\right] +$$
$$+ \frac{1}{2}\left[\frac{\operatorname{imag}(\underline{V}_{\text{TkT}(k+1)p}) - (1-d_{(2k-1)})\cdot\operatorname{imag}(\underline{Z}_{1L(2k-1)}\underline{I}_{\text{TkT}(k+1)p})}{\operatorname{imag}(\underline{I}_F)}\right] \tag{47},$$

where:

$\underline{Z}_{1L(2k-1)}$ - impedance of line section L(2k-1) for the positive sequence component,
$\underline{Z}_{0L(2k-1)}$ - impedance of line section L(2k-1) for the zero sequence component.
k- number of the tap point

**III'. Stage three'**

In this stage the selection of the final results is done (actions performed in operations 640a, 640b, 640c, 640d).

4'. It is checked whether the results of the calculation of the distance $d_1$ , $d_{(2n-3)}$, $d_{(2k-2)}$, $d_{(2k-1)}$, to the fault point are contained within the interval $(0 \div 1)$ in relative units:

$0 \le d_1 \le 1$, $0 \le d_{(2n-3)} \le 1$, $0 \le d_{(2k-2)} \le 1$, $0 \le d_{(2k-1)} \le 1$, and it is checked whether the results of the calculation of fault resistance $R_{1F}$, $R_{(2n-3)F}$, $R_{(2k-2)F}$ $R_{(2k-1)F}$, for the calculated fault points $d_1$, $d_{(2n-3)}$, $d_{(2k-2)}$, $d_{(2k-1)}$ are bigger than or equal to zero. The pairs of results: resistance-distance, e.g.: $d_1$, $R_{1F}$ which are not contained within the given intervals indicate that they were calculated on a false pre-assumption concerning the place of occurrence of the fault on the given line section. These results shall be discarded. The other results undergo further treatment except the case where only one pair is within the given interval. These results are final, i.e. they indicate the fault location and the fault resistance at the fault point (Operation 650).

5'. If the analysis of the criteria performed as in actions 4' does not provide an explicit conclusion about which values define the place and resistance of the fault then, in subsequent actions, equivalent source impedance for the negative component is calculated for these faults: phase-to-earth, phase-to-phase, double phase-to-earth or alternatively for the incremental positive sequence component. For three-phase faults, the impedance of equivalent source systems is calculated for the incremental positive sequence component. (Actions performed in operations 660a, 660b, 660c, 660d).

7'. Total fault current $\underline{I}_{F2}$ for the negative sequence component is calculated from the following formula (actions performed in operations 660a),

$$\underline{I}_{F2} = \sum_{j=1}^{n} \underline{I}_{j2}$$

(48)

8'. Equivalent source impedance $(Z_{2S1})$ is calculated assuming that the fault is located in line section L1, (actions performed in operations 660a):

$$(\underline{Z}_{2S1}) = \frac{-\underline{V}_{12}}{\underline{I}_{12}},$$

(49)

9'. Equivalent source impedance $(\underline{Z}_{2S(n)})$ is calculated assuming that the fault is located in the final line section L(2n-3), (actions performed in operations 660b):

$$(\underline{Z}_{2Sn}) = -\frac{\underline{V}_{n2}}{\underline{I}_{n2}}$$

(50)

where:

$$\underline{V}_{n2} = \underline{V}_{T(n-1)2}^{transf.} - (1 - d_{(2n-3)}) \cdot \underline{Z}_{2L(2n-3)} \cdot \underline{I}_{T(n-1)n2}^{transf.} - d_{(2n-3)} \cdot \underline{Z}_{2L(2n-3)} \cdot (\underline{I}_{T(n-1)n2}^{transf.} - \underline{I}_{F2})$$

(51)

10'. Impedance of $k^{th}$ equivalent source $(\underline{Z}_{2Sk})$ is calculated assuming that the fault is located in tapped line section L(2k-2), (actions performed in operations 660c):

$$(\underline{Z}_{2Sk}) = -\frac{\underline{V}_{k2}}{\underline{I}_{k2}}$$

(52)

where:

$$\underline{V}_{k2} = \underline{V}_{Tk2}^{transf.} - (1 - d_{(2k-2)}) \cdot \underline{Z}_{2L(2k-2)} \cdot \underline{I}_{Tkk2}^{transf.} - d_{(2k-2)} \cdot \underline{Z}_{2L(2k-2)} \cdot (\underline{I}_{Tkk2}^{transf.} - \underline{I}_{F2})$$

(53)

11'. Impedance of equivalent sources $(Z_{2Sk})$ and $(Z_{2S(k+1)})$ is calculated on the assumption that the fault is located in the line section between two tap points Tk - T(k+1), (actions performed in operations 660d):

$$(\underline{Z}_{2Sk}) = -\frac{\underline{V}_{k2}}{\underline{I}_{k2}}$$

(54)

where:

$$\underline{V}_{k2} = \underline{V}_{Tk2}^{\text{transf.}} - d_{(2k-1)} \cdot \underline{Z}_{2L(2k-1)} \cdot \underline{I}_{TkT(k+1)2}^{\text{transf.}} - (1 - d_{(2k-1)}) \cdot \underline{Z}_{2L(2k-1)} \cdot (\underline{I}_{TkT(k+1)2}^{\text{transf.}} - \underline{I}_{F2}) + \underline{Z}_{2Lk}\underline{I}_{k2} \quad (55)$$

$$(\underline{Z}_{2S(k+1)}) = -\frac{\underline{V}_{(k+1)2}}{\underline{I}_{(k+1)2}} \quad (56)$$

where:

$$\underline{V}_{(k+1)2} = \underline{V}_{Tk2}^{\text{transf.}} - d_{(2k-1)} \cdot \underline{Z}_{2L(2k-1)} \cdot \underline{I}_{TkT(k+1)2}^{\text{transf.}} - (1 - d_{(2k-1)}) \cdot \underline{Z}_{2L(2k-1)} \cdot (\underline{I}_{TkT(k+1)2}^{\text{transf.}} - \underline{I}_{F2}) + \underline{Z}_{2L(2k)}\underline{I}_{(k+1)2}$$

$$(57)$$

12'. It is checked (actions performed in operations 670a, 670b, 670c, 670d) whether the calculated equivalent source impedances $(\underline{Z}_{2S1})$, $(\underline{Z}_{2Sn})$, $(\underline{Z}_{2SC})_{\text{SUB\_C}}$, $(\underline{Z}_{2Sk})$, $(\underline{Z}_{2S(k+1)})$ are contained in the interval in the first quadrant of the complex plane $\underline{Z}$, that is, whether both the real and the imaginary part of the calculated impedance is greater than zero. The impedance of equivalent source systems is determined for the negative component for occurrence of the faults: phase-to-earth, phase-to-phase, double phase-to-earth or alternatively for the incremental positive sequence component. For three-phase faults the impedance of equivalent source systems is calculated for the incremental positive sequence component. Results which are not contained within the first quadrant suggest that they were calculated on a false pre-assumption concerning the location of the fault on the given line section and the result of the calculation of the distance to the fault point made on that assumption is rejected. The remaining results undergo further treatment except the case where only one impedance calculated on the assumption that the fault occurred in the given line section is contained in the first quadrant. The result of the calculation of the distance to the fault point for that impedance indicates a correct pre-assumption. This result is considered final (actions performed in operation 680).

13'. If the criteria analysis performed as in action 12' does not provide an explicit conclusion about which values define the location of the fault, then, in subsequent actions (actions performed in operations 690a, 690b, 690c, 690d), the calculated equivalent source impedances are transformed into a modular form, whereupon the correct result is selected on the basis of the equivalent source impedance module.

14'. Operation 700. If the calculated value of the equivalent source system impedance module, assuming the occurrence of the fault on the given line section, does not correspond to the real value of the source system impedance module, this means that the preliminary data concerning the fault location in the given section have been assumed falsely and the result of the calculation of the distance to the fault point based on this assumption is rejected. If the calculated value of the equivalent source system impedance module, assuming the occurrence of the fault on the given line section, corresponds to the real value of the module of impedance of the source system, then the result of the calculation of the distance to the fault confirms the correct pre-assumption and this result is considered final.

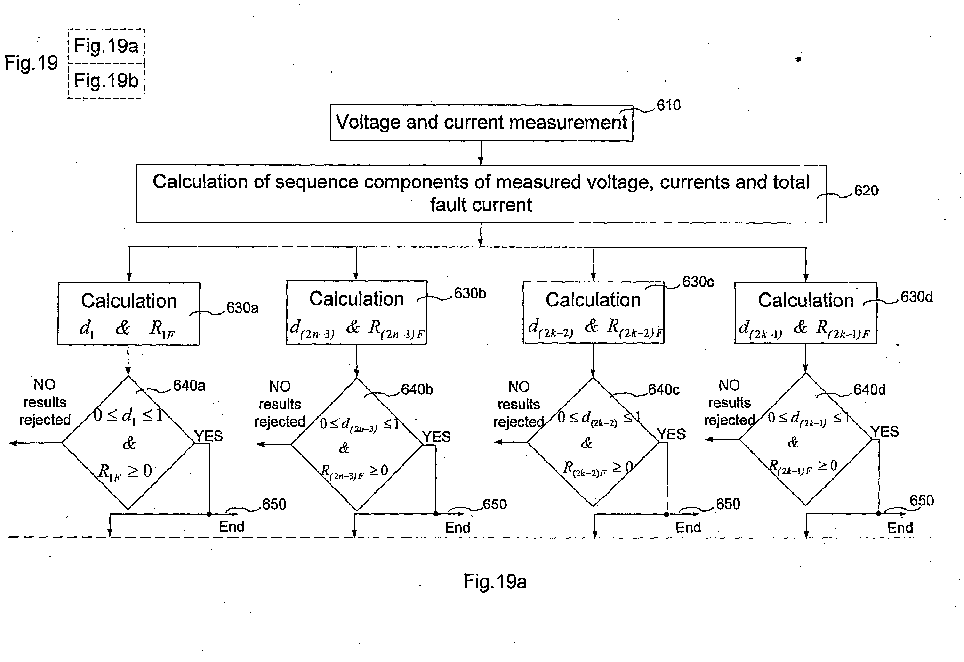

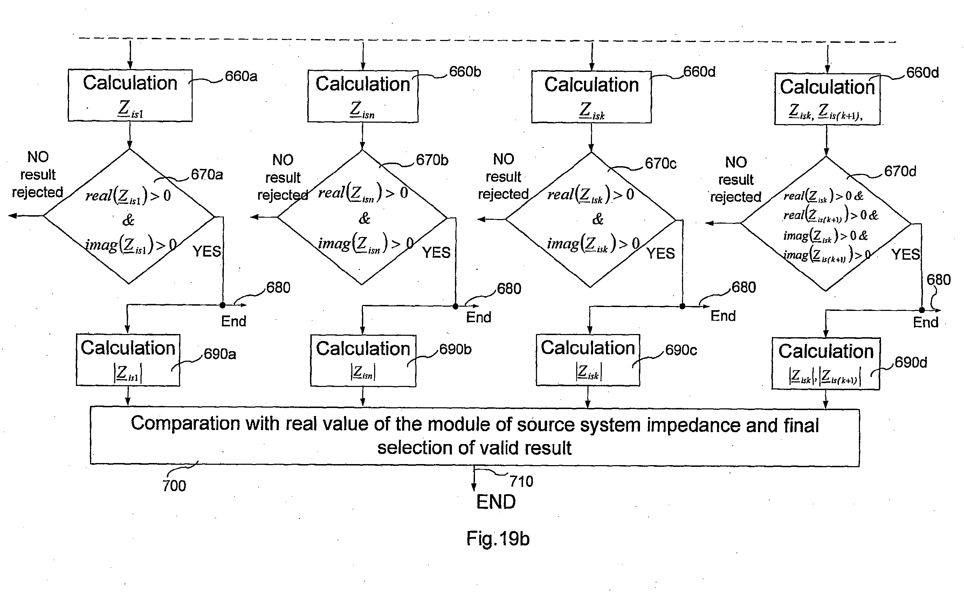

The network of actions shown in fig. 19 includes the following actions for the implementation of the invention:

- measurement of currents and voltages according to point 1' of the invention embodiment example,

- determination of the symmetrical components of measured currents and voltages and calculation of the total fault current according to point 2' of the invention embodiment example,

- calculation of the consecutive hypothetical distances to the fault points and the fault resistance assuming that the fault is located in the first line section L1, the terminal line section L(2n-3), sections of tapped lines (2k-2) and sections between consecutive tap point (2k-1), according to points: 3.1.a' - 3.2.a', 3.1.b' - 3.4.b', 3.1.c' -3.3.c', 3.1.d' -3.3.d' of the invention embodiment example

- checking whether the particular hypothetical distances are contained in the interval from 0 to 1 in relative units and rejection of those hypothetical distances whose values are negative or bigger than 1, according to point 4 of the example embodiment of the invention.

- checking whether the values of the fault resistance are bigger than or equal to zero and rejection of values less than zero, according to point 5' of the invention embodiment example,

- calculation of the impedance of equivalent sources of individual sections assuming that the fault is located in the given section, as per points 8'-11' of the invention embodiment example,

- selection of the correct result, according to point 12' of the invention embodiment example by rejecting those hypothetical distances for which impedances of calculated equivalent sources are not within the first quadrant of the complex system of co-ordinates,

- selection of the final result according to point 14' of the invention embodiment example, by rejecting those hypothetical distances for which the calculated value of the module of impedance of equivalent source systems does not correspond to the real value of the module of the equivalent source system.

The described example refers to a double phase-to-earth fault of the type (a-b-g). Yet this method is analogous for other types of faults. If other types of faults are analysed, the relevant coefficients $a_{F1}, a_{F2}, a_{F0}, a_1, a_2, a_0$ change. The values of these coefficients are compiled in tables 5-6. The method for fault location in multi-terminal electric power transmission lines according to the present invention covers also other types of faults i.e. (a-g, b-g, c-g, a-b, b-c, c-a, b-c-g, c-a-g, a-b-c, a-b-c-g).

The inventive method is not restricted to one line model presented in the example of the analysis, but it can apply to another model, not shown, in the figure, e.g. a long line model. In such case the equations (33-57) will be modified.

The inventive method uses synchronous measurements of currents in all stations of the transmission or distribution system, additionally it uses voltage measurement in the station where the fault locator is installed.

The selection of the valid result is based on the aggregation of the three calculated criterion-type quantities: distance to the fault point, fault resistance in the fault point and impedance of equivalent source systems for those stations where voltage measurement is not done. This third criterion is a two-stage one, i.e. first it is checked whether the determined impedances of equivalent source systems are in the first quadrant of the complex plane $\underline{Z}$ and then their modules are determined. This first element of the third criterion is innovative and has not been known till now. Its advantage is that knowledge of the equivalent source system impedance is not required for its implementation. Therefore, inaccurate knowledge of these impedances, which is normal in practice, is of no consequence.

**Claims**

1. A method for fault location in electric power lines, in which division of the transmission or distribution system line into sections is used, **characterised in that:**

   - current for fault condition and pre-fault condition is measured in all terminal stations of the system,
   - the line phase voltage for fault and pre-fault conditions is measured in one terminal station of the system,
   - symmetrical components of the measured current and voltage signals and the total fault current in the fault point are calculated,
   - a hypothetical location of the fault is assumed in one of the line sections,
   - the first hypothetical fault point located in the line section between the beginning of the line and the first tap point, the second hypothetical fault point located in the line section between the end of the line and the last tap point, and a consecutive hypothetical fault point located in each line branch connected to the line is assumed, while for multi-terminal lines, having more than three terminals, the consecutive hypothetical fault point located in each line section between two consecutive tap points is additionally assumed,
   - the distance from the beginning of the line to the fault point in the section between the beginning of the line and the first tap point, the distance from the end of the line to the fault point in the section between the end of the line and the last tap point, the distance from the end of the tapped line to the fault point located in each of branches are calculated, while for a multi-terminal lines the distance from the tap point to the fault point located in each of the line section between two tap points is calculated and then for all hypothetical fault points in each section fault resistance is calculated,
   - the actual fault point location is selected first by comparing the numerical values concerning the previously determined distances and rejecting the results whose numerical values are negative or bigger than 1 in relative units and then by analysing the values of the calculated fault resistances for fault points and rejecting those results of the calculations for which the value of fault resistance is negative, and if it is found that only one numerical value concerning the distance is contained in the numerical interval between zero and one in relative units and the value of calculated fault resistance for this distance to the fault point is positive or equal to zero, then these results are final and they indicate the actual distance to the fault point and the value of fault resistance in the fault point,

- if, after the selection of the actual fault point it turns out that at least two numerical values concerning the previously calculated distances are contained within the numerical interval from zero to one in relative units and the values of the calculated fault resistances for these fault points are positive or equal to zero, then impedance modules or impedances of equivalent source systems for the negative sequence component for phase-to-ground faults, phase-to-phase faults, and double phase-to-ground faults or for the incremental positive sequence component for three-phase faults are determined, assuming that the fault occurred in a definite sections, whereas for multi-terminal lines during the impedance determination it is additionally verified whether the calculated values of the impedance of equivalent source systems are contained in the first quadrant of the Cartesian co-ordinate system for the complex plain and these distances to fault points are rejected for which impedance values are not contained in this quadrant of the system, and if it turns out that only one value of the impedance of the equivalent source system concerning distance is contained in the first quadrant of the system, then the result of the calculation of the distance to the fault point, for this impedance, is considered to be final, whereas if it turns out that at least two values of the impedance of equivalent source systems concerning distance are contained in the first quadrant of the system, then the modules of these impedances are utilized in the next step,

the distance for which the value of the module of the equivalent source impedance is nearest to the realistic values really determining the system load or supply is considered to be the final result.

2. **A method according to claim 1, characterised in that** the calculation of the total fault current is done taking into account the share coefficients determining the relation between the symmetrical components of the total fault current when the voltage drop across the fault resistance is estimated, a specially determined set of these coefficients being used for that operation.

3. **A method according to claim 1, characterised in that** for double phase-to-earth faults the positive component is eliminated in the estimation of the total fault current, and for the negative and zero components the following values of the share coefficients determining the relation between the symmetrical components of the total fault current when voltage drop across the fault resistance is estimated are assumed:

$$\underline{a}_{F1} = 0 \text{ ,}$$

$$\underline{a}_{F2} = \underline{a}_{F2}^{init.} - \frac{\underline{a}_{F1}^{init.} \, \underline{b}_{F2}}{\underline{b}_{F1}} \text{ ,}$$

$$\underline{a}_{F0} = \frac{\underline{a}_{F1}^{init.}}{\underline{b}_{F1}}$$

where :

$\underline{a}_{F1}^{init.}$ , $\underline{a}_{F2}^{init.}$ , $\underline{a}_{F0}^{init.}$ denote the initial share coefficients determining the relation between the symmetrical components of the total fault current when voltage drop across the fault resistance is estimated,

$b_{F1}$, $b_{F2}$ - denote relation share coefficients, determined from the relation between the zero component and the other components of the total fault current flowing through the fault resistance.

4. **A method according to claim 1, characterised in that** for three-terminal power lines, the distances form the beginning of the line to fault point $d_A$, from the end of the line to fault point $d_B$, from the end of the tapped line to fault point $d_C$ are determined from the following equations:

$$d_{\mathrm{A}} = \frac{\mathrm{real}(\underline{V}_{\mathrm{Ap}})\mathrm{imag}(\underline{I}_{\mathrm{F}}) - \mathrm{imag}(\underline{V}_{\mathrm{Ap}})\mathrm{real}(\underline{I}_{\mathrm{F}})}{\mathrm{real}(\underline{Z}_{\mathrm{1LA}}\underline{I}_{\mathrm{Ap}})\mathrm{imag}(\underline{I}_{\mathrm{F}}) - \mathrm{imag}(\underline{Z}_{\mathrm{1LA}}\underline{I}_{\mathrm{Ap}})\mathrm{real}(\underline{I}_{\mathrm{F}})} \ ,$$

$$d_{\mathrm{B}} = \frac{-\mathrm{real}(\underline{V}_{\mathrm{Tp}} - \underline{Z}_{\mathrm{1LB}}\underline{I}_{\mathrm{TBp}})\mathrm{imag}(\underline{I}_{\mathrm{F}}) + \mathrm{imag}(\underline{V}_{\mathrm{Tp}} - \underline{Z}_{\mathrm{1LB}}\underline{I}_{\mathrm{TBp}})\mathrm{real}(\underline{I}_{\mathrm{F}})}{\mathrm{real}(\underline{Z}_{\mathrm{1LB}}\underline{I}_{\mathrm{TBp}})\mathrm{imag}(\underline{I}_{\mathrm{F}}) - \mathrm{imag}(\underline{Z}_{\mathrm{1LB}}\underline{I}_{\mathrm{TBp}})\mathrm{real}(\underline{I}_{\mathrm{F}})} \ ,$$

$$d_{\mathrm{C}} = \frac{-\mathrm{real}(\underline{V}_{\mathrm{Tp}} - \underline{Z}_{\mathrm{1LC}}\underline{I}_{\mathrm{TCp}})\mathrm{imag}(\underline{I}_{\mathrm{F}}) + \mathrm{imag}(\underline{V}_{\mathrm{Tp}} - \underline{Z}_{\mathrm{1LC}}\underline{I}_{\mathrm{TCp}})\mathrm{real}(\underline{I}_{\mathrm{F}})}{\mathrm{real}(\underline{Z}_{\mathrm{1LC}}\underline{I}_{\mathrm{TCp}})\mathrm{imag}(\underline{I}_{\mathrm{F}}) - \mathrm{imag}(\underline{Z}_{\mathrm{1LC}}\underline{I}_{\mathrm{TCp}})\mathrm{real}(\underline{I}_{\mathrm{F}})} \ ,$$

where:

"real" denotes the real part of the given quantity,
"imag" denotes the imaginary part of the given quantity,
$V_{\mathrm{Ap}}$ - denotes the fault loop voltage determined assuming that the fault occurred in section LA,
$\underline{V}_{\mathrm{Tp}}$ - denotes the fault loop voltage determined assuming that the fault occurred in section LB or LC,
$\underline{I}_{\mathrm{Ap}}$ - denotes the fault loop current determined assuming that the fault occurred in section LA,
$\underline{I}_{\mathrm{TBp}}$ - denotes the fault loop current determined assuming that the fault occurred in section LB,
$\underline{I}_{\mathrm{TCp}}$ - denotes the fault loop current determined assuming that the fault occurred in line section LC,
$\underline{I}_{\mathrm{F}}$ - denotes total fault current,
$\underline{Z}_{\mathrm{1LA}} = \underline{R}_{\mathrm{1LA}} + j\omega_1 L_{\mathrm{1LA}}$ - denotes impedance of the line section LA for the positive sequence,
$\underline{Z}_{\mathrm{1LB}} = R_{\mathrm{1LB}} + j\omega_1 L_{\mathrm{1LB}}$ - denotes impedance of the line section LB for the positive sequence,
$\underline{Z}_{\mathrm{1LC}} = R_{\mathrm{1LC}} + j\omega_1 L_{\mathrm{1LC}}$ - denotes impedance of the line section LC for the positive sequence,
$R_{\mathrm{1LA}}, R_{\mathrm{1LB}}, R_{\mathrm{1LC}}$ - resistance for the positive sequence for line sections LA, LB, LC, respectively,
$L_{\mathrm{1LA}}, L_{\mathrm{1LB}}, L_{\mathrm{1LC}}$ - inductance for the positive sequence for line sections LA, LB, LC, respectively,
$\omega_1$ - pulsation for the fundamental frequency.

5. **A method according to claim 1, characterised in that** for three-terminal power lines, the fault resistance $R_{\mathrm{FA}}$, $R_{\mathrm{FB}}$, $R_{\mathrm{FC}}$ is determined from the following equations:

$$R_{\mathrm{FA}} = \frac{1}{2}\left[\frac{\mathrm{real}(\underline{V}_{\mathrm{Ap}}) - d_{\mathrm{A}}\mathrm{real}(\underline{Z}_{\mathrm{1LA}}\underline{I}_{\mathrm{Ap}})}{\mathrm{real}(\underline{I}_{\mathrm{F}})} + \frac{\mathrm{imag}(\underline{V}_{\mathrm{Ap}}) - d_{\mathrm{A}}\mathrm{imag}(\underline{Z}_{\mathrm{1LA}}\underline{I}_{\mathrm{Ap}})}{\mathrm{imag}(\underline{I}_{\mathrm{F}})}\right] ,$$

$$R_{\mathrm{FB}} = \frac{1}{2}\left[\frac{\mathrm{real}(\underline{V}_{\mathrm{Tp}}) - (1 - d_{\mathrm{B}})\cdot\mathrm{real}(\underline{Z}_{\mathrm{1LB}}\underline{I}_{\mathrm{TBp}})}{\mathrm{real}(\underline{I}_{\mathrm{F}})}\right] + \frac{1}{2}\left[\frac{\mathrm{imag}(\underline{V}_{\mathrm{Tp}}) - (1 - d_{\mathrm{B}})\cdot\mathrm{imag}(\underline{Z}_{\mathrm{1LB}}\underline{I}_{\mathrm{TBp}})}{\mathrm{imag}(\underline{I}_{\mathrm{F}})}\right]$$

$$R_{\mathrm{FC}} = \frac{1}{2}\left[\frac{\mathrm{real}(\underline{V}_{\mathrm{Tp}}) - (1 - d_{\mathrm{C}})\cdot\mathrm{real}(\underline{Z}_{\mathrm{1LC}}\underline{I}_{\mathrm{TCp}})}{\mathrm{real}(\underline{I}_{\mathrm{F}})}\right] + \frac{1}{2}\left[\frac{\mathrm{imag}(\underline{V}_{\mathrm{Tp}}) - (1 - d_{\mathrm{C}})\cdot\mathrm{imag}(\underline{Z}_{\mathrm{1LC}}\underline{I}_{\mathrm{TCp}})}{\mathrm{imag}(\underline{I}_{\mathrm{F}})}\right]$$

where:

"real" denotes the real part of the given quantity,

"imag" denotes the imaginary part of the given quantity,

$\underline{V}_{Ap}$ - denotes the fault loop voltage calculated assuming that the fault occurred in section LA,

$\underline{V}_{Tp}$ - denotes the fault loop voltage calculated assuming that the fault occurred in section LB or LC,

$\underline{I}_{Ap}$ - denotes the fault loop current calculated assuming that the fault occurred in section LA,

$\underline{I}_{TBp}$ - denotes the fault loop current calculated assuming that the fault occurred in section LB,

$\underline{I}_{TCp}$ denotes the fault loop current calculated assuming that the fault occurred in line section LC,

$\underline{I}_F$ - denotes the total fault current,

$\underline{Z}_{1LA} = R_{1LA} + j\omega_1 L_{1LA}$ - denotes impedance of the line section LA for the positive sequence,

$\underline{Z}_{1LB} = R_{1LB} + j\omega_1 L_{1LB}$ - denotes impedance of the line section LB for the positive sequence,

$\underline{Z}_{1LC} = R_{1LC} + j_{\omega1} L_{1LC}$ - denotes impedance of the line section LC for the positive sequence,

$R_{1LA}$, $R_{1LB}$, $R_{1LC}$ - resistance for the positive sequence for line sections LA, LB, LC, respectively,

$L_{1LA}$, $L_{1LB}$, $L_{1LC}$ - inductance for the positive sequence for line sections LA, LB, LC, respectively,

$\omega_1$ - pulsation for the fundamental frequency.

$d_A$ - denotes the distance from the beginning of the line to the fault point,

$d_B$ - denotes the distance from the end of the line to the fault point,

$d_C$ - denotes the distance from the end of the tapped line to the fault point.

6.  **A method according to claim 1, characterised in that** for three-terminal power lines, the equivalent source impedance for the negative sequence component $((\underline{Z}_{2SB})_{SUB\_A})$ and for the incremental positive sequence component $((\underline{Z}_{\Delta1SB})_{SUB\_A})$ are calculated assuming that the fault occurred in LA line section, as per this equation:

$$(\underline{Z}_{iSB})_{SUB\_A} = \frac{\underline{G}_{iA}\underline{I}_{A2} - \underline{H}_{iA}\underline{I}_{FAi}}{\underline{Q}_{BCi}(\underline{I}_{FAi} - \underline{I}_{Ai})},$$

where :

the lower index $i$ takes on values $i = 2$ for the negative sequence, $i = \Delta1$ for the incremental positive sequence component,

$\underline{G}_{iA}$ - denotes the first analytical coefficient for the negative sequence component, determined from the analysis of an equivalent circuit diagram of the system as shown in fig. 11 and/or for the incremental positive sequence component analytically determined from the equivalent circuit diagram of the system as shown in fig. 12,

$\underline{I}_{Ai}$ - denotes the negative and/or incremental positive sequence component of current measured at the beginning of the line,

$\underline{H}_{iA}$ - denotes the second analytical coefficient for the negative sequence component, determined from the analysis of an equivalent circuit diagram of the system as shown in fig. 11 and/or the incremental positive sequence component analytically determined from the equivalent circuit diagram of the system as shown in fig. 12,

$\underline{I}_{FAi}$ - denotes the negative sequence component of the total fault current, determined from the analysis of an equivalent circuit diagram of the system as shown in fig. 11 and/or the incremental positive sequence component of the total fault current, determined from the analysis of an equivalent circuit diagram of the system as shown in fig. 12,

$\underline{Q}_{BCi}$ - denotes the quotient of the negative sequence component of current measured at the end of the line and the sum of the negative sequence components of current signals measured at the end of the line and at the end of the tapped line and/or the quotient of the incremental positive sequence component of current measured at the end of the line and the sum of the incremental positive sequence components of current signals measured at the end of the line and at the end of the tapped line.

7.  **A method according to claim 1, characterised in that** for three-terminal power lines, the equivalent source impedance $((\underline{Z}_{2SC})_{SUB\_A})$ for the negative component and $((\underline{Z}_{\Delta1SC})_{SUB\_A})$ for the incremental positive sequence component are determined assuming that the fault occurred in line section LA, from the following equation:

$$(\underline{Z}_{\text{iSC}})_{\text{SUB\_A}} = \left(\underline{Z}_{\text{iLB}} + (\underline{Z}_{\text{iSB}})_{\text{SUB\_A}}\right)\frac{\underline{I}_{\text{Bi}}}{\underline{I}_{\text{Ci}}} - \underline{Z}_{\text{iLC}}$$

where:

the lower index $i$ takes on values $i = 2$ for the negative sequence component, $i = \Delta 1$ for the incremental positive sequence component,

$(\underline{Z}_{\text{iSB}})_{\text{SUB\_A}}$ - denotes equivalent source impedance for the negative sequence component and/or the incremental positive sequence component, calculated assuming that the fault occurred in line section LA,

$\underline{Z}_{\text{iLB}}$ - denotes the impedance of line section LB for the negative sequence component and/or the positive sequence component, where: $\underline{Z}_{\Delta 1 \text{LB}} = \underline{Z}_{1\text{LB}}$,

$\underline{Z}_{1\text{LB}}$ - denotes the impedance of line section LB for the positive sequence component,

$\underline{Z}_{\text{iLC}}$ - denotes the impedance of line section LC for the negative sequence component and/or impedance of line section LC for the incremental positive sequence component, where $\underline{Z}_{2\text{LC}}\ \underline{Z}_{1\text{LC}}$ and $Z_{\Delta 1\text{LC}}$ - $Z_{1\text{LC}}$,

$\underline{Z}_{1\text{LC}}$ - denotes the impedance of line section LC for the positive sequence component,

$\underline{I}_{\text{Bi}}$ - denotes the negative sequence component and/or the incremental positive sequence component of current measured at the end of the line,

$\underline{I}_{\text{Ci}}$ - denotes the negative sequence component and/or the incremental positive sequence component of current measured at the end of the branch.

**8.** **A method according to claim 1, characterised in that** for three-terminal power lines, equivalent source impedance for the negative sequence component $(\underline{Z}_{2\text{SB}})_{\text{SUB\_B}}$ and for the incremental positive sequence component $(\underline{Z}_{\Delta 1\text{SB}})_{\text{SUB\_B}}$ is determined assuming that the fault occurred in line section LB, from the following equation:

$$(\underline{Z}_{\text{iSB}})_{\text{SUB\_B}} = \frac{(1-d_{\text{B}})\underline{Z}_{\text{iLB}}\,\underline{I}_{\text{TBi}}^{\text{transf.}} - d_{\text{B}}\underline{Z}_{\text{iLB}}\underline{I}_{\text{Bi}} - \underline{V}_{\text{Ti}}^{\text{transf.}}}{\underline{I}_{\text{Bi}}},$$

where:

the lower index $i$ takes on values $i = 2$ for the negative sequence component, $i = \Delta 1$ for the incremental positive sequence component,

$d_{\text{B}}$ - denotes the distance from the end of the line to the fault point,

$\underline{Z}_{\text{iLB}}$ - denotes the impedance of line section LB for the negative sequence component and/or for the positive sequence component, where $\underline{Z}_{2\text{LB}} = \underline{Z}_{1\text{LB}}$ and $\underline{Z}_{\Delta 1\text{LB}} = \underline{Z}_{1\text{LB}}$,

$\underline{Z}_{1\text{LB}}$ - denotes the impedance of line section LB for the positive sequence component,

$\underline{I}_{\text{TBi}}^{\text{transf.}}$ - denotes current flowing from a tap point T to line section LB for the negative sequence component and/or for the incremental positive sequence component,

$\underline{I}_{\text{Bi}}$ - denotes the negative sequence component and/or the incremental positive sequence component of current measured at the end of the line,

$\underline{V}_{\text{Ti}}^{\text{transf.}}$ - denotes voltage in the tap point T for the negative sequence component and/or for the incremental positive sequence component.

**9.** **A method according to claim 1, characterised in that** for three-terminal power lines, equivalent source impedance for the negative sequence component $(\underline{Z}_{2\text{SC}})_{\text{SUB\_B}}$ and for the incremental positive sequence component $(\underline{Z}_{\Delta 1\text{SC}})_{\text{SUB\_B}}$ is calculated assuming that the fault occurred in line section LB, from the following equation:

$$(\underline{Z}_{\text{iSC}})_{\text{SUB\_B}} = -\frac{\underline{V}_{\text{Ci}}}{\underline{I}_{\text{Ci}}}$$

where:

the lower index *i* takes on values *i* = 2 for the negative sequence component, *i* = Δ1 for the incremental positive sequence component,

$\underline{V}_{\text{Ci}}$ - denotes the negative sequence component and/or the incremental positive sequence component of voltage at the end of the tapped line,

$\underline{I}_{\text{Ci}}$ - denotes the negative sequence component and/or the incremental positive sequence component of current measured at the end of the branch.

10. **A method according to claim 1, characterised in that** for three-terminal power lines, equivalent source impedance for the negative sequence component $(\underline{Z}_{\text{2SC}})_{\text{SUB\_C}}$ and for the incremental positive sequence component $(\underline{Z}_{\Delta 1\text{SC}})_{\text{SUB\_C}}$ is calculated assuming that the fault occurred in line section LC, from the following equation:

$$(\underline{Z}_{\text{iSC}})_{\text{SUB\_C}} = \frac{(1 - d_{\text{C}})\underline{Z}_{\text{iLC}}\underline{I}_{\text{TCi}}^{\text{transf.}} - d_{\text{C}}\underline{Z}_{\text{iLC}}\underline{I}_{\text{Ci}} - \underline{V}_{\text{Ti}}^{\text{transf.}}}{\underline{I}_{\text{Ci}}},$$

where:

the lower index *i* takes on values *i* = 2 for the negative sequence component, *i* = Δ1 for the incremental positive sequence component,

$d_{\text{C}}$ - denotes the distance from the end of the tapped line to the fault point,

$\underline{Z}_{\text{iLC}}$ - denotes impedance of the line section LC for the negative sequence component and/or for the incremental positive sequence component, where $\underline{Z}_{\text{2LC}}$ $\underline{Z}_{\text{1LC}}$ and $\underline{Z}_{\Delta 1\text{LC}} = \underline{Z}_{\text{iLC}}$,

$\underline{Z}_{\text{1LC}}$ - denotes impedance of the line section LC for the positive sequence component,

$\underline{I}_{\text{TCi}}^{\text{transf.}}$ - denotes current flowing to the tap point T from line section LC for the negative sequence component and/or for the incremental positive sequence component,

$\underline{I}_{\text{Ci}}$ - denotes the negative sequence component and/or the incremental positive sequence component of current measured at the end of the branch,

$\underline{V}_{\text{Ti}}^{\text{transf.}}$ - denotes voltage at the tap point T for the negative sequence component and/or for the incremental positive sequence component.

11. **A method according to claim 1, characterised in that** for three-terminal power lines, equivalent source impedance for the negative sequence component $(\underline{Z}_{\text{2SB}})_{\text{SUB\_C}}$ and for the incremental positive sequence component $(\underline{Z}_{\Delta 1\text{SB}})_{\text{SUB\_C}}$ is calculated assuming that the fault occurred in line section LC, from the following equation:

$$(\underline{Z}_{\text{iSB}})_{\text{SUB\_C}} = -\frac{\underline{V}_{\text{Bi}}}{\underline{I}_{\text{Bi}}}$$

where:

the lower index *i* takes on values *i* = 2 for the negative sequence component, *i* = Δ1 for the incremental positive sequence component,

$\underline{V}_{\text{Bi}}$ - denotes the negative sequence and/or the incremental positive sequence component of voltage at the end of the line,

$\underline{I}_{\text{Bi}}$ - denotes the negative sequence and/or the incremental positive sequence component of current measured at the end of the line.

12. **A method according to claim 1, characterised in that for** multi-terminal power lines, distances from the beginning of the line to the fault point ($d_1$), from the end of the line to the fault point ($d_{(2n-3)}$), from the end of the line to the fault point ($d_{(2k-2)}$), from the tap point to the fault point in the line section between two tap points ($d_{(2k-1)}$) are determined

from the following equations:

$$d_1 = \frac{\mathrm{real}(\underline{V}_{1p})\,\mathrm{imag}(\underline{I}_F) - \mathrm{imag}(\underline{V}_{1p})\,\mathrm{real}(\underline{I}_F)}{\mathrm{real}(\underline{Z}_{1L1}\underline{I}_{1p})\,\mathrm{imag}(\underline{I}_F) - \mathrm{imag}(\underline{Z}_{1L1}\underline{I}_{1p})\,\mathrm{real}(\underline{I}_F)},$$

$$d_{(2n-3)} = \frac{-\mathrm{real}(\underline{V}_{T(n-1)np} - \underline{Z}_{1L(2n-3)}\underline{I}_{T(n-1)np})\,\mathrm{imag}(\underline{I}_F) + \mathrm{imag}(\underline{V}_{T(n-1)np} - \underline{Z}_{1L(2n-3)}\underline{I}_{T(n-1)np})\,\mathrm{real}(\underline{I}_F)}{\mathrm{real}(\underline{Z}_{1L(2n-3)}\underline{I}_{T(n-1)np})\,\mathrm{imag}(\underline{I}_F) - \mathrm{imag}(\underline{Z}_{1L(2n-3)}\underline{I}_{T(n-1)np})\,\mathrm{real}(\underline{I}_F)}$$

$$d_{(2k-2)} = \frac{-\mathrm{real}(\underline{V}_{Tkkp} - \underline{Z}_{1L(2k-2)}\underline{I}_{Tkkp})\,\mathrm{imag}(\underline{I}_F) + \mathrm{imag}(\underline{V}_{Tkkp} - \underline{Z}_{1L(2k-2)}\underline{I}_{Tkkp})\,\mathrm{real}(\underline{I}_F)}{\mathrm{real}(\underline{Z}_{1L(2k-2)}\underline{I}_{Tkkp})\,\mathrm{imag}(\underline{I}_F) - \mathrm{imag}(\underline{Z}_{1L(2k-2)}\underline{I}_{Tkkp})\,\mathrm{real}(\underline{I}_F)},$$

$$d_{(2k-1)} = \frac{-\mathrm{real}(\underline{V}_{TkT(k+1)p} - \underline{Z}_{1L(2k-1)}\underline{I}_{TkT(k+1)p})\,\mathrm{imag}(\underline{I}_F) + \mathrm{imag}(\underline{V}_{TkT(k+1)p} - \underline{Z}_{1L(2k-1)}\underline{I}_{TkT(k+1)p})\,\mathrm{real}(\underline{I}_F)}{\mathrm{real}(\underline{Z}_{1L(2k-1)}\underline{I}_{TkT(k+1)p})\,\mathrm{imag}(\underline{I}_F) - \mathrm{imag}(\underline{Z}_{1L(2k-1)}\underline{I}_{TkT(k+1)p})\,\mathrm{real}(\underline{I}_F)}$$

where:

$\underline{V}_{1p}$ - fault loop voltage calculated under assumption that fault occurred in the first section of the line section L1,

$\underline{I}_{1p}$ - fault loop current calculated under assumption that fault occurred in the first section of the line section L1,

$\underline{V}_{T(n-1)np}$ - fault loop voltage calculated under assumption that fault occurred in the line section L(2n-3),

$\underline{I}_{T(n-1)np}$ - fault loop current calculated under assumption that fault occurred in the line section L(2n-3),

$\underline{V}_{Tkkp}$ - fault loop voltage calculated under assumption that fault occurred in the $k^{th}$ tapped line,

$\underline{I}_{Tkkp}$ - fault loop current calculated under assumption that fault occurred in $k^{th}$ tapped line,

$\underline{V}_{TkT(k+1)p}$ - fault loop voltage calculated under assumption that fault occurred in the line section between two tap points,

$\underline{I}_{TkT(k+1)p}$ - fault loop current calculated under assumption that fault occurred in the line section between two tap points,

$\underline{I}_F$ - total fault current,

$\underline{Z}_{1L1}$ - impedance of line section L1 for the positive sequence component,

$\underline{Z}_{0L1}$ - impedance of line section L1 for the zero sequence component,

$\underline{Z}_{1L(2n-3)}$ - impedance of line section L(2n-3) for the positive sequence component,

$\underline{Z}_{0L(2a-3)}$ - impedance of line section L(2n-3) for the zero sequence component,

$\underline{Z}_{1L(2k-2)}$ - impedance of line section L(2k-2) for the positive sequence component,

$\underline{Z}_{0L(2k-2)}$ - impedance of line section L(2k-2) for the zero sequence component,

$\underline{Z}_{1L(2k-1)}$ - impedance of line section L(2k-1) for the positive sequence component,

$\underline{Z}_{0L(2k-1)}$ - impedance of line section L(2k-1) for the zero sequence component.

k- number of the tap point

n- number of the line terminal

**13. A method according to claim 1, characterised in that** for multi-terminal electric power lines, fault resistance ($R_{1F}$), ($R_{(2n-3)F}$), ($R_{(2k-2)F}$), ($R_{(2k-1)F}$) is determined from the following equations:

$$R_{1F} = \frac{1}{2}\left[\frac{\mathrm{real}(\underline{V}_{1p}) - d_1\mathrm{real}(\underline{Z}_{1L1}\underline{I}_{1p})}{\mathrm{real}(\underline{I}_F)} + \frac{\mathrm{imag}(\underline{V}_{1p}) - d_1\mathrm{imag}(\underline{Z}_{1L1}\underline{I}_{1p})}{\mathrm{imag}(\underline{I}_F)}\right],$$

$$R_{(2n-3)F} = \frac{1}{2}\left[\frac{real(\underline{V}_{T(n-1)np}) - (1-d_{(2n-3)}) \cdot real(\underline{Z}_{1L(2n-3)}\underline{I}_{T(n-1)np})}{real(\underline{I}_F)}\right] + \\ + \frac{1}{2}\left[\frac{imag(\underline{V}_{T(n-1)np}) - (1-d_{(2n-3)}) \cdot imag(\underline{Z}_{1(2n-3)}\underline{I}_{T(n-1)np})}{imag(\underline{I}_F)}\right],$$

$$R_{(2k-2)F} = \frac{1}{2}\left[\frac{real(\underline{V}_{Tkkp}) - (1-d_{(2k-2)}) \cdot real(\underline{Z}_{1L(2k-2)}\underline{I}_{Tkkp})}{real(\underline{I}_F)}\right] + \\ + \frac{1}{2}\left[\frac{imag(\underline{V}_{Tkkp}) - (1-d_{(2k-2)}) \cdot imag(\underline{Z}_{1L(2k-2)}\underline{I}_{Tkkp})}{imag(\underline{I}_F)}\right]$$

$$R_{(2k-1)F} = \frac{1}{2}\left[\frac{real(\underline{V}_{TkT(k+1)p}) - (1-d_{(2k-1)}) \cdot real(\underline{Z}_{1L(2k-1)}\underline{I}_{TkT(k+1)p})}{real(\underline{I}_F)}\right] + \\ + \frac{1}{2}\left[\frac{imag(\underline{V}_{TkT(k+1)p}) - (1-d_{(2k-1)}) \cdot imag(\underline{Z}_{1L(2k-1)}\underline{I}_{TkT(k+1)p})}{imag(\underline{I}_F)}\right]$$

where:

$d_1$ - distance to fault from the beginning of the line to the fault point,

$d_{(2n-3)}$ - distance to fault from the end of the line to the fault point,

$d_{(2k-2)}$ - distance to fault from the end of the tapped line to the fault point $d_{(2k-1)}$ - distance to fault in the line section between two tap points,

$\underline{V}_{1p}$ - fault loop voltage calculated under assumption that fault occurred in the first section of the line section L1,

$\underline{I}_{1p}$ - fault loop current calculated under assumption that fault occurred in the first section of the line section L1,

$\underline{V}_{T(n-1)np}$ - fault loop voltage calculated under assumption that fault occurred in the line section L(2n-3),

$\underline{I}_{T(n-1)np}$ - fault loop current calculated under assumption that fault occurred in the line section L(2n-3),

$\underline{V}_{Tkkp}$ - fault loop voltage calculated under assumption that fault occurred in the $k^{th}$ tapped line,

$\underline{I}_{Tkkp}$ - fault loop current calculated under assumption that fault occurred in $k^{th}$ tapped line,

$\underline{V}_{TkT(k+1)p}$ - fault loop voltage calculated under assumption that fault occurred in the line section between two tap points,

$\underline{I}_{TkT(k+1)p}$ - fault loop current calculated under assumption that fault occurred in the line section between two tap points,

$\underline{I}_F$ - total fault current,

$\underline{Z}_{1L1}$ - impedance of line section L1 for the positive sequence component,

$\underline{Z}_{0L1}$ - impedance of line section L1 for the zero sequence component,

$\underline{Z}_{1L(2n-3)}$ - impedance of line section L(2n-3) for the positive sequence component,

$\underline{Z}_{0L(2n-3)}$ - impedance of line section L(2n-3) for the zero sequence component,

$\underline{Z}_{1L(2k-2)}$ - impedance of line section L(2k-2) for the positive sequence component,

$\underline{Z}_{0L(2k-2)}$ - impedance of line section L(2k-2) for the zero sequence component,

$\underline{Z}_{1L(2k-1)}$ - impedance of line section L(2k-1) for the positive sequence component,

$\underline{Z}_{0L(2k-1)}$ - impedance of line section L(2k-1) for the zero sequence component.

k- number of the tap point

n- number of the line terminal

**14. A method according to claim 1, characterised in that** for multi-terminal power lines, equivalent source impedance for the negative sequence component ($\underline{Z}_{2S1}$) or for the incremental positive sequence component ($\underline{Z}_{\Delta1S1}$) is calculated assuming that the fault is located in line section between the beginning of the line and the first tap point, from the following equation:

$$(\underline{Z}_{iS1}) = \frac{-\underline{V}_{1i}}{\underline{I}_{1i}}$$

where

i=2 for negative sequence, Δ1 for incremental positive sequence component,
$\underline{V}_{1i}$ - voltage measured in station 1 (the first lower index) for individual symmetrical components, (the second lower index) i.e. negative component - index 2 and incremental positive sequence component - index Δ1,
$I_{1i}$ - current measured in station 1 (the first lower index) for individual symmetrical components, (the second lower index) i.e. negative component - index 2 and incremental positive sequence component - index Δ1.

**15.** **A method according to claim 1, characterised in that** for multi-terminal power lines equivalent source impedance $((\underline{Z}_{2S(n)}))$ for the negative component and $((\underline{Z}_{\Delta 1S(n)}))$ for the incremental positive sequence component is determined assuming that the fault is located in line section between the end of the line and the final tap point, from the following equation:

$$(\underline{Z}_{iSn}) = -\frac{\underline{V}_{T(n-1)i}^{transf.} - (1-d_{(2n-3)}) \cdot \underline{Z}_{iL(2n-3)} \cdot \underline{I}_{T(n-1)ni}^{transf.} - d_{(2n-3)} \cdot \underline{Z}_{iL(2n-3)} \cdot (\underline{I}_{T(n-1)ni}^{transf.} - \underline{I}_{Fi})}{\underline{I}_{ni}}$$

where:

i=2 for negative sequence component, Δ1 for incremental positive sequence component,

$\underline{V}_{T(n-1)i}^{transf.}$ - voltages in the final tap point T(n-1) for the negative sequence component i=2, or for incremental positive sequence component i=Δ1,
$d_{(2n-3)}$ - distance to fault from the end of the line to the fault point,
$\underline{Z}_{iL(2n-3)}$ - impedance of line section L(2n-3) for the negative sequence component i=2, or for incremental positive sequence component i=Δ1,

$\underline{I}_{T(n-1)ni}^{transf.}$ - values of current flowing from tap point T(n-1) to station n in line section L(2n-3) for negative sequence component i=2, or for incremental positive sequence component i=Δ1
$I_{Fi}$ - total fault current for negative sequence component i=2, or for incremental positive sequence component i=Δ1,
$\underline{I}_{ni}$ - current measured in last station n (the first lower index) for individual symmetrical components, (the second lower index) i.e. negative component-index 2 and incremental positive sequence component - index Δ1.

**16.** **A method according to claim 1, characterised in that** for multi-terminal power lines equivalent source impedance for the negative component $((\underline{Z}_{2Sk})$ and for the incremental positive sequence component $((\underline{Z}_{\Delta 1SK}))$ is determined assuming that the fault is located in the line branch:

$$(\underline{Z}_{iSk}) = -\frac{\underline{V}_{Tki}^{transf.} - (1-d_{(2k-2)}) \cdot \underline{Z}_{iL(2k-2)} \cdot \underline{I}_{Tkki}^{transf.} - d_{(2k-2)} \cdot \underline{Z}_{iL(2k-2)} \cdot (\underline{I}_{Tkki}^{transf.} - \underline{I}_{F2})}{\underline{I}_{ki}} \cdot$$

where:

$\underline{V}_{Tki}^{transf.}$ - voltages in the $k^{th}$ tap point for the negative sequence component i=2, or for incremental positive sequence component i=Δ1,
$d_{(2k-2)}$ -- distance to fault from the end of the tapped line to the fault point Tk, $\underline{Z}_{iL(2k-2)}$ - impedance of line section L(2k-2) for the negative sequence component i=2, or for incremental positive sequence component i=Δ1,

$I_{\mathrm{Tkki}}^{\mathrm{transf.}}$ - values of current flowing from tap point Tk to $k^{\mathrm{th}}$ station in tapped line section L(2k-2) for negative sequence component i=2, or for incremental positive sequence component i=$\Delta$1

$I_{Fi}$ - total fault current for negative sequence component i=2, or for incremental positive sequence component i=$\Delta$1,

$I_{ki}$ current measured in station k (the first lower index) for individual symmetrical components, (the second lower index) i.e. negative component - index 2 and incremental positive sequence component - index $\Delta$1.

**17. A method according to claim 1, characterised in that** for multi-terminal power lines equivalent source impedance for the negative component (($\underline{Z}_{2Sk}$) and ($\underline{Z}_{2S(k+1)}$)) as well as for the incremental positive sequence component ($\underline{Z}_{\Delta 1Sk}$) and ($\underline{Z}_{\Delta 1S(k+1)}$)) is determined assuming that the fault is located in the line section between two consecutive tap points, from the following equation:

$$(\underline{Z}_{iSk}) = -\frac{V_{\mathrm{Tki}}^{\mathrm{transf.}} - d_{(2k-1)} \cdot \underline{Z}_{iL(2k-1)} \cdot I_{\mathrm{TkT(k+1)i}}^{\mathrm{transf.}} - (1 - d_{(2k-1)}) \cdot \underline{Z}_{iL(2k-1)} \cdot (I_{\mathrm{TkT(k+1)i}}^{\mathrm{transf.}} - I_{Fi}) + \underline{Z}_{iLk} I_{ki}}{I_{ki}}$$

$$(\underline{Z}_{iS(k+1)}) = -\frac{V_{\mathrm{Tki}}^{\mathrm{transf.}} - d_{(2k-1)} \cdot \underline{Z}_{iL(2k-1)} \cdot I_{\mathrm{TkT(k+1)i}}^{\mathrm{transf.}} - (1 - d_{(2k-1)}) \cdot \underline{Z}_{iL(2k-1)} \cdot (I_{\mathrm{TkT(k+1)i}}^{\mathrm{transf.}} - I_{Fi}) + \underline{Z}_{iL(2k)} I_{(k+1)i}}{I_{(k+1)i}}$$

where:

$V_{\mathrm{Tki}}^{\mathrm{transf.}}$ - voltages in the $k^{\mathrm{th}}$ tap point for the negative sequence component i=2, or for incremental positive sequence component i=$\Delta$1,

$d_{(2k-1)}$ - distance to fault in the line section between two tap points

$\underline{Z}_{iL(2k-1)}$- impedance of line section L(2k-1) for the negative sequence component i=2, or for incremental positive sequence component i=$\Delta$1,

$I_{\mathrm{TkT(k+1)i}}^{\mathrm{transf.}}$ - current flowing from tap point Tk to tap point T(k+1) in the line section for negative sequence component i=2, or for incremental positive sequence component i=$\Delta$1

$I_{Fi}$ - total fault current for negative sequence component i=2, or for incremental positive sequence component i=$\Delta$1,

$I_{ki}$ current measured in station k (the first lower index) for individual symmetrical components, (the second lower index) i.e. negative component - index 2 and incremental positive sequence component - index $\Delta$1,

$I_{(k+1)i}$ - current measured in station k+1 (the first lower index) for individual symmetrical components, (the second lower index) i.e. negative component-index 2 and incremental positive sequence component - index $\Delta$1

**Patentansprüche**

1. Verfahren zur Fehlerortung in elektrischen Stromleitungen, bei dem die Aufteilung der Fernleitungen des Übertragungs- oder Verteilungssystems in Sektionen ausgenutzt wird, **dadurch gekennzeichnet, dass**

- an allen Endstellen der Systemleitungen der Strom für den Kurzschlusszustand oder Kurzschlussvorzustand gemessen wird,
- an einer Endstelle des Systems die Phasenspannung der Leitung für den Kurzschlusszustand oder Kurzschlussvorzustand gemessen wird,
- symmetrische Komponenten der gemessenen Strom- und Spannungssignale sowie der gesamte Kurzschlussstrom an der Kurzschlussstelle gemessen werden,
- eine hypothetische Kurzschlussstelle, angeordnet in einer der Leitungssektionen, angenommen wird,
- die erste hypothetische Kurzschlussstelle, angeordnet in der Leitungssektion zwischen dem Leitungsanfang und dem ersten Knotenpunkt der Abzweigung, und eine andere hypothetische Kurzschlussstelle, angeordnet in der Leitungssektion zwischen dem Leitungsende und dem letzten Knotenpunkt der Abzweigung, sowie weitere hypothetische Kurzschlussstellen, angeordnet in jeder der Leitung angeschlossenen Abzweigungen, angenommen werden, wobei allerdings für eine Leitung mit mehreren Abzweigungen, die mehr als drei Stationen hat, eine weitere hypothetische Kurzschlussstelle, angeordnet in jeder Leitungssektion zwischen zwei aufeinanderfolgenden Knotenpunkten der Abzweigung, zusätzlich angenommen wird,

- die Entfernung vom Anfang der Leitung bis zur Kurzschlussstelle in der Leitungssektion zwischen dem Leitungsanfang und dem ersten Knotenpunkt der Abzweigung, die Entfernung vom Leitungsende bis zur Kurzschlussstelle in der Leitungssektion zwischen dem Leitungsende und dem letzten Punkt der Abzweigung, die Entfernung vom Ende der Abzweigleitung bis zur Kurzschlussstelle in jeder Abzweigung der Leitung, für eine Leitung mit mehreren Abzweigungen allerdings die Entfernung vom Knotenpunkt der Abzweigung bis zur Kurzschlussstelle, angeordnet in jeder Sektion der Leitung zwischen zwei Knotenpunkten der Abzweigung, errechnet werden und anschließend für alle hypothetischen Kurzschlussstellen in jeder Sektion der Durchgangswiderstand errechnet wird,

- die Auswahl einer geeigneten Kurzschlussstelle zuerst durch den Vergleich der Zahlenwerte, die sich auf die vorher festgelegten Entfernungen beziehen, und durch das Ablehnen von Ergebnissen, deren Zahlenwerte in Relativeinheiten negativ oder größer als 1 sind, vorgenommen wird, und anschließend durch die Analyse der Werte der errechneten Widerstände der Übergänge für die Kurzschlussstellen und das Ablehnen der Rechnungsergebnisse, bei denen der Widerstandswert des Durchganges negativ ist, und wenn sich nach diesen Berechnungen herausstellt, dass nur ein Zahlenwert, der sich auf die Entfernung vom Kurzschluss bezieht, in Relativeinheiten im Intervall zwischen Null und Eins enthalten ist sowie der für diese Entfernung errechnete Widerstand des Durchganges an der Kurzschlussstelle positiv oder gleich Null ist, dann wird diese Entfernung bis zur Kurzschlussstelle als endgültige Entfernung angenommen, die die aktuelle Entfernung bis zur Kurzschlussstelle sowie den Widerstandswert des Durchganges an der Kurzschlussstelle anzeigt,

- wenn sich nach der Auswahl einer geeigneten Kurzschlussstelle herausstellt, dass mindestens zwei Zahlenwerte, die sich auf die vorher errechneten Entfernungen beziehen, in Relativeinheiten im Intervall zwischen Null und Eins enthalten sind sowie die Werte der errechneten Widerstände des Durchganges für diese Kurzschlussstellen positiv oder gleich Null sind, dann werden die Module der Impedanz der äquivalenten Speiseschaltungen für das Gegensystem für Einphasenkurzschlüsse, Zweiphasenkurzschlüsse und Zweiphasenerdschlüsse, oder für das inkrementelle Mitsystem für Dreiphasenkurzschlüsse bestimmt, unter der Annahme, dass der Kurzschluss in einer bestimmten Sektion aufgetreten ist, wobei für eine Leitung mit mehreren Abzweigungen bei der Bestimmung der Impedanz der äquivalenten Speiseschaltungen zusätzlich geprüft wird, ob die errechneten Impedanzwerte der äquivalenten Speiseschaltungen im ersten Viertel des kartesische Koordinatensystems des komplexen Systems enthalten sind, und solche Entfernungswerte bis zur Kurzschlussstelle abgelehnt werden, für die die errechneten Impedanzwerte der äquivalenten Speiseschaltungen im ersten Viertel des kartesische Koordinatensystems des komplexen Systems nicht enthalten sind, und wenn sich herausstellt, dass nur ein Impedanzwert der äquivalenten Speiseschaltungen, der die Entfernung bis zur Kurzschlussstelle enthält, im ersten Viertel des kartesische Koordinatensystems des komplexen Systems enthalten ist, diese Entfernung bis zur Kurzschlussstelle für diesen Impedanzwert als endgültiger Wert angenommen wird, wenn sich aber herausstellt, dass mindestens zwei Impedanzwerte der äquivalenten Speiseschaltungen, die die Entfernungen bis zur Kurzschlussstelle enthalten, im ersten Viertel des kartesische Koordinatensystems des komplexen Systems angeordnet sind, diese Werte der Impedanzmodule der äquivalenten Speiseschaltungen im nächsten Schritt verwendet werden,

- die Entfernung bis zur Kurzschlussstelle, für die das Impedanzmodul der äquivalenten Speiseschaltung den Realwerten, die die Belastung oder die Systemspeisung tatsächlich bestimmen, am besten entspricht, als endgültiges Ergebnis angenommen wird.

**2.** Ein Verfahren nach Anspruch 1, **dadurch gekennzeichnet, dass** die Errechnung des gesamten Kurzschlussstromes unter Berücksichtigung von Koeffizienten durchgeführt wird, die die Relationen zwischen den einzelnen symmetrischen Komponenten des gemessenen Gesamtstroms bezeichnen, wenn der Spannungsabfall auf dem Widerstand des Durchganges geschätzt wird, und insbesondere dass ein bestimmter Satz dieser Koeffizienten bei dieser Operation verwendet wird.

**3.** Ein Verfahren nach Anspruch 1, **dadurch gekennzeichnet, dass** für Zweiphasenerdschlüsse das Mitsystem bei der Errechnung des gesamten Kurzschlussstromes ausgeschlossen wird, wobei für das Gegen- und Nullsystem folgende Werte der Beteiligungskoeffizienten, die die Reaktionen zwischen den einzelnen symmetrischen Komponenten des Gesamtstroms bezeichnen, angenommen werden, wenn der Spannungsabfall auf dem Widerstand des Durchganges geschätzt wird:

$$\underline{a}_{\text{F1}} = 0 \ ,$$

$$\underline{a}_{\text{F2}} = \underline{a}_{\text{F2}}^{\text{init.}} - \frac{\underline{a}_{\text{F1}}^{\text{init.}} \underline{b}_{\text{F2}}}{\underline{b}_{\text{F1}}} \ ,$$

$$\underline{a}_{\text{F0}} = \frac{\underline{a}_{\text{F1}}^{\text{init.}}}{\underline{b}_{\text{F1}}} \ ,$$

wobei

$\underline{a}_{\text{F1}}^{\text{init.}}$ , $\underline{a}_{\text{F2}}^{\text{init.}}$ , $\underline{a}_{\text{F0}}^{\text{init.}}$ den Anfangsbeteiligungskoeffizienten der symmetrischen Komponenten des Gesamtstroms bei der Bestimmung des Spannungsabfalls des Widerstandes bezeichnen,

$\underline{b}_{\text{F1}}$, $\underline{b}_{\text{F2}}$ die Relationskoeffizienten bezeichnen, die aus der Relation zwischen der Nullsystem-Komponente und den übrigen Komponenten des gesamten Kurzschlussstromes, der durch den Widerstand des Durchganges fließt, bestimmt werden.

4. Ein Verfahren nach Anspruch 1 **dadurch gekennzeichnet, dass** für die Speiseleitungen, die drei Endstellen haben, die Entfernungen vom Anfang der Leitung bis zum Kurzschlusspunkt $d_A$, vom Ende der Leitung bis zum Kurzschlusspunkt $d_B$ und vom Ende der Abzweigung der Leitung bis zum Kurzschlusspunkt $d_C$ aus folgenden Gleichungen bestimmt werden:

$$d_{\text{A}} = \frac{\text{real}(\underline{V}_{\text{Ap}})\text{imag}(\underline{I}_{\text{F}}) - \text{imag}(\underline{V}_{\text{Ap}})\text{real}(\underline{I}_{\text{F}})}{\text{real}(\underline{Z}_{\text{1LA}}\underline{I}_{\text{Ap}})\text{imag}(\underline{I}_{\text{F}}) - \text{imag}(\underline{Z}_{\text{1LA}}\underline{I}_{\text{Ap}})\text{real}(\underline{I}_{\text{F}})} \ ,$$

$$d_{\text{B}} = \frac{-\text{real}(\underline{V}_{\text{Tp}} - \underline{Z}_{\text{1LB}}\underline{I}_{\text{TBp}})\text{imag}(\underline{I}_{\text{F}}) + \text{imag}(\underline{V}_{\text{Tp}} - \underline{Z}_{\text{1LB}}\underline{I}_{\text{TBp}})\text{real}(\underline{I}_{\text{F}})}{\text{real}(\underline{Z}_{\text{1LB}}\underline{I}_{\text{TBp}})\text{imag}(\underline{I}_{\text{F}}) - \text{imag}(\underline{Z}_{\text{1LB}}\underline{I}_{\text{TBp}})\text{real}(\underline{I}_{\text{F}})} \ ,$$

$$d_{\text{C}} = \frac{-\text{real}(\underline{V}_{\text{Tp}} - \underline{Z}_{\text{1LC}}\underline{I}_{\text{TCp}})\text{imag}(\underline{I}_{\text{F}}) + \text{imag}(\underline{V}_{\text{Tp}} - \underline{Z}_{\text{1LC}}\underline{I}_{\text{TCp}})\text{real}(\underline{I}_{\text{F}})}{\text{real}(\underline{Z}_{\text{1LC}}\underline{I}_{\text{TCp}})\text{imag}(\underline{I}_{\text{F}}) - \text{imag}(\underline{Z}_{\text{1LC}}\underline{I}_{\text{TCp}})\text{real}(\underline{I}_{\text{F}})} \ ,$$

wobei folgendes gilt:

"real" - bezeichnet den Realteil des gegebenen Wertes,
"imag" - bezeichnet den Imaginärteil des gegebenen Wertes,
$\underline{V}_{\text{A}}\text{p}$ - bezeichnet die Spannung der Kurzschlussschleife, bestimmt unter der Annahme, dass der Kurzschluss in der Sektion LA aufgetreten ist,
$\underline{V}_{\text{TP}}$ - bezeichnet die Spannung der Kurzschlussschleife, bestimmt unter der Annahme, dass der Kurzschluss in der Sektion LB oder LC aufgetreten ist,
$\underline{I}_{\text{Ap}}$ - bezeichnet den Strom der Kurzschlussschleife, bestimmt unter der Annahme, dass der Kurzschluss in der Sektion LA aufgetreten ist,
$\underline{I}_{\text{TBp}}$ - bezeichnet den Strom der Kurzschlussschleife, bestimmt unter der Annahme, dass der Kurzschluss in der Sektion LB aufgetreten ist,
$\underline{I}_{\text{TCp}}$ - bezeichnet den Strom der Kurzschlussschleife, bestimmt unter der Annahme, dass der Kurzschluss in der Sektion LC aufgetreten ist,
$\underline{I}_{\text{F}}$ - bezeichnet den gesamten Kurzschlussstrom,
$\underline{Z}_{\text{1LA}} = R_{\text{1LA}} + j\omega_1 L_{\text{1LA}}$ - bezeichnet die Impedanz der Sektion der Leitung LA für das Mitsystem,

$\underline{Z}_{1LB} = R_{1LB} + j\omega_1 L_{1LB}$ - bezeichnet die Impedanz der Sektion der Leitung LB für das Mitsystem,
$\underline{Z}_{1LC} = R_{1LC} + j\omega_1 L_{1LC}$ - bezeichnet die Impedanz der Sektion der Leitung LC für das Mitsystem,
$R_{1LA}$, $R_{1LB}$, $R_{1LC}$ - Widerstände für das Mitsystem, jeweils für die Sektion der Leitung LA, LB, LC,
$L_{1LA}$, $L_{1LB}$, $L_{1LC}$ - Induktivitäten für das Mitsystem, jeweils für die Sektion der Leitung LA, LB, LC,
$\omega_1$ - Pulsation für die Bildfrequenz.

**5.** Ein Verfahren nach Anspruch 1, **dadurch gekennzeichnet, dass** für die Speiseleitungen, die drei Endstellen haben, der Widerstand des Durchganges $R_{FA}$, $R_{FB}$, $R_{FC}$ aus folgenden Gleichungen bestimmt wird:

$$R_{FA} = \frac{1}{2}\left[\frac{\text{real}(\underline{V}_{Ap}) - d_A\text{real}(\underline{Z}_{1LA}\underline{I}_{Ap})}{\text{real}(\underline{I}_F)} + \frac{\text{imag}(\underline{V}_{Ap}) - d_A\text{imag}(\underline{Z}_{1LA}\underline{I}_{Ap})}{\text{imag}(\underline{I}_F)}\right],$$

$$R_{FB} = \frac{1}{2}\left[\frac{\text{real}(\underline{V}_{Tp}) - (1-d_B)\cdot\text{real}(\underline{Z}_{1LB}\underline{I}_{TBp})}{\text{real}(\underline{I}_F)}\right] + \frac{1}{2}\left[\frac{\text{imag}(\underline{V}_{Tp}) - (1-d_B)\cdot\text{imag}(\underline{Z}_{1LB}\underline{I}_{TBp})}{\text{imag}(\underline{I}_F)}\right]$$

$$R_{FC} = \frac{1}{2}\left[\frac{\text{real}(\underline{V}_{Tp}) - (1-d_C)\cdot\text{real}(\underline{Z}_{1LC}\underline{I}_{TCp})}{\text{real}(\underline{I}_F)}\right] + \frac{1}{2}\left[\frac{\text{imag}(\underline{V}_{Tp}) - (1-d_C)\cdot\text{imag}(\underline{Z}_{1LC}\underline{I}_{TCp})}{\text{imag}(\underline{I}_F)}\right]$$

wobei folgendes gilt:

"real" - bezeichnet den Realteil des gegebenen Wertes,
"imag" - bezeichnet den Imaginärteil des gegebenen Wertes,
$\underline{V}_{Ap}$ - bezeichnet die Spannung der Kurzschlussschleife, bestimmt unter der Annahme, dass der Kurzschluss in der Sektion LA aufgetreten ist,
$\underline{V}_{Tp}$ - bezeichnet die Spannung der Kurzschlussschleife, bestimmt unter der Annahme, dass der Kurzschluss in der Sektion LB oder LC aufgetreten ist,
$\underline{I}_{AP}$ - bezeichnet den Strom der Kurzschlussschleife, bestimmt unter der Annahme, dass der Kurzschluss in der Sektion LA aufgetreten ist,
$\underline{I}_{TBp}$ bezeichnet den Strom der Kurzschlussschleife, bestimmt unter der Annahme, dass der Kurzschluss in der Sektion LB aufgetreten ist,
$\underline{I}_{TCp}$ - bezeichnet den Strom der Kurzschlussschleife, bestimmt unter der Annahme, dass der Kurzschluss in der Sektion LC aufgetreten ist,
$\underline{I}_F$ - bezeichnet den gesamten Kurzschlussstrom,
$\underline{Z}_{1LA} = R_{1LA} + j\omega_1 L_{1LA}$ - bezeichnet die Impedanz der Sektion der Leitung LA für das Mitsystem,
$\underline{Z}_{1LB} = R_{1LB} + j\omega_1 L_{1LB}$ - bezeichnet die Impedanz der Sektion der Leitung LB für das Mitsystem,
$\underline{Z}_{1LC} = R_{1LC} + j\omega_1 L_{1LC}$ - bezeichnet die Impedanz der Sektion der Leitung LC für das Mitsystem,
$R_{1LA}$, $R_{1LB}$, $R_{1LC}$ - Widerstände für das Mitsystem, jeweils für eine Sektion der Leitung LA, LB, LC,
$L_{1LA}$, $L_{1LB}$, $L_{1LC}$ - Induktivitäten für das Mitsystem, jeweils für eine Sektion der Leitung LA, LB, LC,
$\omega_1$ - Pulsation für die Bildfrequenz,
$d_A$ - bezeichnet die Entfernung vom Anfang der Leitung bis zur Kurzschlussstelle,
$d_B$ - bezeichnet die Entfernung vom Ende der Leitung bis zur Kurzschlussstelle,
$d_C$ - bezeichnet die Entfernung vom Ende der Abzweigleitung bis zur Kurzschlussstelle.

**6.** Ein Verfahren nach Anspruch 1, **dadurch gekennzeichnet, dass** für die Speiseleitungen, die drei Endstellen haben, die Impedanz der äquivalenten Quelle für das Gegensystem $(\underline{Z}_{2SB})_{SUB\_A}$ sowie für das inkrementelle Mitsystem $(\underline{Z}_{\Delta1SB})_{SUB\_A}$ unter der Annahme, dass der Kurzschluss in einer Sektion der Leitung LA aufgetreten ist, gemäß der nachstehenden Formel errechnet wird:

$$(\underline{Z}_{iSB})_{SUB\_A} = \frac{\underline{G}_{iA}\underline{I}_{A2} - \underline{H}_{iA}\underline{I}_{FAi}}{\underline{Q}_{BCi}(\underline{I}_{FAi} - \underline{I}_{Ai})},$$

wobei folgendes gilt:

der tiefgestellte Index *i* nimmt den Wert *i* = 2 für das Gegensystem und *i* = Δ1 für das inkrementelle Mitsystem an,

$\underline{G}_{iA}$ - bezeichnet den ersten analytischen Koeffizienten für das Gegensystem,
ermittelt aus der Analyse der Ersatzschaltung wie auf Zeichnung 11 und / oder für das inkrementelle Mitsystem, bestimmt aus der Ersatzschaltung wie auf Zeichnung 12,

$\underline{I}_{Ai}$ - bezeichnet die Gegensystem-Komponente und / oder die inkrementelle Mitsystem-Komponente des am Anfang der Leitung gemessenen Stroms,

$\underline{H}_{iA}$ - bezeichnet den anderen analytischen Koeffizienten für das Gegensystem,
ermittelt aus der Analyse der Ersatzschaltung wie auf Zeichnung 11 und / oder für das inkrementelle Mitsystem, analytisch bestimmt aus der Ersatzschaltung wie auf Zeichnung 12,

$\underline{I}_{FAi}$ - bezeichnet die Gegensystem-Komponente des Kurzschlussgesamtstromes,
ermittelt aus der Analyse der Ersatzschaltung wie auf Zeichnung 11 und / oder die inkrementelle Mitsystem-Komponente des Kurzschlussgesamtstromes, bestimmt aus der Analyse der Ersatzschaltung wie auf Zeichnung 12,

$\underline{Q}_{BCi}$ - bezeichnet den Quotienten aus der Gegensystem-Komponente des am Ende der Leitung gemessenen Stroms und der Summe der Gegensystem-Komponenten der Stromsignale, gemessen am Ende der Leitung sowie am Ende der Abzweigleitung und / oder den Quotienten aus der inkrementellen Mitsystem-Komponente des am Ende der Leitung gemessenen Stroms und der Summe der inkrementellen Mitsystem-Komponenten der Stromsignale, gemessen am Ende der Leitung und am Ende der Abzweigleitung.

7. Ein Verfahren nach Anspruch 1, **dadurch gekennzeichnet, dass** für die Speiseleitungen, die drei Endstellen haben, die Impedanz der äquivalenten Quelle $(\underline{Z}_{2SC})_{SUB\_A}$ für das Gegensystem sowie $(\underline{Z}_{Δ1SC})_{SUB\_A})$ für das inkrementelle Mitsystem unter der Annahme, dass der Kurzschluss in einer Sektion der Leitung LA aufgetreten ist, gemäß der nachstehenden Formel errechnet wird:

$$(\underline{Z}_{iSC})_{SUB\_A} = \left(\underline{Z}_{iLB} + (\underline{Z}_{iSB})_{SUB\_A}\right)\frac{\underline{I}_{Bi}}{\underline{I}_{Ci}} - \underline{Z}_{iLC}.$$

wobei folgendes gilt:

der tiefgestellte Index *i* nimmt den Wert *i* = 2 für das Gegensystem und *i* = Δ1 für das inkrementelle Mitsystem an,

$(\underline{Z}_{iSB})_{SUB\_A}$ - bezeichnet die Impedanz der äquivalenten Quelle für das Gegensystem und / oder für das inkrementelle Mitsystem, errechnet unter der Annahme, dass der Kurzschluss in einer Sektion der Leitung LA aufgetreten ist,

$\underline{Z}_{iLB}$ - bezeichnet die Impedanz der Sektion der Leitung LB für das Gegensystem und / oder für das Mitsystem, wobei $\underline{Z}_{Δ1LB} = \underline{Z}_{1LB}$,

$\underline{Z}_{1LB}$ - bezeichnet die Impedanz der Sektion der Leitung LB für das Mitsystem,

$\underline{Z}_{iLC}$ - bezeichnet die Impedanz der Sektion der Leitung LC für das Gegensystem und / oder die Impedanz der Sektion der Leitung LC für das inkrementelle Mitsystem, wobei $\underline{Z}_{2LC} = \underline{Z}_{1LC}$ und $\underline{Z}_{Δ1LC} = \underline{Z}_{1LC}$,

$\underline{Z}_{1LC}$ - bezeichnet die Impedanz der Sektion der Leitung LC für das Mitsystem

$\underline{I}_{Bi}$ - bezeichnet die Gegensystem-Komponente und / oder die inkrementelle Mitsystem-Komponente des am Leitungsende gemessenen Stroms,

$\underline{I}_{Ci}$ - bezeichnet die Gegensystem-Komponente und / oder die inkrementelle Mitsystem-Komponente des am Ende der Abzweigung gemessenen Stroms.

8. Ein Verfahren nach Anspruch 1, **dadurch gekennzeichnet, dass** für die Speiseleitungen, die drei Endstellen haben, die Impedanz der äquivalenten Quelle für das Gegensystem $(\underline{Z}_{2SB})_{SUB\_B}$ sowie für das inkrementelle Mitsystem $(\underline{Z}_{1SB})_{SUB\_B}$ unter der Annahme, dass der Kurzschluss in einer Sektion der Leitung LB aufgetreten ist, gemäß der nachstehenden Formel bestimmt wird:

$$(\underline{Z}_{iSB})_{SUB\_B} = \frac{(1 - d_B)\underline{Z}_{iLB}\,\underline{I}_{TBi}^{transf.} - d_B\,\underline{Z}_{iLB}\,\underline{I}_{Bi} - \underline{V}_{Ti}^{transf.}}{\underline{I}_{Bi}},$$

wobei folgendes gilt:

der tiefgestellte Index $i$ nimmt den Wert $i = 2$ für das Gegensystem und $i = \Delta 1$ für das inkrementelle Mitsystem an,
$d_\mathrm{B}$ - bezeichnet die Entfernung vom Leitungsende bis zur Kurzschlussstelle,
$\underline{Z}_{i\mathrm{LB}}$ - bezeichnet die Impedanz der Sektion der Leitung LB für das Gegensystem und / oder für das Mitsystem, wobei

$$\underline{Z}_{2\mathrm{LB}} = \underline{Z}_{1\mathrm{LB}} \text{ und } \underline{Z}_{\Delta 1\mathrm{LB}} = \underline{Z}_{1\mathrm{LB}} \,,$$

$\underline{Z}_{1\mathrm{LB}}$ - bezeichnet die Impedanz der Sektion der Leitung LB für das Mitsystem,

$\underline{I}_{\mathrm{TBi}}^{\mathrm{transf.}}$ - bezeichnet den Strom, der vom Knotenpunkt T bis zur Sektion der Leitung LB fließt, für das Gegensystem und / oder für das inkrementelle Mitsystem,
$\underline{I}_{\mathrm{Bi}}$ - bezeichnet die Gegensystem-Komponente und / oder die inkrementelle Mitsystem-Komponente des am Leitungsende gemessenen Stroms,

$\underline{V}_{\mathrm{Ti}}^{\mathrm{transf.}}$ - bezeichnet die Spannung am Knotenpunkt T für das Gegensystem und / oder für das inkrementelle Mitsystem.

**9.** Ein Verfahren nach Anspruch 1, **dadurch gekennzeichnet, dass** für die Speiseleitungen, die drei Endstellen haben, die Impedanz der äquivalenten Quelle für das Gegensystem $(\underline{Z}_{2\mathrm{SC}})_{\mathrm{SUB\_B}}$ sowie für das inkrementelle Mitsystem $(\underline{Z}_{\Delta 1\mathrm{SC}})_{\mathrm{SUB\_B}}$ unter der Annahme, dass der Kurzschluss in einer Sektion der Leitung LB aufgetreten ist, gemäß der nachstehenden Formel errechnet wird:

$$(\underline{Z}_{i\mathrm{SC}})_{\mathrm{SUB\_B}} = -\frac{\underline{V}_{\mathrm{Ci}}}{\underline{I}_{\mathrm{Ci}}} \,,$$

wobei folgendes gilt:

der tiefgestellte Index $i$ nimmt den Wert $i = 2$ für das Gegensystem und $i = \Delta 1$ für das inkrementelle Mitsystem an,
$\underline{V}_{\mathrm{Ci}}$ - bezeichnet die Gegensystem-Komponente und / oder die inkrementelle Mitsystem-Komponente der Spannung am Ende der Abzweigleitung,
$\underline{I}_{\mathrm{Ci}}$ - bezeichnet die Gegensystem-Komponente und / oder die inkrementelle Mitsystem-Komponente des am Ende der Abzweigung gemessenen Stroms.

**10.** Ein Verfahren nach Anspruch 1, **dadurch gekennzeichnet, dass** für die Speiseleitungen, die drei Endstellen haben, die Impedanz der äquivalenten Quelle für das Gegensystem $(\underline{Z}_{2\mathrm{SC}})_{\mathrm{SUB\_C}}$ sowie für das inkrementelle Mitsystem $(\underline{Z}_{\Delta 1\mathrm{SC}})_{\mathrm{SUB\_C}}$ unter der Annahme, dass der Kurzschluss in einer Sektion der Leitung LC aufgetreten ist, gemäß der nachstehenden Formel errechnet wird:

$$(\underline{Z}_{i\mathrm{SC}})_{\mathrm{SUB\_C}} = \frac{(1-d_\mathrm{C})\underline{Z}_{i\mathrm{LC}}\underline{I}_{\mathrm{TCi}}^{\mathrm{transf.}} - d_\mathrm{C}\underline{Z}_{i\mathrm{LC}}\underline{I}_{\mathrm{Ci}} - \underline{V}_{\mathrm{Ti}}^{\mathrm{transf.}}}{\underline{I}_{\mathrm{Ci}}} \,,$$

wobei folgendes gilt:

der tiefgestellte Index $i$ nimmt den Wert $i = 2$ für das Gegensystem und $i = \Delta 1$ für das inkrementelle Mitsystem an,
$d_\mathrm{C}$ - bezeichnet die Entfernung vom Ende der Abzweigleitung bis zur Kurzschlussstelle,
$\underline{Z}_{i\mathrm{LC}}$ - bezeichnet die Impedanz der Sektion der Leitung LC für das Gegensystem und / oder für das inkrementelle Mitsystem, wobei $\underline{Z}_{2\mathrm{LC}} = \underline{Z}_{1\mathrm{LC}}$ und $\underline{Z}_{\Delta 1\mathrm{LC}} = \underline{Z}_{1\mathrm{LC}}$,
$\underline{Z}_{1\mathrm{LC}}$ - bezeichnet die Impedanz der Sektion der Leitung LC für das Mitsystem,

$\underline{I}_{\mathrm{TCi}}^{\mathrm{transf.}}$ - bezeichnet den Strom, der vom Knotenpunkt T bis zur Sektion der Leitung LC fließt, für das Gegensystem und / oder für das inkrementelle Mitsystem,
$\underline{I}_{Ci}$ - bezeichnet die Gegensystem-Komponente und / oder die inkrementelle Mitsystem-Komponente des am Abzweigungsende gemessenen Stroms,

$\underline{V}_{Ti}^{transf.}$ - bezeichnet die Spannung am Knotenpunkt T für das Gegensystem und / oder für das inkrementelle Mitsystem.

**11.** Ein Verfahren nach Anspruch 1, **dadurch gekennzeichnet, dass** für die Speiseleitungen, die drei Endstellen haben, die Impedanz der äquivalenten Quelle für das Gegensystem $(\underline{Z}_{2SB})_{SUB\_C}$ sowie für das inkrementelle Mitsystem $(\underline{Z}_{\Delta1SB})_{SUB\_C}$ unter der Annahme, dass der Kurzschluss in einer Sektion der Leitung LC aufgetreten ist, gemäß der nachstehenden Formel errechnet wird:

$$(\underline{Z}_{iSB})_{SUB\_C} = -\frac{\underline{V}_{Bi}}{\underline{I}_{Bi}},$$

wobei folgendes gilt:

der tiefgestellte Index $i$ nimmt den Wert $i = 2$ für das Gegensystem und $i = \Delta1$ für das inkrementelle Mitsystem an,
$\underline{V}_{Bi}$ - bezeichnet das Gegensystem und / oder das inkrementelle Mitsystem der Spannung am Leitungsende,
$\underline{I}_{Bi}$ - bezeichnet die Gegensystem-Komponente und / oder die inkrementelle Mitsystem-Komponente des am Leitungsende gemessenen Stroms.

**12. Ein Verfahren gemäß Anspruch 1, dadurch gekennzeichnet, dass** für Speiseleitungen mit mehreren Abzweigungen die Entfernungen vom Anfang der Leitung bis zur Kurzschlussstelle $(d_1)$, vom Ende der Leitung bis zur Kurzschlussstelle $(d_{(2n-3)})$, vom Ende der Leitung bis zur Kurzschlussstelle $(d_{(2k-2)})$, vom Knotenpunkt bis zur Kurzschlussstelle in der Sektion der Leitung zwischen zwei Knotenpunkten $(d_{(2k-1)})$ aus nachstehenden Gleichungen bestimmt werden:

$$d_1 = \frac{\text{real}(\underline{V}_{1p})\text{imag}(\underline{I}_F) - \text{imag}(\underline{V}_{1p})\text{real}(\underline{I}_F)}{\text{real}(\underline{Z}_{1L1}\underline{I}_{1p})\text{imag}(\underline{I}_F) - \text{imag}(\underline{Z}_{1L1}\underline{I}_{1p})\text{real}(\underline{I}_F)},$$

$$d_{(2n-3)} = \frac{-\text{real}(\underline{V}_{T(n-1)np} - \underline{Z}_{1L(2n-3)}\underline{I}_{T(n-1)np})\text{imag}(\underline{I}_F) + \text{imag}(\underline{V}_{T(n-1)np} - \underline{Z}_{1L(2n-3)}\underline{I}_{T(n-1)np})\text{real}(\underline{I}_F)}{\text{real}(\underline{Z}_{1L(2n-3)}\underline{I}_{T(n-1)np})\text{imag}(\underline{I}_F) - \text{imag}(\underline{Z}_{1L(2n-3)}\underline{I}_{T(n-1)np})\text{real}(\underline{I}_F)}$$

$$d_{(2k-2)} = \frac{-\text{real}(\underline{V}_{Tkkp} - \underline{Z}_{1L(2k-2)}\underline{I}_{Tkkp})\text{imag}(\underline{I}_F) + \text{imag}(\underline{V}_{Tkkp} - \underline{Z}_{1L(2k-2)}\underline{I}_{Tkkp})\text{real}(\underline{I}_F)}{\text{real}(\underline{Z}_{1L(2k-2)}\underline{I}_{Tkkp})\text{imag}(\underline{I}_F) - \text{imag}(\underline{Z}_{1L(2k-2)}\underline{I}_{Tkkp})\text{real}(\underline{I}_F)},$$

$$d_{(2k-1)} = \frac{-\text{real}(\underline{V}_{TkT(k+1)p} - \underline{Z}_{1L(2k-1)}\underline{I}_{TkT(k+1)p})\text{imag}(\underline{I}_F) + \text{imag}(\underline{V}_{TkT(k+1)p} - \underline{Z}_{1L(2k-1)}\underline{I}_{TkT(k+1)p})\text{real}(\underline{I}_F)}{\text{real}(\underline{Z}_{1L(2k-1)}\underline{I}_{TkT(k+1)p})\text{imag}(\underline{I}_F) - \text{imag}(\underline{Z}_{1L(2k-1)}\underline{I}_{TkT(k+1)p})\text{real}(\underline{I}_F)}$$

wobei folgendes gilt:

$\underline{V}_{1p}$ - bezeichnet die Spannung der Kurzschlussschleife, errechnet unter der Annahme, dass der Kurzschluss in der ersten Sektion der Leitung L1 aufgetreten ist,
$\underline{I}_{1p}$ - bezeichnet den Strom der Kurzschlussschleife, errechnet unter der Annahme, dass der Kurzschluss in der ersten Sektion der Leitung L1 aufgetreten ist,
$\underline{V}_{T(n-1)np}$ - bezeichnet die Spannung der Kurzschlussschleife, errechnet unter der Annahme, dass der Kurzschluss in der ersten Sektion der Leitung L(2n-3) aufgetreten ist,

$\underline{I}_{T(n-1)np}$ - bezeichnet den Strom der Kurzschlussschleife, errechnet unter der Annahme, dass der Kurzschluss in der ersten Sektion der Leitung L(2n-3) aufgetreten ist,

$\underline{V}_{Tkkp}$ - bezeichnet die Spannung der Kurzschlussschleife, errechnet unter der Annahme, dass der Kurzschluss in der k-ten Abzweigung der Leitung aufgetreten ist,

$\underline{I}_{Tkkp}$ - bezeichnet den Strom der Kurzschlussschleife, errechnet unter der Annahme, dass der Kurzschluss in der k-ten Abzweigung der Leitung aufgetreten ist,

$\underline{V}_{TkT(k+1)p}$ - bezeichnet die Spannung der Kurzschlussschleife, errechnet unter der Annahme, dass der Kurzschluss in einer Sektion der Leitung zwischen zwei Knotenpunkten aufgetreten ist,

$\underline{I}_{TkT(k+1)p}$ - bezeichnet den Strom der Kurzschlussschleife, errechnet unter der Annahme, dass der Kurzschluss in einer Sektion der Leitung zwischen zwei Knotenpunkten aufgetreten ist,

$\underline{I}_{F}$ - Kurzschlussgesamtstrom,

$\underline{Z}_{1L1}$ - Impedanz der Sektion der Leitung L1 für das Mitsystem,

$\underline{Z}_{0L1}$ - Impedanz der Sektion der Leitung L1 für das Nullsystem,

$\underline{Z}_{1L(2n-3)}$ - Impedanz der Sektion der Leitung L(2n-3) für das Mitsystem,

$\underline{Z}_{0L(2n-3)}$ - Impedanz der Sektion der Leitung L(2n-3) für das Nullsystem,

$\underline{Z}_{1L(2k-2)}$ - Impedanz der Sektion der Leitung L(2k-2) für das Mitsystem,

$\underline{Z}_{0L(2k-2)}$ - Impedanz der Sektion der Leitung L(2k-2) für das Nullsystem,

$\underline{Z}_{1L(2k-1)}$ - Impedanz der Sektion der Leitung L(2k-1) für das Mitsystem,

$\underline{Z}_{0L(2k-1)}$ - Impedanz der Sektion der Leitung L(2k-1) für das Nullsystem,

k - Nummer des Knotenpunktes,

n - Nummer des Leitungsendes.

**13. Ein Verfahren gemäß Anspruch 1, dadurch gekennzeichnet, dass** für Speiseleitungen mit mehreren Abzweigungen die Widerstände des Durchganges $(R_{1F})$, $(R_{(2n-3)F})$, $(R_{(2k-2)F})$, $(R_{(2k-1)F})$ aus folgenden Gleichungen bestimmt werden:

$$R_{1F} = \frac{1}{2}\left[\frac{\mathrm{real}(\underline{V}_{1p}) - d_1\mathrm{real}(\underline{Z}_{1L1}\underline{I}_{1p})}{\mathrm{real}(\underline{I}_F)} + \frac{\mathrm{imag}(\underline{V}_{1p}) - d_1\mathrm{imag}(\underline{Z}_{1L1}\underline{I}_{1p})}{\mathrm{imag}(\underline{I}_F)}\right],$$

$$R_{(2n-3)F} = \frac{1}{2}\left[\frac{\mathrm{real}(\underline{V}_{T(n-1)np}) - (1-d_{(2n-3)}) \cdot real(\underline{Z}_{1L(2n-3)}\underline{I}_{T(n-1)np})}{\mathrm{real}(\underline{I}_F)}\right] +$$
$$+ \frac{1}{2}\left[\frac{\mathrm{imag}(\underline{V}_{T(n-1)np}) - (1-d_{(2n-3)}) \cdot imag(\underline{Z}_{1(2n-3)}\underline{I}_{T(n-1)np})}{\mathrm{imag}(\underline{I}_F)}\right],$$

$$R_{(2k-2)F} = \frac{1}{2}\left[\frac{\mathrm{real}(\underline{V}_{Tkkp}) - (1-d_{(2k-2)}) \cdot real(\underline{Z}_{1L(2k-2)}\underline{I}_{Tkkp})}{\mathrm{real}(\underline{I}_F)}\right] +$$
$$+ \frac{1}{2}\left[\frac{\mathrm{imag}(\underline{V}_{Tkkp}) - (1-d_{(2k-2)}) \cdot imag(\underline{Z}_{1L(2k-2)}\underline{I}_{Tkkp})}{\mathrm{imag}(\underline{I}_F)}\right]$$

$$R_{(2k-1)F} = \frac{1}{2}\left[\frac{\mathrm{real}(\underline{V}_{TkT(k+1)p}) - (1-d_{(2k-1)}) \cdot real(\underline{Z}_{1L(2k-1)}\underline{I}_{TkT(k+1)p})}{\mathrm{real}(\underline{I}_F)}\right] +$$
$$+ \frac{1}{2}\left[\frac{\mathrm{imag}(\underline{V}_{TkT(k+1)p}) - (1-d_{(2k-1)}) \cdot imag(\underline{Z}_{1L(2k-1)}\underline{I}_{TkT(k+1)p})}{\mathrm{imag}(\underline{I}_F)}\right]$$

wobei folgendes gilt:

$d_1$ - Entfernung zum Kurzschluss vom Leitungsanfang bis zur Kurzschlussstelle,

$d_{(2n-3)}$ - Entfernung zum Kurzschluss vom Leitungsende bis zur Kurzschlussstelle,

$d_{(2k-2)}$ - Entfernung zum Kurzschluss vom Ende der Abzweigleitung bis zur Kurzschlussstelle,

$d_{(2k-1)}$ - Entfernung zum Kurzschluss in der Sektion der Leitung zwischen zwei Knotenpunkten,

$\underline{V}_{1p}$ - Spannung der Kurzschlussschleife, errechnet unter der Annahme, dass der Kurzschluss in der ersten Sektion der Leitung L1 aufgetreten ist,

$\underline{I}_{1p}$ - Strom der Kurzschlussschleife, errechnet unter der Annahme, dass der Kurzschluss in der ersten Sektion der Leitung L1 aufgetreten ist,

$\underline{V}_{T(n-1)np}$ - Spannung der Kurzschlussschleife, errechnet unter der Annahme, dass der Kurzschluss in der Sektion der Leitung L(2n-3) aufgetreten ist,

$\underline{I}_{T(n-1)np}$ - Strom der Kurzschlussschleife, errechnet unter der Annahme, dass der Kurzschluss in der Sektion der Leitung L(2n-3) aufgetreten ist,

$\underline{V}_{Tkkp}$ - Spannung der Kurzschlussschleife, errechnet unter der Annahme, dass der Kurzschluss in der k-ten Abzweigleitung aufgetreten ist,

$\underline{I}_{Tkkp}$ - Strom der Kurzschlussschleife, errechnet unter der Annahme, dass der Kurzschluss in der k-ten Abzweigleitung aufgetreten ist,

$\underline{V}_{TkT(k+1)p}$ - Spannung der Kurzschlussschleife, errechnet unter der Annahme, dass der Kurzschluss in einer Sektion der Leitung zwischen zwei Knotenpunkten aufgetreten ist,

$\underline{I}_{TkT(k+1)p}$ - Strom der Kurzschlussschleife, errechnet unter der Annahme, dass der Kurzschluss in einer Sektion der Leitung zwischen zwei Knotenpunkten aufgetreten ist,

$\underline{I}_F$ - Kurzschlussgesamtstrom,

$\underline{Z}_{1L1}$ - Impedanz der Sektion der Leitung L1 für das Mitsystem,

$\underline{Z}_{0L1}$ - Impedanz der Sektion der Leitung L1 für das Nullsystem,

$\underline{Z}_{1L(2n-3)}$ - Impedanz der Sektion der Leitung L(2n-3) für das Mitsystem,

$\underline{Z}_{0L(2n-3)}$ - Impedanz der Sektion der Leitung L(2n-3) für das Nullsystem,

$\underline{Z}_{1L(2k-2)}$ - Impedanz der Sektion der Leitung L(2k-2) für das Mitsystem,

$\underline{Z}_{0L(2k-2)}$ - Impedanz der Sektion der Leitung L(2k-2) für das Nullsystem,

$\underline{Z}_{1L(2k-1)}$ - Impedanz der Sektion der Leitung L(2k-1) für das Mitsystem,

$\underline{Z}_{0L(2k-1)}$ - Impedanz der Sektion der Leitung L(2k-1) für das Nullsystem,

k - Nummer des Knotenpunktes,

n - Nummer des Leitungsendes.

**14. Ein Verfahren nach Anspruch 1, dadurch gekennzeichnet, dass** für Speiseleitungen mit mehreren Abzweigungen die Impedanz der äquivalenten Quelle für das Gegensystem ($\underline{Z}_{2S1}$) sowie für das inkrementelle Mitsystem ($\underline{Z}_{\Delta 1S1}$) unter der Annahme, dass der Kurzschluss in der Sektion der Leitung zwischen dem Linienanfang und dem ersten Knotenpunkt aufgetreten ist, nach der nachstehenden Formel errechnet wird:

$$(\underline{Z}_{iS1}) = \frac{-\underline{V}_{1i}}{\underline{I}_{1i}}$$

wobei folgendes gilt:

i = 2 für das Gegensystem, $\Delta 1$ für das inkrementelle Mitsystem,

$\underline{V}_{1i}$ - Spannung, gemessen in der Station 1 (erster unterer Index) für die gegebene symmetrische Komponente (zweiter unterer Index), das heißt für die Gegensystem-Komponente - Index 2 und für die inkrementelle Mitsystem-Komponente - Index $\Delta 1$,

$\underline{I}_{1i}$ - Strom, gemessen in der Station 1 (erster unterer Index) für die gegebene symmetrische Komponente (zweiter unterer Index), das heißt für die Gegensystem-Komponente - Index 2 und für die inkrementelle Mitsystem-Komponente - Index $\Delta 1$.

**15. Ein Verfahren nach Anspruch 1, dadurch gekennzeichnet, dass** für Speiseleitungen mit mehreren Abzweigungen die Impedanz der äquivalenten Quelle (($\underline{Z}_{2S(n)}$)) für das Gegensystem sowie (($\underline{Z}_{\Delta 1S(n)}$)) für das inkrementelle Mitsystem unter der Annahme, dass der Kurzschluss in der Sektion der Leitung zwischen dem Linienende und dem Endknotenpunkt aufgetreten ist, nach der nachstehenden Formel errechnet wird:

$$(\underline{Z}_{iSn}) = -\frac{\underline{V}_{T(n-1)i}^{transf.} - (1-d_{(2n-3)}) \cdot \underline{Z}_{iL(2n-3)} \cdot \underline{I}_{T(n-1)ni}^{transf.} - d_{(2n-3)} \cdot \underline{Z}_{iL(2n-3)} \cdot (\underline{I}_{T(n-1)ni}^{transf.} - \underline{I}_{Fi})}{\underline{I}_{ni}}$$

wobei folgendes gilt:

i = 2 für das Gegensystem, Δ1 für das inkrementelle Mitsystem,

$\underline{V}_{T(n-1)i}^{transf.}$ - Spannung am Endknotenpunkt T(n-1) für das Gegensystem i = 2, oder für das inkrementelle Mitsystem i = Δ1,

$d_{(2n-3)}$ - Entfernung vom Leitungsende bis zur Kurzschlussstelle,

$\underline{Z}_{iL(2n-3)}$ - Impedanz der Sektion der Leitung L(2n-3) für das Gegensystem i = 2, oder für das inkrementelle Mitsystem i = Δ1,

$\underline{I}_{T(n-1)ni}^{transf.}$ - Werte des fließenden Stroms vom Knotenpunkt T(n-1) bis zur Station n in der Sektion der Leitung L(2n-3) für das Gegensystem i = 2, oder für das inkrementelle Mitsystem 1 = Δ1,

$\underline{I}_{Fi}$ - Kurzschlussgesamtstrom für das Gegensystem i = 2, oder für das inkrementelle Mitsystem i = Δ1,

$\underline{I}_{ni}$ - Strom, gemessen in der letzten Station n (erster unterer Index) für die gegebene symmetrische Komponente (zweiter unterer Index), das heißt für die Gegensystem-Komponente - Index 2 und für die inkrementelle Mitsystem-Komponente - Index Δ1.

16. **Ein Verfahren nach Anspruch 1, dadurch gekennzeichnet, dass** für Speiseleitungen mit mehreren Abzweigungen die Impedanz der äquivalenten Quelle für das Gegensystem (($\underline{Z}_{2Sk}$)) sowie für das inkrementelle Mitsystem ($\underline{Z}_{Δ1Sk}$)) unter der Annahme bestimmt wird, dass der Kurzschluss in der Abzweigleitung aufgetreten ist:

$$(\underline{Z}_{iSk}) = -\frac{\underline{V}_{Tki}^{transf.} - (1-d_{(2k-2)}) \cdot \underline{Z}_{iL(2k-2)} \cdot \underline{I}_{Tkki}^{transf.} - d_{(2k-2)} \cdot \underline{Z}_{iL(2k-2)} \cdot (\underline{I}_{Tkki}^{transf.} - \underline{I}_{F2})}{\underline{I}_{ki}} \; .$$

wobei folgendes gilt:

$\underline{V}_{Tki}^{transf.}$ - Spannung im k-ten Knotenpunkt für das Gegensystem i = 2, oder für das inkrementelle Mitsystem i = Δ1,

$d_{(2k-2)}$ - Entfernung vom Ende der Abzweigleitung bis zur Kurzschlussstelle Tk,

$\underline{Z}_{iL(2k+2)}$ - Impedanz der Sektion der Leitung L(2k-2) für das Gegensystem i = 2, oder für das inkrementelle Mitsystem i = Δ1,

$\underline{I}_{Tkki}^{transf.}$ - Werte des fließenden Stroms vom Knotenpunkt Tk bis zur k-ten Station in der Sektion der Abzweigleitung L(2k-2) für das Gegensystem i = 2, oder für das inkrementelle Mitsystem i = Δ1,

$\underline{I}_{Fi}$ - Kurzschlussgesamtstrom für das Gegensystem i = 2, oder für das inkrementelle Mitsystem i = Δ1,

$\underline{I}_{ki}$ - Strom, gemessen in der k-ten Station (erster unterer Index) für die gegebenen symmetrischen Komponenten (zweiter unterer Index), das heißt für die Gegensystem-Komponente - Index 2 und für die inkrementelle Mitsystem-Komponente - Index Δ1.

17. **Ein Verfahren nach Anspruch 1, dadurch gekennzeichnet, dass** für Speiseleitungen mit mehreren Abzweigungen die Impedanzen der äquivalenten Quellen für das Gegensystem (($\underline{Z}_{2Sk}$) und ($\underline{Z}_{2S(k+1)}$)) sowie für das inkrementelle Mitsystem (($\underline{Z}_{Δ1Sk}$) und ($\underline{Z}_{Δ1S(k+1)}$)) unter der Annahme, dass der Kurzschluss in einer Sektion der Leitung zwischen zwei Knotenpunkten aufgetreten ist, aus der nachstehenden Gleichung bestimmt werden:

$$(\underline{Z}_{iSk}) = -\frac{\underline{V}_{Tki}^{transf.} - d_{(2k-1)} \cdot \underline{Z}_{iL(2k-1)} \cdot \underline{I}_{TkT(k+1)i}^{transf.} - (1-d_{(2k-1)}) \cdot \underline{Z}_{iL(2k-1)} \cdot (\underline{I}_{TkT(k+1)i}^{transf.} - \underline{I}_{Fi}) + \underline{Z}_{iLk} \underline{I}_{ki}}{\underline{I}_{ki}}$$

$$(\underline{Z}_{iS(k+1)}) = -\frac{\underline{V}_{Tki}^{transf.} - d_{(2k-1)} \cdot \underline{Z}_{iL(2k-1)} \cdot \underline{I}_{TkT(k+1)i}^{transf.} - (1 - d_{(2k-1)}) \cdot \underline{Z}_{iL(2k-1)} \cdot (\underline{I}_{TkT(k+1)i}^{transf.} - \underline{I}_{Fi}) + \underline{Z}_{iL(2k)} \underline{I}_{(k+1)i}}{\underline{I}_{(k+1)i}}.$$

wobei folgendes gilt:

$\underline{V}_{Tki}^{transf.}$ - Spannung im k-ten Knotenpunkt für das Gegensystem i = 2, oder für das inkrementelle Mitsystem i = Δ1,

$d_{(2k-1)}$ - Entfernung zum Kurzschluss in einer Sektion der Leitung zwischen zwei Knotenpunkten,

$\underline{Z}_{iL(2k-1)}$ - Impedanz der Sektion der Leitung L(2k-1) für das Gegensystem i = 2, oder für das inkrementelle Mitsystem i = Δ1,

$\underline{I}_{TkT(k+1)i}^{transf.}$ - fließender Strom vom Knotenpunkt Tk bis zum Knotenpunkt T(k+1) in der Sektion der Leitung für das Gegensystem i = 2, oder für das inkrementelle Mitsystem i = Δ1,

$\underline{I}_{Fi}$ - Kurzschlussgesamtstrom für das Gegensystem i = 2, oder für das inkrementelle Mitsystem i = Δ1,

$\underline{I}_{ki}$ - Strom, gemessen in der k-ten Station (erster unterer Index) für die gegebene symmetrische Komponente (zweiter unterer Index), das heißt für die Gegensystem-Komponente - Index 2 und für die inkrementelle Mitsystem-Komponente - Index Δ1,

$\underline{I}_{(k+1)i}$ - Strom, gemessen in der Station k+1 (erster unterer Index) für die gegebene symmetrische Komponente (zweiter unterer Index), das heißt für die Gegensystem-Komponente - Index 2 und für die inkrementelle Mitsystem-Komponente - Index Δ1.

## Revendications

**1.** Procédé de localisation des défauts sur les lignes électriques dans lequel est utilisée la répartition des lignes de transmission du système de transport ou de distribution en sections, **caractérisé en ce que**

- dans tous les postes terminaux des lignes du système on mesure le courant correspondant aux conditions de défauts et existant avant les défauts,
- dans un poste terminal du système on mesure la tension de phase de la ligne correspondant aux conditions de défauts et existant avant les défauts,
- on calcule les composantes symétriques des signaux de courant et de tension mesurés et le courant de défaut total au point de défaut,
- on pose un point hypothétique de défaut situé dans une des sections de ligne,
- on pose un premier point hypothétique de défaut situé dans la section de ligne entre le début de la ligne et un premier noeud de dérivation, un deuxième point de défaut situé dans la section de ligne entre l'extrémité de la ligne et le dernier noeud de dérivation, et les points hypothétiques de défaut successifs situés dans chaque dérivation raccordée à la ligne, tandis que pour pour les lignes avec multiples dérivations, qui ont plus de trois postes, les points hypothétiques de défaut successifs situés dans chaque section de ligne entre deux noeuds de dérivation successifs sont posés complémentairement,
- on calcule la distance entre le début de la ligne et le point de défaut dans la section de ligne entre le début de la ligne et le premier noeud de dérivation, la distance entre l'extrémité de la ligne et le point de défaut dans la section de ligne entre l'extrémité de la ligne et le dernier noeud de dérivation, la distance entre l'extrémité de la dérivation et le point de défaut dans chaque dérivation de ligne, tandis que pour les lignes avec multiples dérivations, on calcule la distance entre le noeud de dérivation et le point de défaut situé dans chaque section de ligne entre deux noeuds de dérivation, et, ensuite, pour tous les points hypothétiques de défaut de chacune des sections, on calcule la résistance de défaut,
- on sélectionne le point réel de défaut, en premier lieu, par une comparaison des valeurs numériques concernant les distances préalablement calculées et on rejette les résultats aux valeurs numériques négatives ou supérieures à 1 dans les unités correspondantes, et, en deuxième lieu, on analyse les valeurs calculées des résistances de défauts correspondant aux points de défaut, puis, on rejette les résultats des calculs correspondant à une valeur négative, et, enfin, si, après ces calculs, il s'avère que seulement une valeur numérique correspondant à la distance de défaut est comprise entre zéro et un en unités correspondantes, et la résistance de défaut au point de défaut calculée pour cette distance est positive ou égale à zéro, on pose cette distance de défaut comme finale, indiquant la distance actuelle de défaut et la valeur de la résistance de défaut correspondant au point de défaut,

- si, après la sélection du point de défaut réel, il s'avère qu'au moins deux valeurs numériques concernant les distances préalablement calculées sont contenues entre zéro et un en unités correspondantes et les valeurs de résistances de défaut calculées correspondant à ces points de défaut sont positives ou égales à zéro, on détermine les modules des impédances de systèmes d'alimentation équivalents pour la composante inverse pour les défauts monophasés, biphasés et biphasés-terre ou pour la composante directe progressive pour défauts triphasés et dans l'hypothèse que le défaut s'est produit dans une section déterminée, tandis que pour les lignes avec multiples dérivations lors de la détermination des impédances de systèmes d'alimentation équivalents on vérifie, de plus, si les valeurs calculées des impédances de systèmes d'alimentation équivalents sont contenues dans le premier quadrant du système de coordonnées cartésiennes du système intégré et on rejette ces valeurs de distance de défaut pour lesquelles les valeurs calculées des impédances de systèmes d'alimentation équivalents ne sont pas placées dans le premier quadrant du système de coordonnées cartésiennes du système intégré, et s'il s'avère que seulement une valeur des impédances de systèmes d'alimentation équivalents contenant les distances de défaut est contenue dans le premier quadrant du système de coordonnées cartésiennes du système intégré, alors cette distance de défaut, pour cette valeur de l'impédance, est posée comme finale, en revanche, s'il s'avère qu'au moins deux valeurs des impédances de systèmes d'alimentation équivalents contenant les distances de défaut sont placées dans le premier quadrant du système de coordonnées cartésiennes du système intégré alors ces valeurs des modules des impédances de systèmes d'alimentation équivalents sont utilisées dans l'étape suivante,

la distance de défaut, pour laquelle le module de l'impédance de systèmes d'alimentation équivalents correspond le mieux aux valeurs réalistes, déterminant réellement la charge ou l'alimentation du système, est admis comme le résultat final.

2. Procédé selon la revendication 1 **caractérisé en ce que** le calcul du courant de défaut total est fait en tenant compte des coefficients de participation déterminant les relations entre les composantes symétriques respectives du courant total où la chute de tension sur la résistance de défaut est estimée, et, pour cette opération, est utilisé un ensemble de ces coefficients.

3. Procédé selon la revendication 1 **caractérisé en ce que**, pour les défauts biphasés-terre, on élimine la composante directe dans le calcul du courant de défaut total, et pour les composantes inverse et homopolaire on pose les valeurs suivantes des coefficients de participation déterminant les relations entre les composantes symétriques respectives du courant total où la chute de tension sur la résistance de défaut est estimée:

$$\underline{a}_{\mathrm{F1}} = 0 \;,$$

$$\underline{a}_{\mathrm{F2}} = \underline{a}_{\mathrm{F2}}^{\mathrm{init.}} - \frac{\underline{a}_{\mathrm{F1}}^{\mathrm{init.}}\, \underline{b}_{\mathrm{F2}}}{\underline{b}_{\mathrm{F1}}} \;,$$

$$\underline{a}_{\mathrm{F0}} = \frac{\underline{a}_{\mathrm{F1}}^{\mathrm{init.}}}{\underline{b}_{\mathrm{F1}}} \;,$$

où :

$\underline{a}_{\mathrm{F1}}^{\mathrm{init.}}$ , $\underline{a}_{\mathrm{F2}}^{\mathrm{init.}}$ , $\underline{a}_{\mathrm{F0}}^{\mathrm{init.}}$ -désignent les coefficients initiaux de participation des composantes symétriques du courant total dans la détermination de la chute de tension de résistance,
$\underline{b}_{\mathrm{F1}}, \underline{b}_{\mathrm{F2}}$ - désignent les coefficients de relation déterminés par la relation entre la composante homopolaire et les autres composantes du courant total de défaut passant par la résistance de défaut.

4. Procédé selon la revendication 1 **caractérisé en ce que** pour les lignes d'alimentation qui ont trois postes terminaux, les distances entre le début de la ligne et le point de défaut $d_A$, entre l'extrémité de la ligne et le point de défaut $d_B$, entre l'extrémité de la dérivation et le point de défaut $d_C$, sont déterminées à partir des équations suivantes:

$$d_A = \frac{\text{real}(\underline{V}_{Ap})\text{imag}(\underline{I}_F) - \text{imag}(\underline{V}_{Ap})\text{real}(\underline{I}_F)}{\text{real}(\underline{Z}_{1LA}\underline{I}_{Ap})\text{imag}(\underline{I}_F) - \text{imag}(\underline{Z}_{1LA}\underline{I}_{Ap})\text{real}(\underline{I}_F)} \ ,$$

$$d_B = \frac{-\text{real}(\underline{V}_{Tp} - \underline{Z}_{1LB}\underline{I}_{TBp})\text{imag}(\underline{I}_F) + \text{imag}(\underline{V}_{Tp} - \underline{Z}_{1LB}\underline{I}_{TBp})\text{real}(\underline{I}_F)}{\text{real}(\underline{Z}_{1LB}\underline{I}_{TBp})\text{imag}(\underline{I}_F) - \text{imag}(\underline{Z}_{1LB}\underline{I}_{TBp})\text{real}(\underline{I}_F)} \ ,$$

$$d_C = \frac{-\text{real}(\underline{V}_{Tp} - \underline{Z}_{1LC}\underline{I}_{TCp})\text{imag}(\underline{I}_F) + \text{imag}(\underline{V}_{Tp} - \underline{Z}_{1LC}\underline{I}_{TCp})\text{real}(\underline{I}_F)}{\text{real}(\underline{Z}_{1LC}\underline{I}_{TCp})\text{imag}(\underline{I}_F) - \text{imag}(\underline{Z}_{1LC}\underline{I}_{TCp})\text{real}(\underline{I}_F)} \ ,$$

où :

« real » désigne la partie réelle de la valeur donnée,

« imag » désigne la partie imaginaire de la valeur donnée,

$\underline{V}_{Ap}$ - désigne la tension de la boucle de défaut désignée dans l'hypothèse que le défaut s'est produit dans la section LA,

$\underline{V}_{Tp}$ - désigne la tension de la boucle de défaut désignée dans l'hypothèse que le défaut s'est produit dans la section LB ou LC,

$\underline{I}_{Ap}$ - désigne le courant de la boucle de défaut désigné dans l'hypothèse que le défaut s'est produit dans la section LA,

$\underline{I}_{TBp}$ - désigne le courant de la boucle de défaut désigné dans l'hypothèse que le défaut s'est produit dans la section LB,

$\underline{I}_{TCp}$ - désigne le courant de la boucle de défaut désigné dans l'hypothèse que le défaut s'est produit dans la section dans la section de ligne LC,

$\underline{I}_F$ - désigne le courant de défaut total,

$\underline{Z}_{1LA} = R_{1LA} + j\omega_1 L_{1LA}$ - désigne l'impédance de la section de ligne LA pour la composante directe,

$\underline{Z}_{1LB} = R_{1LB} + j\omega_1 L_{1LB}$ - désigne l'impédance de la section de ligne LB pour la composante directe,

$\underline{Z}_{1LC} = R_{1LC} + j\omega_1 L_{1LC}$ - désigne l'impédance de la section de ligne LC pour la composante directe,

$R_{1LA}, R_{1LB}, R_{1LC}$ - résistance pour la composante directe pour la section de ligne LA, LB, LC, respectivement,

$L_{1LA}, L_{1LB}, L_{1LC}$ - inductance pour la composante directe pour la section de ligne LA, LB, LC, respectivement,

$\omega_1$ - pulsation pour la fréquence fondamentale.

5. Procédé selon la revendication 1 **caractérisé en ce que** pour les lignes d'alimentation qui ont trois postes terminaux, la résistance de défaut $R_{FA}$, $R_{FB}$, $R_{FC}$ est déterminée à partir des équations suivantes:

$$R_{FA} = \frac{1}{2}\left[\frac{\text{real}(\underline{V}_{Ap}) - d_A\text{real}(\underline{Z}_{1LA}\underline{I}_{Ap})}{\text{real}(\underline{I}_F)} + \frac{\text{imag}(\underline{V}_{Ap}) - d_A\text{imag}(\underline{Z}_{1LA}\underline{I}_{Ap})}{\text{imag}(\underline{I}_F)}\right],$$

$$R_{FB} = \frac{1}{2}\left[\frac{\text{real}(\underline{V}_{Tp}) - (1-d_B)\cdot\text{real}(\underline{Z}_{1LB}\underline{I}_{TBp})}{\text{real}(\underline{I}_F)}\right] + \frac{1}{2}\left[\frac{\text{imag}(\underline{V}_{Tp}) - (1-d_B)\cdot\text{imag}(\underline{Z}_{1LB}\underline{I}_{TBp})}{\text{imag}(\underline{I}_F)}\right]$$

$$R_{FC} = \frac{1}{2}\left[\frac{\text{real}(\underline{V}_{Tp}) - (1-d_C)\cdot\text{real}(\underline{Z}_{1LC}\underline{I}_{TCp})}{\text{real}(\underline{I}_F)}\right] + \frac{1}{2}\left[\frac{\text{imag}(\underline{V}_{Tp}) - (1-d_C)\cdot\text{imag}(\underline{Z}_{1LC}\underline{I}_{TCp})}{\text{imag}(\underline{I}_F)}\right]$$

où :

« real » désigne la partie réelle de la valeur donnée,

« imag » désigne la partie imaginaire de la valeur donnée,

$\underline{V}_{Ap}$ - désigne la tension de la boucle de défaut calculée pour l'hypothèse que le défaut s'est produit dans la section LA,

$\underline{V}_{Tp}$ - désigne la tension de la boucle de défaut calculée pour l'hypothèse que le défaut s'est produit dans la section LB ou LC,

$\underline{I}_{Ap}$ - désigne le courant de la boucle de défaut calculé pour l'hypothèse que le défaut s'est produit dans la section LA,

$\underline{I}_{TBp}$ - désigne le courant de la boucle de défaut calculé pour l'hypothèse que le défaut s'est produit dans la section LB,

$\underline{I}_{TCp}$ - désigne le courant de la boucle de défaut calculé pour l'hypothèse que le défaut s'est produit dans la section de ligne LC,

$\underline{I}_F$ - désigne le courant de défaut total,

$\underline{Z}_{1LA} = R_{1LA} + j\omega_1 L_{1LA}$ - désigne l'impédance de la section de ligne LA pour la composante directe,

$\underline{Z}_{1LB} = R_{1Lb} + j\omega_1 L_{1LB}$ - désigne l'impédance de la section de ligne LB pour la composante directe,

$\underline{Z}_{1LC} = R_{1LC} + j\omega_1 L_{1LC}$ - désigne l'impédance de la section de ligne LC pour la composante directe,

$R_{1LA}$, $R_{1LB}$, $R_{1LC}$ - résistance pour la composante directe pour la section de ligne LA, LB, LC, respectivement,

$L_{1LA}$, $L_{1LB}$, $L_{1LC}$ - inductance pour la composante directe pour la section de ligne LA, LB, LC, respectivement,

$\omega_1$ - pulsation pour la fréquence fondamentale,

$d_A$ - désigne la distance entre le début de la ligne et le point de défaut,

$d_B$ - désigne la distance entre l'extrémité de la ligne et le point de défaut,

$d_C$ - désigne la distance entre l'extrémité de la dérivation et le point de défaut.

6.  Procédé selon la revendication 1 **caractérisé en ce que** pour les lignes d'alimentation qui ont trois postes terminaux, on calcule les impédances de la source équivalente pour la composante inverse ($(\underline{Z}_{2SB})_{SUB\_A}$) et pour la composante directe progressive ($(\underline{Z}_{\Delta1B})_{SUB\_A}$) dans l'hypothèse que le défaut s'est produit dans la section de ligne LA, selon la formule :

$$(\underline{Z}_{iSB})_{SUB\_A} = \frac{\underline{G}_{iA}\,\underline{I}_{A2} - \underline{H}_{iA}\,\underline{I}_{FAi}}{\underline{Q}_{BCi}(\underline{I}_{FAi} - \underline{I}_{Ai})}\,,$$

où :

indice inférieur $i$ prend la valeur $i=2$ pour la composante inverse, $i=\Delta1$ pour la composante directe progressive,

$\underline{G}_{iA}$ - désigne le premier facteur analytique pour la composante inverse, déterminé sur la base de l'analyse du système de substitution tel qu'illustré en figure 11 et/ou pour la composante directe progressive déterminé analytiquement sur la base du système de substitution tel qu'illustré en figure 12,

$\underline{I}_{Ai}$ - désigne la composante inverse et/ou la composante directe progressive du courant mesuré au début de la ligne,

$\underline{H}_{iA}$ - désigne deuxième facteur analytique pour la composante inverse déterminé sur la base de l'analyse du système de substitution tel qu'illustré en figure 11 et/ou pour la composante directe progressive déterminé analytiquement sur la base du système de substitution tel qu'illustré en figure 12,

$\underline{I}_{FAi}$ - désigne la composante inverse du courant de défaut total, déterminé sur la base de l'analyse du système de substitution tel qu'illustré en figure 11 et/ou la composante directe progressive du courant de défaut total, déterminé sur la base de l'analyse du système de substitution tel qu'illustré en figure 12,

$\underline{Q}_{BCi}$ - désigne le quotient de la composante inverse du courant mesuré à l'extrémité de la ligne et de la somme des composantes inverses des signaux de courant, mesurés à l'extrémité de la ligne et à l'extrémité de la dérivation et/ou le quotient de la composante directe progressive du courant mesuré à l'extrémité de la ligne et de la somme des composantes directes progressives des signaux de courant, mesurés à l'extrémité de la ligne et à l'extrémité de la dérivation.

7.  Procédé selon la revendication 1 **caractérisé en ce que** pour les lignes d'alimentation qui ont trois postes terminaux, les impédances de la source équivalente ($(\underline{Z}_{2SC})_{SUB\_A}$) pour la composante inverse et ($(\underline{Z}_{\Delta1SC})_{SUB\_A}$) pour la composante directe progressive est déterminée dans l'hypothèse que le défaut s'est produit dans la section de ligne LA, à partir de l'équation suivante :

$$\left(\underline{Z}_{\mathrm{iSC}}\right)_{\mathrm{SUB\_A}} = \left(\underline{Z}_{\mathrm{iLB}} + \left(\underline{Z}_{\mathrm{iSB}}\right)_{\mathrm{SUB\_A}}\right)\frac{\underline{I}_{\mathrm{Bi}}}{\underline{I}_{\mathrm{Ci}}} - \underline{Z}_{\mathrm{iLC}} \ .$$

où :

indice inférieur $i$ prend la valeur $i=2$ pour la composante inverse, $i= \Delta 1$ pour la composante directe progressive, $(\underline{Z}_{i\mathrm{SB}})_{\mathrm{SUB\_A}}$ - désigne l'impédance de la source équivalente pour la composante inverse et/ou pour la composante directe progressive, calculée dans l'hypothèse que le défaut s'est produit dans la section de ligne LA, $\underline{Z}_{\mathrm{iLB}}$ - désigne l'impédance de la section de ligne LB pour la composante inverse et/ou pour la composante directe, étant précisé que $\underline{Z}_{\Delta 1 \mathrm{LB}} = \underline{Z}_{1\mathrm{LB}}$, $\underline{Z}_{1\mathrm{LB}}$ - désigne l'impédance de la section LB pour la composante directe, $\underline{Z}_{\mathrm{iLC}}$ - désigne l'impédance de la section de ligne LC pour la composante inverse et/ou l'impédance de la section de ligne LC pour la composante directe progressive, étant précisé que $\underline{Z}_{2\mathrm{LC}} = \underline{Z}_{1\mathrm{LC}}$ i $\underline{Z}_{\Delta 1 \mathrm{LC}} = \underline{Z}_{1\mathrm{LC}}$, $\underline{Z}_{1\mathrm{LC}}$ - désigne l'impédance de la section de ligne LC pour la composante directe, $\underline{I}_{\mathrm{Bi}}$ - désigne la composante inverse et/ou la composante directe progressive du courant mesuré à l'extrémité de la ligne, $\underline{I}_{\mathrm{Ci}}$ - désigne la composante inverse et/ou la composante directe progressive du courant mesuré à l'extrémité de la dérivation.

8. Procédé selon la revendication 1 **caractérisé en ce que** pour les lignes d'alimentation qui ont trois postes terminaux, l'impédance de la source équivalente pour la composante inverse $(\underline{Z}_{2\mathrm{SB}})_{\mathrm{SUB\_B}}$ et pour la composante directe progressive $(\underline{Z}_{1\mathrm{SB}})_{\mathrm{SUB\_B}}$ est déterminée dans l'hypothèse que le défaut s'est produit dans la section de ligne LB, à partir de l'équation suivante :

$$\left(\underline{Z}_{\mathrm{iSB}}\right)_{\mathrm{SUB\_B}} = \frac{(1-d_{\mathrm{B}})\underline{Z}_{\mathrm{iLB}}\,\underline{I}_{\mathrm{TBi}}^{\mathrm{transf.}} - d_{\mathrm{B}}\,\underline{Z}_{\mathrm{iLB}}\,\underline{I}_{\mathrm{Bi}} - \underline{V}_{\mathrm{Ti}}^{\mathrm{transf.}}}{\underline{I}_{\mathrm{Bi}}} \ ,$$

où :

indice inférieur $i$ prend la valeur $i=2$ pour la composante inverse, $i= \Delta 1$ pour la composante directe progressive, $d_{\mathrm{B}}$ - désigne la distance entre l'extrémité de la ligne et le point de défaut, $\underline{Z}_{\mathrm{iLB}}$ - désigne l'impédance de la section de ligne LB pour la composante inverse et/ou pour la composante directe, étant précisé que $\underline{Z}_{2\mathrm{LB}} = \underline{Z}_{1\mathrm{LB}}$ i $\underline{Z}_{\Delta 1 \mathrm{LB}} = \underline{Z}_{1\mathrm{LB}}$, $\underline{Z}_{1\mathrm{LB}}$ - désigne l'impédance de la section de ligne LB pour la composante directe,

$\underline{I}_{\mathrm{TBi}}^{\mathrm{transf.}}$ - désigne le courant arrivant au noeud de dérivation T à la section de ligne LB pour la composante inverse et/ou pour la composante directe progressive, $\underline{I}_{\mathrm{Bi}}$ - désigne la composante inverse et/ou la composante directe progressive du courant mesuré à l'extrémité de la ligne,

$\underline{V}_{\mathrm{Ti}}^{\mathrm{transf.}}$ - désigne la tension au noeud de dérivation T pour la composante inverse et/ou pour la composante directe progressive.

9. Procédé selon la revendication 1 **caractérisé en ce que** pour les lignes d'alimentation qui ont trois postes terminaux, l'impédance de la source équivalente pour la composante inverse $(\underline{Z}_{2\mathrm{SC}})_{\mathrm{SUB\_B}}$ et pour la composante directe progressive $(\underline{Z}_{\Delta 1\mathrm{SC}})_{\mathrm{SUB\_B}}$ est calculée dans l'hypothèse que le défaut s'est produit dans la section de ligne LB, à partir de l'équation suivante :

$$\left(\underline{Z}_{\mathrm{iSC}}\right)_{\mathrm{SUB\_B}} = -\frac{\underline{V}_{\mathrm{Ci}}}{\underline{I}_{\mathrm{Ci}}} \ ,$$

où :

indice inférieur *i* prend la valeur *i* = 2 pour la composante inverse, *i* = Δ1 pour la composante directe progressive, $\underline{V}_{\text{Ci}}$ - désigne la composante inverse et/ou la composante directe progressive de la tension à l'extrémité de la dérivation,

$\underline{I}_{\text{Ci}}$ - désigne la composante inverse et/ou la composante directe progressive du courant mesuré à l'extrémité de la dérivation.

10. Procédé selon la revendication 1 **caractérisé en ce que** pour les lignes d'alimentation qui ont trois postes terminaux, l'impédance de la source équivalente pour la composante inverse $(\underline{Z}_{\text{2SC}})_{\text{SUB}-C}$ et pour la composante directe progressive $(\underline{Z}_{\Delta\text{1SC}})_{\text{SUB\_C}}$ est calculée dans l'hypothèse que le défaut s'est produit dans la section de ligne LC, à partir de l'équation suivante :

$$(\underline{Z}_{\text{iSC}})_{\text{SUB\_C}} = \frac{(1 - d_{\text{C}})\underline{Z}_{\text{iLC}}\underline{I}_{\text{TCi}}^{\text{transf.}} - d_{\text{C}}\underline{Z}_{\text{iLC}}\underline{I}_{\text{Ci}} - \underline{V}_{\text{Ti}}^{\text{transf.}}}{\underline{I}_{\text{Ci}}},$$

où :

indice inférieur *i* prend la valeur *i* = 2 pour la composante inverse, *i* = Δ1 pour la composante directe progressive, $d_{\text{C}}$ - désigne la distance entre l'extrémité de la dérivation et le point de défaut, $\underline{Z}_{\text{iLC}}$ - désigne l'impédance de la section de ligne LC pour la composante inverse et/ou pour la composante directe progressive, étant précisé que $\underline{Z}_{\text{2LC}} = \underline{Z}_{\text{1LC}}$ i $\underline{Z}_{\Delta\text{1LC}} = \underline{Z}_{\text{1LC}}$, $\underline{Z}_{\text{1LC}}$ - désigne impédances de la section de ligne LC pour la composante directe,

$\underline{I}_{\text{TCi}}^{\text{transf.}}$ - désigne le courant arrivant au noeud T de la section de ligne LC pour la composante inverse et/ou pour la composante directe progressive,

$\underline{I}_{\text{Ci}}$ - désigne la composante inverse et/ou la composante directe progressive du courant mesuré à l'extrémité de la dérivation,

$\underline{V}_{\text{Ti}}^{\text{transf.}}$ - désigne la tension au point de noeud de dérivation T pour la composante inverse et/ou pour la composante directe progressive.

11. Procédé selon la revendication 1 **caractérisé en ce que** pour les lignes d'alimentation qui ont trois postes terminaux, l'impédance de la source équivalente pour la composante inverse $(\underline{Z}_{\text{2SB}})_{\text{SUB\_C}}$ et pour la composante directe progressive $(\underline{Z}_{\Delta\text{1SB}})_{\text{SUB}-C}$ est calculée dans l'hypothèse que le défaut s'est produit dans la section de ligne LC, à partir de l'équation suivante :

$$(\underline{Z}_{\text{iSB}})_{\text{SUB\_C}} = -\frac{\underline{V}_{\text{Bi}}}{\underline{I}_{\text{Bi}}},$$

où :

indice inférieur *i* prend la valeur *i* = 2 pour la composante inverse, *i* = Δ1 pour la composante directe progressive, $\underline{V}_{\text{Bi}}$ - désigne la composante inverse et/ou directe progressive de la tension à l'extrémité de la ligne, $\underline{I}_{\text{Bi}}$ - désigne la composante inverse et/ou directe progressive du courant mesuré à l'extrémité de la ligne.

12. **Procédé selon la revendication 1 caractérisé en ce que** pour les lignes d'alimentation avec multiples dérivations, les distances entre le début de la ligne et le point de défaut ($d_1$), l'extrémité de la ligne et le point de défaut ($d_{(2n-3)}$), l'extrémité de la ligne et le point de défaut ($d_{(2k-2)}$), le noeud de dérivation et le point de défaut dans la section de ligne entre deux noeuds de dérivation ($d_{(2k-1)}$) sont déterminées à partir des équations suivantes:

$$d_1 = \frac{\text{real}(\underline{V}_{\text{1p}})\text{imag}(\underline{I}_{\text{F}}) - \text{imag}(\underline{V}_{\text{1p}})\text{real}(\underline{I}_{\text{F}})}{\text{real}(\underline{Z}_{\text{1L1}}\underline{I}_{\text{1p}})\text{imag}(\underline{I}_{\text{F}}) - \text{imag}(\underline{Z}_{\text{1L1}}\underline{I}_{\text{1p}})\text{real}(\underline{I}_{\text{F}})},$$

$$d_{(2n-3)} = \frac{-\text{real}(\underline{V}_{T(n-1)np} - \underline{Z}_{1L(2n-3)}\underline{I}_{T(n-1)np})\text{imag}(\underline{I}_F) + \text{imag}(\underline{V}_{T(n-1)np} - \underline{Z}_{1L(2n-3)}\underline{I}_{T(n-1)np})\text{real}(\underline{I}_F)}{\text{real}(\underline{Z}_{1L(2n-3)}\underline{I}_{T(n-1)np})\text{imag}(\underline{I}_F) - \text{imag}(\underline{Z}_{1L(2n-3)}\underline{I}_{T(n-1)np})\text{real}(\underline{I}_F)}$$

$$d_{(2k-2)} = \frac{-\text{real}(\underline{V}_{Tkkp} - \underline{Z}_{1L(2k-2)}\underline{I}_{Tkkp})\text{imag}(\underline{I}_F) + \text{imag}(\underline{V}_{Tkkp} - \underline{Z}_{1L(2k-2)}\underline{I}_{Tkkp})\text{real}(\underline{I}_F)}{\text{real}(\underline{Z}_{1L(2k-2)}\underline{I}_{Tkkp})\text{imag}(\underline{I}_F) - \text{imag}(\underline{Z}_{1L(2k-2)}\underline{I}_{Tkkp})\text{real}(\underline{I}_F)},$$

$$d_{(2k-1)} = \frac{-\text{real}(\underline{V}_{TkT(k+1)p} - \underline{Z}_{1L(2k-1)}\underline{I}_{TkT(k+1)p})\text{imag}(\underline{I}_F) + \text{imag}(\underline{V}_{TkT(k+1)p} - \underline{Z}_{1L(2k-1)}\underline{I}_{TkT(k+1)p})\text{real}(\underline{I}_F)}{\text{real}(\underline{Z}_{1L(2k-1)}\underline{I}_{TkT(k+1)p})\text{imag}(\underline{I}_F) - \text{imag}(\underline{Z}_{1L(2k-1)}\underline{I}_{TkT(k+1)p})\text{real}(\underline{I}_F)}$$

où :

$\underline{V}_{1p}$ - la tension de la boucle de défaut calculée pour l'hypothèse, que le défaut s'est produit dans la première section de ligne L1,

$\underline{I}_{1p}$ - le courant de la boucle de défaut calculé dans l'hypothèse que le défaut s'est produit dans la première section de ligne L1,

$\underline{V}_{T(n-1)np}$ - la tension de la boucle de défaut calculée pour l'hypothèse, que le défaut s'est produit dans la section de ligne L(2n-3),

$\underline{I}_{T(n-1)np}$ - le courant de la boucle de défaut calculé dans l'hypothèse que le défaut s'est produit dans la section de ligne L(2n-3),

$\underline{V}_{Tkkp}$ - la tension de la boucle de défaut calculée pour l'hypothèse que le défaut s'est produit dans la branche de dérivation k,

$\underline{I}_{Tkkp}$ - le courant de la boucle de défaut calculé dans l'hypothèse que le défaut s'est produit dans la branche de dérivation k,

$\underline{V}_{TkT(k+1)p}$ - la tension de la boucle de défaut calculée pour l'hypothèse, que le défaut s'est produit dans la section de ligne entre deux noeuds de dérivation,

$\underline{I}_{TkT(k+1)p}$ - le courant de la boucle de défaut calculé dans l'hypothèse que le défaut s'est produit dans la section de ligne entre deux noeuds de dérivation,

$\underline{I}_F$ - courant de défaut total,

$\underline{Z}_{1L1}$ - l'impédance de la section de ligne L1 pour la composante directe,

$\underline{Z}_{0L1}$ - l'impédance de la section de ligne L1 pour la composante homopolaire,

$\underline{Z}_{1L(2n-3)}$ - l'impédance de la section de ligne L(2n-3) pour la composante directe,

$\underline{Z}_{0L(2n-3)}$ - l'impédance de la section de ligne L(2n-3) pour la composante homopolaire,

$\underline{Z}_{1L(2k-2)}$ - l'impédance de la section de ligne L(2k-2) pour la composante directe,

$\underline{Z}_{0L(2k-2)}$ - l'impédance de la section de ligne L(2k-2) pour la composante homopolaire,

$\underline{Z}_{1L(2k-1)}$ - l'impédance de la section de ligne L(2k-1) pour la composante directe,

$\underline{Z}_{0L(2k-1)}$ l'impédance de la section de ligne L(2k-1) pour la composante homopolaire,

k - numéro du noeud de dérivation,

n - numéro de l'extrémité de la ligne.

13. **Procédé selon la revendication 1 caractérisé en ce que** pour les lignes d'alimentation avec multiples dérivations, les résistances de défaut ($R_{1F}$), ($R_{(2n-3)F}$), ($R_{(2k-2)F}$), ($R_{(2k-1)F}$) sont déterminées à partir des équations suivantes:

$$R_{1F} = \frac{1}{2}\left[\frac{\text{real}(\underline{V}_{1p}) - d_1\text{real}(\underline{Z}_{1L1}\underline{I}_{1p})}{\text{real}(\underline{I}_F)} + \frac{\text{imag}(\underline{V}_{1p}) - d_1\text{imag}(\underline{Z}_{1L1}\underline{I}_{1p})}{\text{imag}(\underline{I}_F)}\right],$$

$$R_{(2n-3)F} = \frac{1}{2}\left[\frac{\text{real}(\underline{V}_{T(n-1)np}) - (1 - d_{(2n-3)}) \cdot real(\underline{Z}_{1L(2n-3)}\underline{I}_{T(n-1)np})}{\text{real}(\underline{I}_F)}\right] +$$
$$+ \frac{1}{2}\left[\frac{\text{imag}(\underline{V}_{T(n-1)np}) - (1 - d_{(2n-3)}) \cdot imag(\underline{Z}_{1(2n-3)}\underline{I}_{T(n-1)np})}{\text{imag}(\underline{I}_F)}\right]$$

$$R_{(2k-2)F} = \frac{1}{2}\left[\frac{\text{real}(\underline{V}_{Tkkp}) - (1 - d_{(2k-2)}) \cdot real(\underline{Z}_{1L(2k-2)}\underline{I}_{Tkkp})}{\text{real}(\underline{I}_F)}\right] +$$
$$+ \frac{1}{2}\left[\frac{\text{imag}(\underline{V}_{Tkkp}) - (1 - d_{(2k-2)}) \cdot imag(\underline{Z}_{1L(2k-2)}\underline{I}_{Tkkp})}{\text{imag}(\underline{I}_F)}\right]$$

$$R_{(2k-1)F} = \frac{1}{2}\left[\frac{\text{real}(\underline{V}_{TkT(k+1)p}) - (1 - d_{(2k-1)}) \cdot real(\underline{Z}_{1L(2k-1)}\underline{I}_{TkT(k+1)p})}{\text{real}(\underline{I}_F)}\right] +$$
$$+ \frac{1}{2}\left[\frac{\text{imag}(\underline{V}_{TkT(k+1)p}) - (1 - d_{(2k-1)}) \cdot imag(\underline{Z}_{1L(2k-1)}\underline{I}_{TkT(k+1)p})}{\text{imag}(\underline{I}_F)}\right]$$

où :

$d_1$ - distance jusqu'au défaut à compter du début de la ligne jusqu'au point de défaut,
$d_{(2n-3)}$ - distance jusqu'au défaut à compter de l'extrémité de la ligne jusqu'au point de défaut,
$d_{(2k-2)}$ - distance jusqu'au défaut à compter de l'extrémité de la dérivation jusqu'au point de défaut,
$d_{(2k-1)}$ - distance jusqu'au défaut dans la section de ligne entre deux noeuds de dérivation,
$\underline{V}_{1p}$ - tension de la boucle de défaut calculée pour l'hypothèse que le défaut s'est produit dans la première section de ligne L1,
$\underline{I}_{1p}$ - courant de la boucle de défaut calculé dans l'hypothèse que le défaut s'est produit dans la première section de ligne L1,
$\underline{V}_{T(n-1)np}$ - tension de la boucle de défaut calculée pour l'hypothèse, que le défaut s'est produit dans la section de ligne L(2n-3),
$\underline{I}_{T(n-1)np}$ - courant de la boucle de défaut calculé dans l'hypothèse que le défaut s'est produit dans la section de ligne L(2n-3),
$\underline{V}_{Tkkp}$ - tension de la boucle de défaut calculée pour l'hypothèse, que le défaut s'est produit dans la branche de dérivation k,
$\underline{I}_{Tkkp}$ - courant de la boucle de défaut calculé dans l'hypothèse que le défaut s'est produit dans la branche de dérivation k,
$\underline{V}_{TkT(k+1)p}$ - tension de la boucle de défaut calculée pour l'hypothèse, que le défaut s'est produit dans la section de ligne entre deux noeuds de dérivation,
$\underline{I}_{TkT(k+1)p}$ - courant de la boucle de défaut calculé dans l'hypothèse que le défaut s'est produit dans la section de ligne entre deux noeuds de dérivation,
$\underline{I}_F$ - courant de défaut total,
$\underline{Z}_{1L1}$ - impédance de la section de ligne L1 pour la composante directe,
$\underline{Z}_{0L1}$ - impédance de la section de ligne L1 pour la composante homopolaire,
$\underline{Z}_{1L(2n-3)}$ - impédance de la section de ligne L(2n-3) pour la composante directe,
$\underline{Z}_{0L(2n-3)}$ - impédance de la section de ligne L(2n-3) pour la composante homopolaire,
$\underline{Z}_{1L(2k-2)}$ - impédance de la section de ligne L(2k-2) pour la composante directe,
$\underline{Z}_{0L(2k-2)}$ - impédance de la section de ligne L(2k-2) pour la composante homopolaire,
$\underline{Z}_{1L(2k-1)}$ - impédance de la section de ligne L(2k-1) pour la composante directe,
$\underline{Z}_{0L(2k-1)}$ - impédance de la section de ligne L(2k-1) pour la composante homopolaire,
k- numéro du noeud de dérivation,
n- numéro de l'extrémité de la ligne.

**14. Procédé selon la revendication 1 caractérisé en ce que** pour les lignes d'alimentation avec multiples dérivations, l'impédance de la source équivalente pour la composante inverse ($\underline{Z}_{2S1}$) et pour la composante directe progressive ($\underline{Z}_{\Delta1S1}$) est calculée dans l'hypothèse que le défaut s'est produit dans la section de ligne entre le début de la ligne et le premier noeud de dérivation selon la formule:

$$(\underline{Z}_{iS1}) = \frac{-\underline{V}_{1i}}{\underline{I}_{1i}}$$

où :

i=2 pour la composante inverse, $\Delta1$ pour la composante directe progressive,

$\underline{V}_{1i}$ - tension mesurée au poste 1 (premier indice inférieur) pour une composante symétrique déterminée (second indice inférieur), c'est-à-dire pour la composante inverse - indice 2 et pour la composante directe progressive-indice $\Delta1$,

$\underline{I}_{1i}$ - courant mesuré au poste 1 (premier indice inférieur) pour une composante symétrique déterminée (second indice inférieur), c'est-à-dire pour la composante inverse - indice 2 et pour la composante directe progressive - indice $\Delta1$.

**15. Procédé selon la revendication 1 caractérisé en ce que** pour les lignes d'alimentation avec multiples dérivations, l'impédance de la source équivalente (($\underline{Z}_{2S(n)}$)) pour la composante inverse et (($\underline{Z}_{\Delta1S(n)}$)) pour la composante directe progressive est calculée dans l'hypothèse que le défaut s'est produit dans la section de ligne entre l'extrémité de la ligne et le noeud de dérivation terminal, selon la formule:

$$(\underline{Z}_{iSn}) = -\frac{\underline{V}_{T(n-1)i}^{transf.} - (1-d_{(2n-3)}) \cdot \underline{Z}_{iL(2n-3)} \cdot \underline{I}_{T(n-1)ni}^{transf.} - d_{(2n-3)} \cdot \underline{Z}_{iL(2n-3)} \cdot (\underline{I}_{T(n-1)ni}^{transf.} - \underline{I}_{Fi})}{\underline{I}_{ni}}$$

où :

i=2 pour la composante inverse, $\Delta1$ pour la composante directe progressive,

$\underline{V}_{T(n-1)i}^{transf.}$ - tensions au noeud de dérivation terminal T(n-1) pour la composante inverse, i=2, ou pour la composante directe progressive i=$\Delta1$,

$d_{(2n-3)}$ - distance entre l'extrémité de la ligne et le point de défaut,

$\underline{Z}_{iL(2n-3)}$ - impédance de la section de ligne L(2n-3) pour la composante inverse i=2, ou pour la composante directe progressive i=$\Delta1$,

$\underline{I}_{T(n-1)ni}^{transf.}$ - valeur du courant allant du noeud de dérivation T(n-1) au poste n dans la section de ligne L(2n-3) pour la composante inverse i=2, ou pour la composante directe progressive i=$\Delta1$,

$\underline{I}_{Fi}$ - courant de défaut total pour la composante inverse i=2, ou pour la composante directe progressive i=$\Delta1$,

$\underline{I}_{ni}$ - courant mesuré au dernier poste n (premier indice inférieur) pour une composante symétrique déterminée (second indice inférieur), c'est-à-dire pour la composante inverse - indice 2 et pour la composante directe progressive - indice $\Delta1$.

**16. Procédé selon la revendication 1 caractérisé en ce que** pour les lignes d'alimentation avec multiples dérivations, l'impédance de la source équivalente pour la composante inverse (($\underline{Z}_{2Sk}$)) et pour la composante directe progressive (($\underline{Z}_{\Delta1Sk)}$)) est déterminée dans l'hypothèse que le défaut s'est produit dans la dérivation:

$$(\underline{Z}_{iSk}) = -\frac{\underline{V}_{Tki}^{transf.} - (1-d_{(2k-2)}) \cdot \underline{Z}_{iL(2k-2)} \cdot \underline{I}_{Tkki}^{transf.} - d_{(2k-2)} \cdot \underline{Z}_{iL(2k-2)} \cdot (\underline{I}_{Tkki}^{transf.} - \underline{I}_{F2})}{\underline{I}_{ki}}.$$

où :

$V_{\mathrm{Tki}}^{\text{transf.}}$ - tensions dans le noeud k pour la composante inverse i=2, ou pour la composante directe progressive i=Δ1,

$d_{(2k-2)}$ - distance entre l'extrémité de la dérivation et le point de défaut Tk,

$\underline{Z}_{iL(2k-2)}$ - impédance de la section de ligne L(2k-2) pour la composante inverse i=2, ou pour la composante directe progressive i=Δ1,

$\underline{I}_{\mathrm{Tkki}}^{\text{transf.}}$ - valeur du courant allant du noeud de dérivation Tk au poste k dans la section de ligne de dérivation L(2k-2) pour la composante inverse i=2, ou pour la composante directe progressive i=Δ1,

$\underline{I}_{Fi}$ - courant de défaut total pour la composante inverse i=2, ou pour la composante directe progressive i=Δ1,

$\underline{I}_{ki}$ - courant mesuré au poste k (premier indice inférieur) pour les composantes symétriques déterminées, (second indice inférieur), c'est-à-dire pour la composante inverse - indice 2 et pour la composante directe progressive - indice Δ1.

**17. Procédé selon la revendication 1 caractérisé en ce que** pour les lignes d'alimentation avec multiples dérivations les impédances des sources équivalentes pour la composante inverse (($\underline{Z}_{2Sk}$) et ($\underline{Z}_{2S(k+1)}$)), et, aussi, pour la composante directe progressive (($\underline{Z}_{\Delta1Sk}$) i ($\underline{Z}_{\Delta1S(k+1)}$)) sont déterminées dans l'hypothèse que le défaut s'est produit dans la section de ligne entre deux noeuds de dérivation, à partir de l'équation suivante :

$$(\underline{Z}_{iSk}) = -\frac{V_{\mathrm{Tki}}^{\text{transf.}} - d_{(2k-1)} \cdot \underline{Z}_{iL(2k-1)} \cdot \underline{I}_{\mathrm{TkT(k+1)i}}^{\text{transf.}} - (1-d_{(2k-1)}) \cdot \underline{Z}_{iL(2k-1)} \cdot (\underline{I}_{\mathrm{TkT(k+1)i}}^{\text{transf.}} - \underline{I}_{Fi}) + \underline{Z}_{iLk}\underline{I}_{ki}}{\underline{I}_{ki}}$$

$$(\underline{Z}_{iS(k+1)}) = -\frac{V_{\mathrm{Tki}}^{\text{transf.}} - d_{(2k-1)} \cdot \underline{Z}_{iL(2k-1)} \cdot \underline{I}_{\mathrm{TkT(k+1)i}}^{\text{transf.}} - (1-d_{(2k-1)}) \cdot \underline{Z}_{iL(2k-1)} \cdot (\underline{I}_{\mathrm{TkT(k+1)i}}^{\text{transf.}} - \underline{I}_{Fi}) + \underline{Z}_{iL(2k)}\underline{I}_{(k+1)i}}{\underline{I}_{(k+1)i}} \ .$$

où :

$V_{\mathrm{Tki}}^{\text{transf.}}$ - tensions au noeud de dérivation k pour la composante inverse i=2, ou pour la composante directe progressive i=Δ1,

$d_{(2k-1)}$ - distance jusqu'au défaut dans la section de ligne entre deux noeuds de dérivation,

$\underline{Z}_{iL(2k-1)}$ - impédance de la section de ligne L(2k-1) pour la composante inverse i=2, ou pour la composante directe progressive i=Δ1,

$\underline{I}_{\mathrm{TkT(k+1)i}}^{\text{transf.}}$ - courant allant du noeud de dérivation Tk au noeud de dérivation T(k+1) dans la section de ligne pour la composante inverse i=2, ou pour la composante directe progressive i=Δ1

$\underline{I}_{Fi}$ - courant de défaut total pour la composante inverse i=2, ou pour la composante directe progressive i=Δ1,

$\underline{I}_{ki}$ - courant mesuré au poste k (premier indice inférieur) pour une composante symétrique déterminée (second indice inférieur), c'est-à-dire pour la composante inverse - indice 2 et pour la composante directe progressive - indice Δ1,

$\underline{I}_{(k+1)i}$ - courant mesuré au poste k+1 (premier indice inférieur) pour une composante symétrique déterminée (second indice inférieur), c'est-à-dire pour la composante inverse - indice 2 et pour la composante directe progressive - indice Δ1.

Fig.1.

Fig.2.

Fig.3.

Fig.4.

Fig.5.

Fig.6.

Fig.7.

Fig.8.

Fig.9.

Fig.10.

Fig.11.

Fig.12.

Fig.14

Fig.15

Fig.13

Fig.16

Fig.17

Fig.18

71

EP 1 924 863 B1

Fig.19

Fig.19a
Fig.19b

Voltage and current measurement — 610

Calculation of sequence components of measured voltage, currents and total fault current — 620

Calculation $d_1$ & $R_{1F}$ — 630a

Calculation $d_{(2n-3)}$ & $R_{(2n-3)F}$ — 630b

Calculation $d_{(2k-2)}$ & $R_{(2k-2)F}$ — 630c

Calculation $d_{(2k-1)}$ & $R_{(2k-1)F}$ — 630d

NO results rejected

$0 \leq d_1 \leq 1$ & $R_{1F} \geq 0$ — 640a   YES

NO results rejected

$0 \leq d_{(2n-3)} \leq 1$ & $R_{(2n-3)F} \geq 0$ — 640b   YES

NO results rejected

$0 \leq d_{(2k-2)} \leq 1$ & $R_{(2k-2)F} \geq 0$ — 640c   YES

NO results rejected

$0 \leq d_{(2k-1)} \leq 1$ & $R_{(2k-1)F} \geq 0$ — 640d   YES

650   End

650   End

650   End

650   End

Fig.19a

Calculation $\underline{Z}_{is1}$ — 660a

Calculation $\underline{Z}_{isn}$ — 660b

Calculation $\underline{Z}_{isk}$ — 660d

Calculation $\underline{Z}_{isk}, \underline{Z}_{is(k+1)},$ — 660d

NO result rejected

670a
$real(\underline{Z}_{is1}) > 0$ & $imag(\underline{Z}_{is1}) > 0$ YES

NO result rejected

670b
$real(\underline{Z}_{isn}) > 0$ & $imag(\underline{Z}_{isn}) > 0$ YES

NO result rejected

670c
$real(\underline{Z}_{isk}) > 0$ & $imag(\underline{Z}_{isk}) > 0$ YES

NO result rejected

670d
$real(\underline{Z}_{isk}) > 0$ & $real(\underline{Z}_{is(k+1)}) > 0$ & $imag(\underline{Z}_{isk}) > 0$ & $imag(\underline{Z}_{is(k+1)}) > 0$ YES

680 End

680 End

680 End

680 End

Calculation $|\underline{Z}_{is1}|$ — 690a

Calculation $|\underline{Z}_{isn}|$ — 690b

Calculation $|\underline{Z}_{isk}|$ — 690c

Calculation $|\underline{Z}_{isk}|, |\underline{Z}_{is(k+1)}|$ — 690d

Comparation with real value of the module of source system impedance and final selection of valid result

700

710

END

Fig.19b

EP 1 924 863 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **YING-HONG LIN.** Novel Fault Location Algorithm for Multi-Terminal Lines Using Phasor Measurement Units. *the materials of the Thirty-Seventh Annual North American Power Symposium in Ames, Iowa, USA,* 20051023

- A new fault Locator for three-Terminal Transmission Line-Using Two-Terminal Synchronized Voltage and Current Phasors. IEEE Transaction on Power Delivery. IEEE Service Center, 2002, vol. 17, 452-459